(19) Europäisches Patentamt
European Patent Office
Office européen des brevets

(11) EP 4 570 811 A1

(12) EUROPEAN PATENT APPLICATION

(43) Date of publication:
**18.06.2025 Bulletin 2025/25**

(21) Application number: **23307168.7**

(22) Date of filing: **11.12.2023**

(51) International Patent Classification (IPC):
***C07F 9/53*** (2006.01) ***C07F 9/6558*** (2006.01)
***C07F 9/6533*** (2006.01) ***B41M 7/00*** (2006.01)
***C08F 2/50*** (2006.01) ***C08K 5/00*** (2006.01)
***C09D 11/101*** (2014.01) ***G03F 7/038*** (2006.01)

(52) Cooperative Patent Classification (CPC):
**C07F 9/5337; C07F 9/6533; C07F 9/65583; C08F 2/50; C09D 11/101; G03F 7/029; G03F 7/031; G03F 7/0388**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ARKEMA FRANCE**
**92800 Puteaux (FR)**

(72) Inventors:
- **JEPSON, David**
  **Wetherby, LS22 7NS (GB)**
- **CALDERLEY, Nicholas**
  **Wetherby, LS22 7NS (GB)**
- **PLENDERLEITH, Richard**
  **Wetherby, LS22 7NS (GB)**
- **SQUIRES, Kelly**
  **Wetherby, LS22 7NS (GB)**
- **TELITEL, Sofia**
  **60550 Verneuil en Halatte (FR)**
- **MELEC, Pierre**
  **60550 Verneuil en Halatte (FR)**
- **DEMOULIN, Kevin**
  **60550 Verneuil en Halatte (FR)**
- **CICERON, Philippe**
  **60300 Senlis (FR)**

(74) Representative: **Arkema Patent**
**Arkema France**
**DRD-DPI**
**51, Esplanade du Général de Gaulle**
**CS 10478**
**92907 Paris La Défense Cedex (FR)**

# (54) POLYMERIZABLE PHOSPHINE OXIDE-BASED PHOTOINITIATORS

(57) The present invention relates to a polymerizable phosphine oxide-based photoinitiator, to a process for preparing said photoinitiator and to a precursor that may be used to prepare said photoinitiator. The present invention further relates to a photoinitiator composition, to a curable composition, to a process for the preparation of a cured product, to a process of inkjet printing, to a process of 3D printing and to a process for coating a nail. The invention also relates to precursors of the photoinitiator or the photoinitiator composition. The invention also relates to the use of the photoinitiator or the photoinitiator composition.

EP 4 570 811 A1

## Description

### TECHNICAL FIELD

The present invention relates to a polymerizable phosphine oxide-based photoinitiator, to a process for preparing said photoinitiator and to a precursor that may be used to prepare said photoinitiator. The present invention further relates to a photoinitiator composition, to a curable composition, to a process for the preparation of a cured product, to a process of inkjet printing, to a process of 3D printing and to a process for coating a nail. The invention also relates to precursors of the photoinitiator or the photoinitiator composition. The invention also relates to the use of the photoinitiator or the photoinitiator composition.

### TECHNICAL BACKGROUND

Radiation curable compositions containing ethylenically unsaturated compounds can be polymerized by exposure to radiation, such as ultraviolet (UV) light. For rapid and effective curing, a photoinitiator is often used. The photoinitiator forms radical species upon irradiation with photons and initiates free-radical polymerization of unsaturated groups, leading to hardening (curing) of the material.

Free radical photoinitiators can adopt two different modes of action and are classified by mode of action as Norrish Type I and Norrish Type II Photoinitiators. Norrish Type I photoinitiators cleave upon exposure to radiation, producing radical species which are capable of initiating the polymerization of unsaturated compounds. Norrish Type II photoinitiators are compounds which do not fragment upon exposure to radiation and so will not typically initiate radical-chain polymerization unless a co-initiator is present. Upon exposure to radiation, interaction between the Type II photoinitiator and the co-initiator leads to the generation of radical species which can initiate the polymerization of UV-curable resins.

In the field of photocured 3D printing there is a growing predominance of printing equipment that use longer wavelength (above 385 nm) light sources to effect curing of the photoactive resin. In formulations designed for use on these printers, phosphine oxide derivatives such as acylphosphine oxides are the preferred class of photoinitiators because of their strong absorbance in the wavelength range of interest. Acylphosphine oxides are classified as Norrish Type I initiators and include the following compounds:

(a) Laromer 819 (also known as Irgacure, 819, Speedcure BPO, or BAPO, namely bis-(2,4,6-trimethylbenzoyl)phenyl phosphine oxide) which has the following structure:

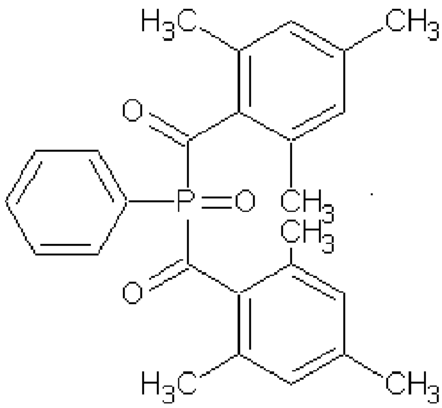

(b) Speedcure TPO (also known as 2,4,6- trimethylbenzoyl diphenyl phosphine oxide) which has the following structure:

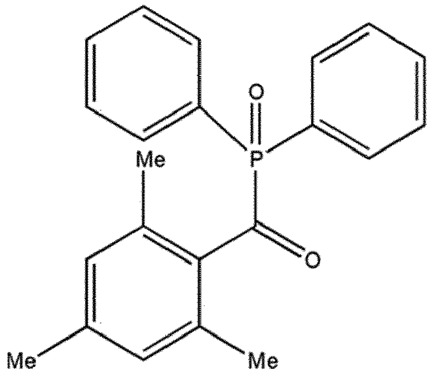

(c) Speedcure TPO-L (also known as Ethyl (2,4,6-trimethylbenzoyl)phenyl phosphinate) which has the following structure:

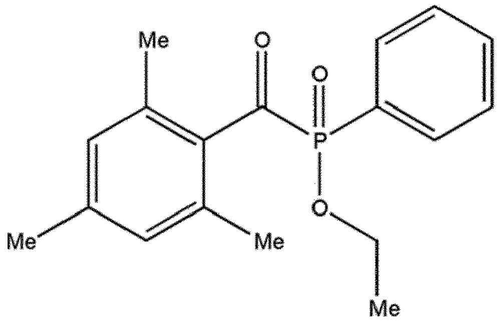

However, TPO has recently been classified as a SVHC (substance of very high concern)based on new toxicology testing. This limits its acceptable residue amount in cured products and hence its use in many applications, especially food contact or personal care applications. TPO-L and BAPO are expected to be similarly reclassified.

In addition, mesitaldehyde (2,4,6-trimethylbenzaldehyde), which is a compound normally released from TPO under UV light, can migrate from the cured product and contaminate any adjacent materials. In the case of foodstuffs, migration of small molecule fragments can lead to problems with off-taste and odour. Furthermore, mesitaldehyde is classed as a skin irritant, so migration from cured articles may pose a health hazard. Low molecular-weight photoinitiators such as TPO, TPO-L and BPO may also migrate from the cured products and can also pose a hazard to health.

Biocompatible 3D-printing materials consumption is increasing due to a reduction in production time and formulation of specially designed goods. These materials are particularly sought for in new medical applications, such as implants, prosthesis, surgical guides, tissue engineered products, hearing aids, dental products as well as wearable devices (shoes, jewelry, ear buds and glasses). The development of FDA-approved 3D printing biomaterials and the creation of low-cost 3D printing materials are two major challenges facing the sector. Given that UV-curable 3D printing material will be in contact with human bodies, biocompatible resins must be subjected to biological evaluation and testing for cytotoxicity, genotoxicity, or delayed hypersensitivity, etc. The attention is mainly focused on developing UV curable resins to make 3D parts free of residual monomers or low molecular weight additives in order to meet health and safety standards, create durable and high performance of biomedical devices without fear of toxicity or side effects.

3D printers equipped with longer wavelength irradiation, such as LED lamps, are tremendously growing for reasons of high penetration depth of the UV-A LED light, lower biohazard, and cost efficiency. Acylphosphine oxides have a red shift of the absorption band from 350~420nm and are thus efficient photoinitiators for many LED light emission ranges. Unfortunately, non-polymerizable acylphosphine oxides can lead to undesirable residues and photoproducts (such as mesitaldehyde) and will be prone to migration through cured 3D parts to the surface. Polymerizable photoinitiators thus appear more advantageous as they are chemically incorporated into the cured polymeric matrix and hence pose less toxicological concern.

Document EP 3378875 relates to a photopolymerization initiator which is a compound having a structure in which one or more carbonyl groups that link to a carbon atom are further directly bonded to an aromatic ring of an aromatic acyl group that bonds to a phosphorus atom in an acylphosphine oxide structure.

Document US 10590264 discloses a photopolymerization initiator which is an acyl phosphine oxide.

EP3149013 discloses multifunctional mono- and bis-acyl phosphine oxides which are useful as photoinitiators, and to photocurable compositions.

There is thus a need for cost effective and efficient photoinitiators for the manufacture of radiation curable

adhesives and coating formulations, that present high curing activity, lower toxicity and reduced migration from coated articles.

The present invention enables to meet the abovementioned need. In particular the invention provides cost effective and efficient photoinitiators for the manufacture of curable compositions, that present high curing activity, lower toxicity and reduced migration from coated articles.

This is achieved by the (polymerizable phosphine oxide-based) photoinitiator according to the present invention.

The photoinitiator according to the invention advantageously has one or more polymerizable groups (i.e. (meth) acrylate and/or (meth)acrylamide groups) and hence exhibits a lower tendency to migrate and lower bioavailability (reduced propensity to be absorbed through the skin or through the gastrointestinal tract) compared to smaller molecules such as TPO, TPO-L and BPO.

Accordingly, such photoinitiators may mimic the good curing properties of the classic TPO/BPO initiators with reduced toxicity issues.

Finally, the photoinitiator according to the present invention may be prepared from inexpensive and readily-available materials, which makes it possible to obtain such initiators in a cost-effective manner.

## SUMMARY OF THE INVENTION

The invention relates to a photoinitiator according to formula (1) or (2):

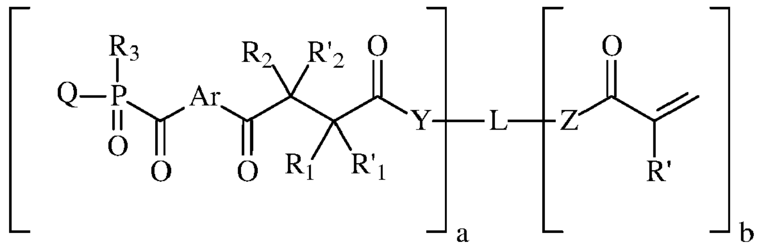

(1)

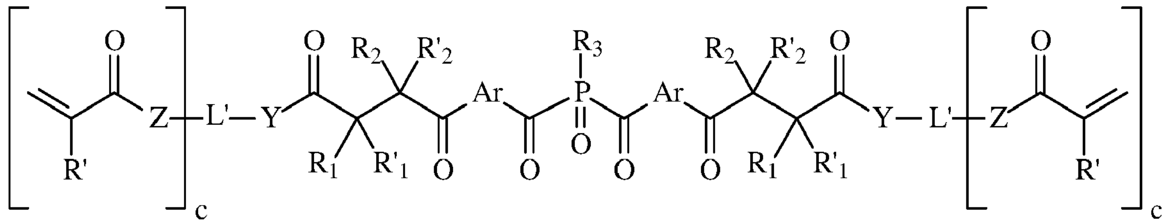

(2)

wherein Ar, L, L', Q, R', $R_1$, $R'_1$, $R_2$, $R'_2$, $R_3$, Y, Z, a, b and c are as defined herein.

The invention also relates to a process for the preparation of a photoinitiator of formula (1) or (2) according to the invention, wherein the process comprises reacting at least one precursor of formula (34) or (35) with at least one product of formula (36):

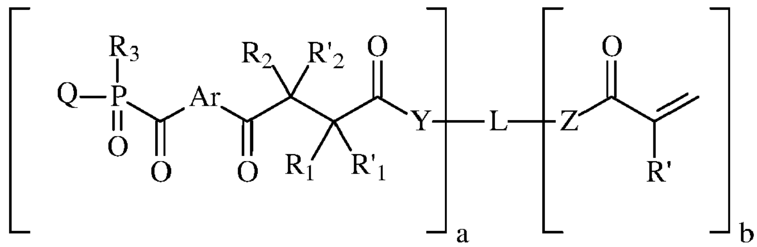

(1)

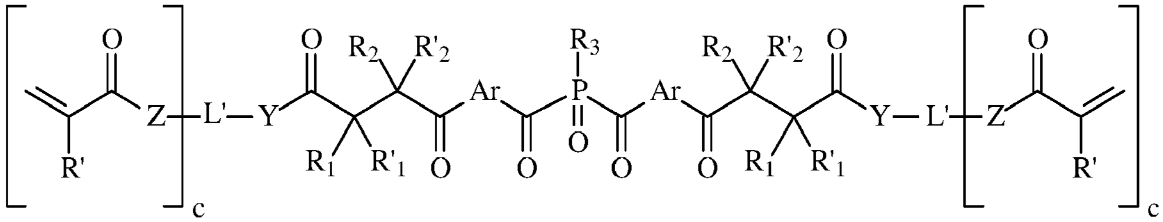

(2)

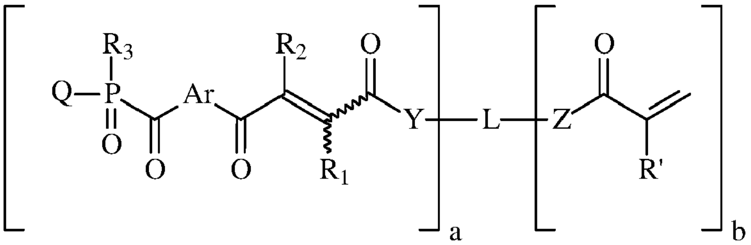

(34)

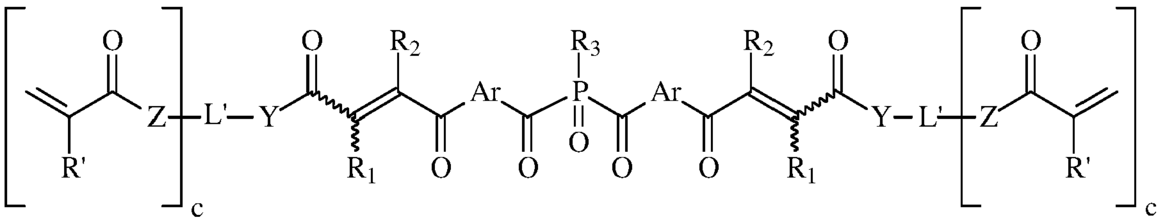

(35)

$R'_1$-$R'_2$ (36)

wherein Ar, $R_1$, $R_2$, $R_3$, $R'_1$, $R'_2$, Q, L, L' Y, Z, R', a, b and c are as defined herein.

The invention further relates to a precursor of formula (34) or (35):

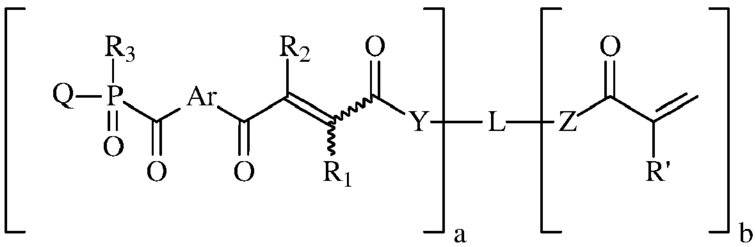

(34)

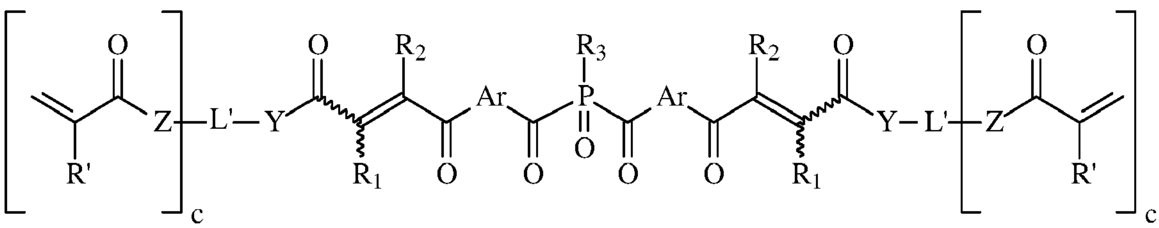

(35)

wherein Ar, $R_1$, $R_2$, $R_3$, Q, L, L', Y, Z, R', a, b and c are as defined herein.

The invention further relates to a process for the preparation of a precursor of formula (34) according to the invention, wherein the process comprises:

- reacting at least one precursor of formula (37) with a compound of formula (38); or
- reacting at least one precursor of formula (37) with a compound of formula (39) and a compound of formula (40); or

- reacting at least one precursor of formula (37) with a compound of formula (41) and a compound of formula (40):

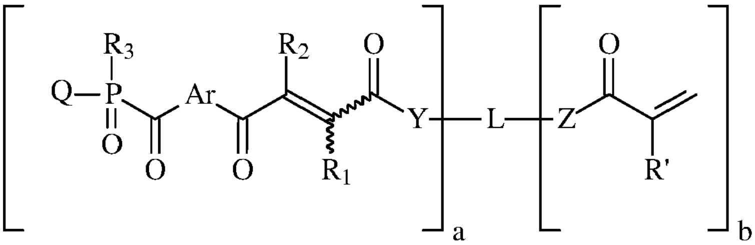

(34)

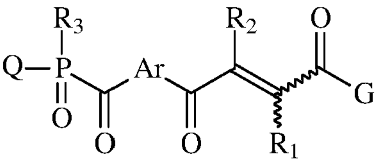

(37)

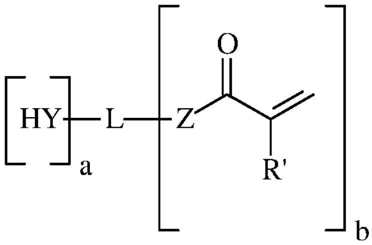

(38)

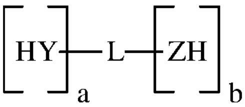

(39)

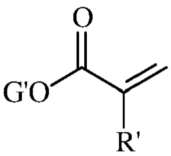

(40)

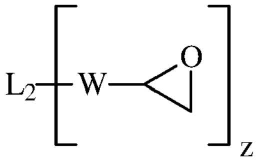

(41)

wherein Ar, $R_1$, $R_2$, $R_3$, Q, L, $L_2$, W, Y, Z, R', G, G', J, a, b and z are as defined herein.

The invention further relates to a process for the preparation of a precursor of formula (35) according to the invention, wherein the process comprises:

- reacting at least one precursor of formula (42) with a compound of formula (43); or
- reacting at least one precursor of formula (42) with a compound of formula (44) and a compound of formula (40); or
- reacting at least one precursor of formula (42) with a compound of formula (41) and a compound of formula (40):

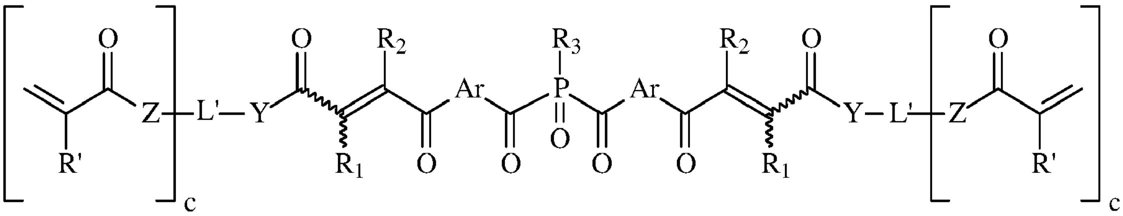

(35)

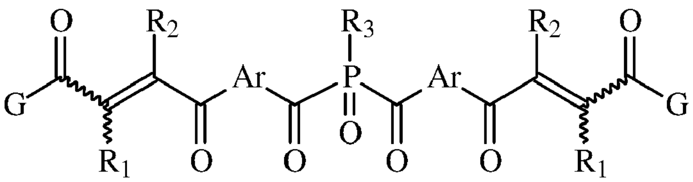

(42)

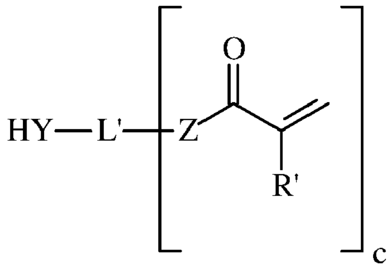 (43)

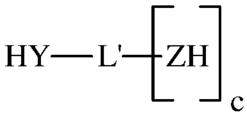 (44) 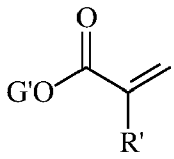 (40) 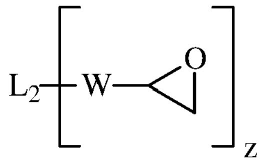 (41)

wherein Ar, $R_1$, $R_2$, $R_3$, L', $L_2$, W, Y, Z, R', G, G', J, c and z are as defined herein.

Another object of the invention is a process for the preparation of a photoinitiator of formula (1) according to the invention, wherein the process comprises:

- reacting at least one precursor of formula (45) with at least one compound of formula (38); or
- reacting at least one precursor of formula (45) with at least one compound of formula (39) and at least one compound of formula (40); or
- reacting at least one precursor of formula (45) with at least one compound of formula (41) and at least one compound of formula (40);

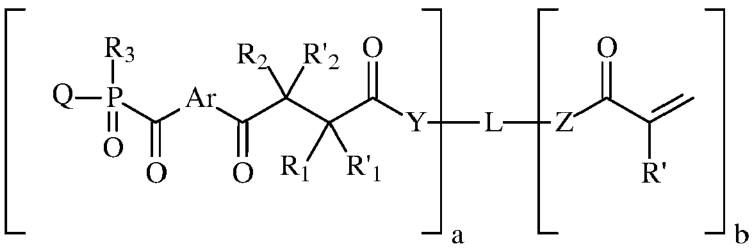 (1)

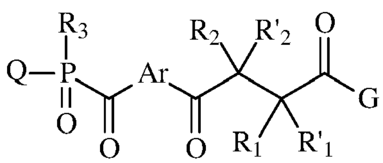 (45) 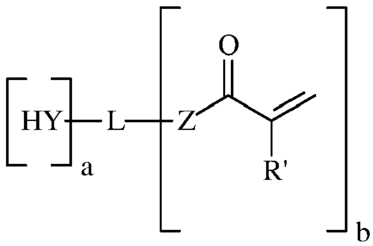 (38)

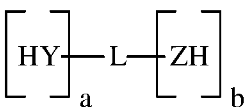 (39) 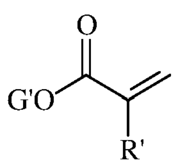 (40) 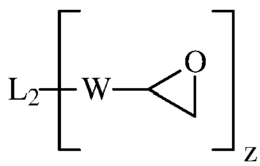 (41)

wherein Ar, $R_1$, $R_2$, $R'_1$, $R'_2$, $R_3$, Q, L, $L_2$, W, Y, Z, R', G, G', J, a, b and z are as defined herein.

Yet another object of the invention is a process for the preparation of a photoinitiator of formula (2) according to the invention, wherein the process comprises:

- reacting at least one precursor of formula (46) with a compound of formula (43); or

- reacting at least one precursor of formula (46) with a compound of formula (44) and a compound of formula (40); or
- reacting at least one precursor of formula (46) with a compound of formula (41) and a compound of formula (40):

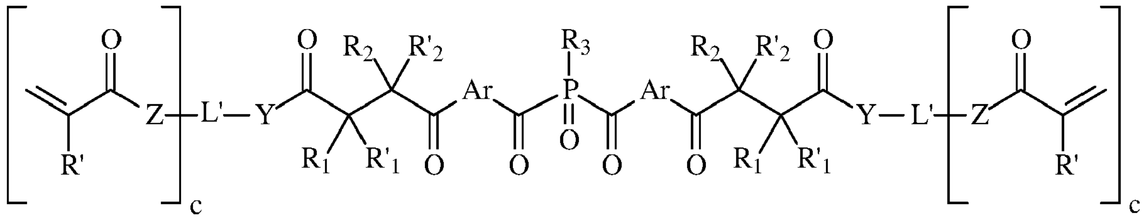
(2)

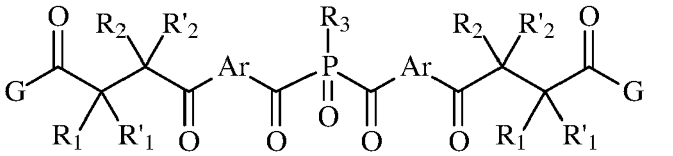
(46)

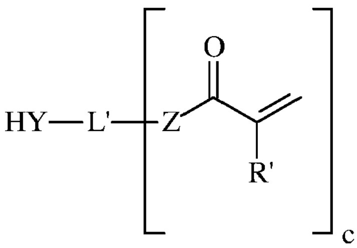
(43)

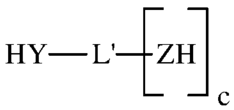
(44)

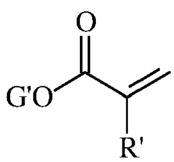
(40)

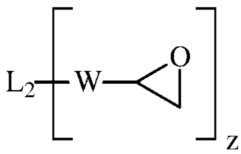
(41)

wherein Ar, $R_1$, $R_2$, $R_3$, $R'_1$, $R'_2$, L', $L_2$, W, Y, Z, R', G, G', J, c and z are as defined herein.

Yet another object of the invention is a process for the preparation of a photoinitiator of formula (6) according to the invention, wherein the process comprises reacting at least one precursor of formula (37) with at least one product of formula (47) and at least one product of formula (40):

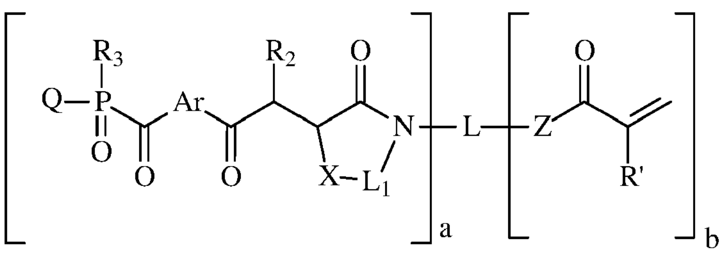
(6)

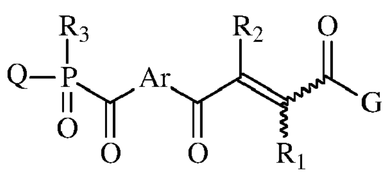
(37)

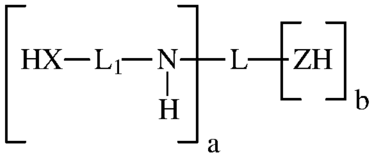 (47) 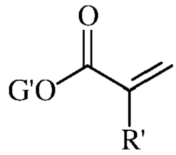 (40)

wherein Ar, $R_1$, $R_2$, $R_3$, Q, L, Z, R', X, $L_1$, G, G', J, a and b are as defined herein.

Yet another object of the invention is a process for the preparation of a photoinitiator of formula (7) according to the invention, wherein the process comprises reacting at least one precursor of formula (38) with at least one product of formula (48) and at least one product of formula (40):

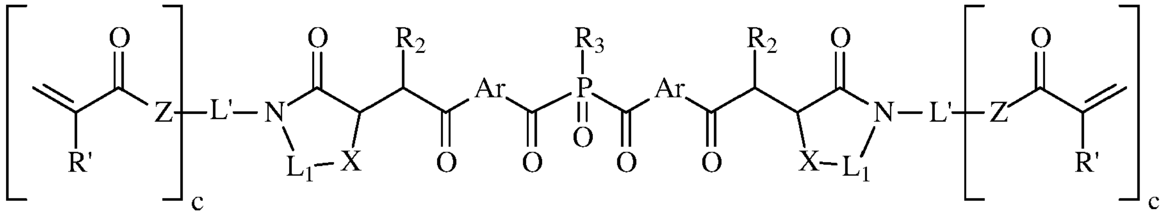

(7)

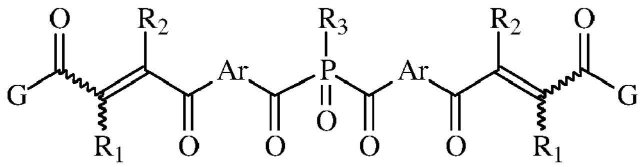

(38)

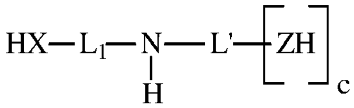 (48) 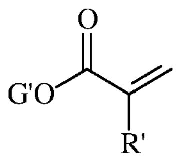 (40)

wherein Ar, $R_1$, $R_2$, $R_3$, L', Z, R', X, $L_1$, G, G', J and c are as herein.

The invention also relates to a photoinitiator composition comprising:

- a mixture of at least two photoinitiators of formula (1) according to the invention;
- a mixture of at least two photoinitiators of formula (2) according to the invention;
- a mixture of at least one photoinitiator of formula (1) according to the invention and at least one precursor of formula (34) according to the invention; or
- a mixture of at least one photoinitiator of formula (2) according to the invention and at least one precursor of formula (35) according to the invention.

The invention further relates to a process for photopolymerizing one or more ethylenically unsaturated compounds comprising contacting one or more ethylenically unsaturated compounds with a photoinitiator of formula (1) or (2) according to the invention or a photoinitiator composition according to the invention, and irradiating the mixture, in particular with UV, near-UV, visible, infrared and/or near-infrared radiation.

The invention further relates to a curable composition comprising:

a) a photoinitiator of formula (1) or (2) according to the invention or a photoinitiator composition according to the invention; and

b) an ethylenically unsaturated compound.

The invention further relates to a process for the preparation of a cured product, comprising curing the curable composition according to the invention, preferably by exposing the curable composition to radiation such as UV, near-UV, visible, infrared and/or near-infrared radiation.

The invention further relates to a process of 3D printing comprising printing a 3D article with the composition according to the invention, in particular layer by layer or continuously.
The invention further relates to a process of inkjet printing comprising jetting the curable composition according to the invention onto a substrate.
The invention further relates to a process of coating a nail, wherein the process comprises applying the curable composition according to the invention on a nail, and curing the composition on the nail.
The invention further relates to a use of a photoinitiator of formula (1) or (2) according to the invention or a photoinitiator composition according to the invention, as a photoinitiator or a photoinitiating system in a radiation curable composition, preferably in a UV or LED-curable composition.
The invention further relates to a use of a photoinitiator of formula (1) or (2) according to the invention or a photoinitiator composition according to the invention, to cure one or more ethylenically unsaturated compounds.
The invention further relates to a use of a photoinitiator of formula (1) or (2) according to the invention or a photoinitiator composition according to the invention, to obtain a cured product having a reduced amount of extractables.

## DETAILED DESCRIPTION

The invention will now be described in more detail without limitation in the following description.

### Definitions

The term *"alkyl"* means a monovalent saturated alicyclic hydrocarbon group of formula $-C_nH_{2n+1}$ wherein n is 1 to 20. An alkyl may be linear or branched. Examples of alkyl groups include methyl, ethyl, propyl, isopropyl, butyl, isobutyl, tert-butyl, pentyl, hexyl, 2-methylbutyl, 2,2-dimethylpropyl, n-hexyl, 2-methylpentyl, 2,2-dimethylbutyl, n-heptyl, 2-ethylhexyl, and the like.
The term "*aryl*" means an optionally substituted polyunsaturated aromatic group. The aryl may contain a single ring (i.e. phenyl) or more than one ring wherein at least one ring is aromatic. When the aryl comprises more than one more ring, the rings may be fused, linked via a covalent bond (for example biphenyl). The aromatic ring may optionally comprise one to two additional fused rings (i.e. cycloalkyl, heterocycloalkyl or heteroaryl). The term "*aryl*" also encompasses partially hydrogenated derivatives of the carbocyclic system is described above. Examples include phenyl, naphtyl, biphenyl, phenanthrenyl and naphthacenyl.
The term *"arylene"* means a substituent that derives from an aromatic hydrocarbon (arene) and is bivalent.
The term *"halogen"* means an atom selected from Cl, Br, F and I.
The term "*cycloalkyl*" means a monovalent saturated alicyclic hydrocarbon group comprising a cycle. Examples of cycloalkyl groups include cyclopentyl, cyclohexyl and isobornyl.
The term *"heterocycloalkyl"* means a cycloalkyl having at least one ring atom that is a heteroatom selected from O, N or S.
The term *"alkoxy"* means a group of formula -O-alkyl, wherein the alkyl is as defined above.
The term "*aryloxy*" means a group of formula -O-aryl, wherein the aryl is as defined above.
The term "*thioalkyl*" means a group of formula -S-alkyl, wherein the alkyl is as defined above.
The term "*thioaryl*" means a group of formula -S-aryl, wherein the aryl is as defined above.
The term "*linker*" means a plurivalent group. A linker may connect at least two moieties of a compound together, in particular 2 to 16 moieties of a compound together. For example, a linker that connects two moieties of a compound together is referred to as a divalent linker, a linker that connects three moieties of a compound together is referred to as a trivalent linker, etc....
The term *"hydrocarbon linker*" means a linker having a carbon backbone chain which may optionally be interrupted by one or more heteroatoms selected from N, O, S, Si and mixtures thereof. A hydrocarbon linker may be aliphatic, cycloaliphatic or aromatic. A hydrocarbon linker may be saturated or unsaturated. A hydrocarbon linker may be optionally substituted.
The term *"aliphatic"* means a non-aromatic acyclic compound. It may be linear or branched, saturated or unsaturated. It may be substituted by one or more groups, for example selected from alkyl, hydroxyl, halogen (Br, Cl, I, F), isocyanate, carbonyl, amine, carboxylic acid, -C(=O)-OR', -C(=O)-O-C(=O)-R', each R' being independently a $C_1$-$C_6$ alkyl. It may comprise one or more bonds selected from ether, ester, amide, urethane, urea and mixtures thereof.
The term *"acyclic"* means a compound that does not comprise any rings.
The term *"cycloaliphatic"* means a non-aromatic cyclic compound. It may be substituted by one or more groups as defined for the term *"aliphatic".* It may comprise one or more bonds as defined for the term *"aliphatic".*
The term *"aromatic"* means a compound comprising an aromatic ring, which means that respects Hückel's aromaticity rule, in particular a compound comprising a phenyl group. It may be substituted by one or more groups as defined for the term *"aliphatic".* It may comprise one or more bonds as defined for the term *"aliphatic".*

The term "*saturated*" means a compound that does not comprise any double or triple carbon-carbon bonds.

The term "*unsaturated*" means a compound that comprises a double or triple carbon-carbon bond, in particular a double carbon-carbon bond.

The term *"polyether polyol*" or *"polyether linker*" means a polyol (in other words a compound comprising at least two hydroxyl groups), respectively a linker, comprising at least two ether bonds.

The term "*polyester polyol*" or "*polyester linker*" means a polyol, respectively a linker, comprising at least two ester bonds.

The term *"polycarbonate polyol"* or *"polycarbonate linker"* means a polyol, respectively a linker, comprising at least two carbonate bonds.

The term *"polyurethane linker*" means a linker comprising at least two urethane bonds.

The term *"polyorganosiloxane polyol" or "polyorganosiloxane linker*" means a polyol, respectively a linker, comprising at least two organosiloxane bonds. The organosiloxane may, for example be a dimethylsiloxane bond.

The term *"polycaprolactone polyol*" or *"polycaprolactone linker*" means a polyol, respectively a linker, comprising at least two units derived from the ring-opening polymerization of ε-caprolactone, in particular at least two $-[(CH_2)_5-C(=O)O]-$ units.

The term *"polybutadiene polyol*" or *"polybutadiene linker*" means a polyol, respectively a linker, comprising at least two units derived from the polymerization of butadiene, in particular at least two units selected from $-CH_2-CH=CH-CH_2-$ and $CH_2-CH(CH=CH_2)-$.

The term *"isocyanate group"* means a -N=C=O group.

The term *"isocyanurate linker*" means a linker comprising an isocyanurate moiety, in particular a moiety of formula:

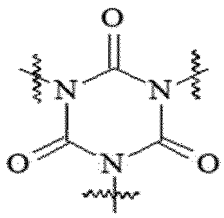

**Photoinitiator of formula (1) or** (2)

The present invention relates to a photoinitiator. The photoinitiator is according to the following formula (1) or (2):

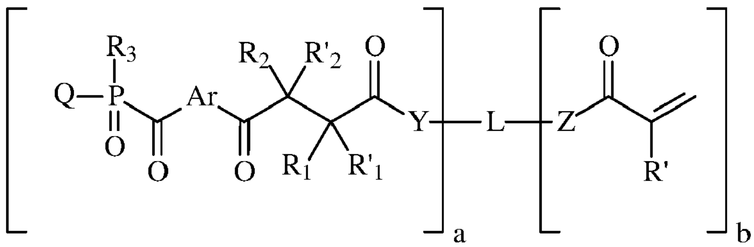

(1)

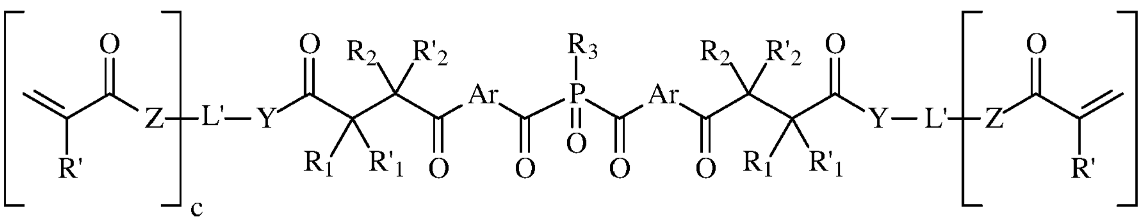

(2)

wherein Ar, L, L', Q, R', $R_1$, $R'_1$, $R_2$, $R'_2$, $R_3$, Y, Z, a, b and c are as defined herein.

In formulae (1) and (2), each Ar is independently an optionally substituted arylene. In particular, each Ar may independently be an optionally substituted phenylene. The phenylene may be an ortho-phenylene, a meta-phenylene or a para-phenylene (substituted or not). The ortho, meta and para position refer to the position of the radicals of the bivalent phenylene. Preferably, each Ar may independently be a meta-phenylene substituted by one or more optionally substituted

groups selected from alkyl, aryl, alkoxy, aryloxy, thioalkyl and thioaryl. More preferably, each Ar is a group of formula (5):

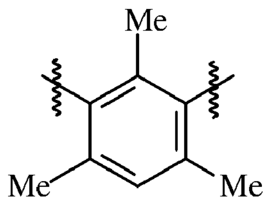

(5).

In formulae (1) and (2), $R_1$ and $R_2$ are independently H or an optionally substituted group selected from alkyl and aryl; or $R_1$ and $R_2$, together with the carbon atoms to which they are attached, form a ring. Such ring may be chosen from 5-8-membered ring, for example a 5-membered ring, a 6-membered ring, a 7-membered ring, or an 8-membered ring, and may preferably be a 6-membered ring. Such ring (preferably 6-membered) is preferably a cycloaliphatic ring. In particular, $R_1$ and $R_2$ may both be H or $R_1$ and $R_2$, together with the carbon atoms to which they are attached, may form a six-membered ring, preferably a six-membered cycloaliphatic ring. Preferably, $R_1$ and $R_2$ are both H.

In formulae (1) and (2), one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-W^2-R^{10})$, $-C(R^{11})(CO-W^3-R^{12})(CN)$, $-C(R^{13})(CN)_2$, a moiety comprising a polymerizable group and a moiety comprising a phosphine oxide group; or $R'_2$ is H and $R'_1$ and Y, together with the atoms to which they are attached, form a 5-8 membered ring;
wherein:

- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom.

In one embodiment, one of $R'_1$ and $R'_2$ is H and the other of $R'_1$ and $R'_2$ is $-OR^4$. In such a case, $R^4$ is preferably an optionally substituted alkyl.

In another embodiment, one of $R'_1$ and $R'_2$ is H and the other of $R'_1$ and $R'_2$ is $-SR^5$. In such a case, $R^5$ is preferably an optionally substituted alkyl.

In another embodiment, one of $R'_1$ and $R'_2$ is H and the other of $R'_1$ and $R'_2$ is $-NR^6R^7$. In such a case, $R^6$ and $R^7$, together with the nitrogen atom to which they are attached, preferably form a 5-7 membered ring; more preferably an optionally substituted ring selected from morpholine, piperidine, pyrrolidine, oxazolidine, piperazine, thiazolidine, thiomorpholine and azepane.

In another embodiment, one of $R'_1$ and $R'_2$ is H and the other of $R'_1$ and $R'_2$ is $-C(R^8)(CO-W^1-R^9)(CO-W^2-R^{10})$. In such a case, $R^8$, $R^9$, $R^{10}$, $W^1$ and $W^2$ are preferably as defined below:

- $R^8$ is H;
- $W^1$ and $W^2$ are independently a bond or an oxygen atom; and
- $R^9$ and $R^{10}$ are independently an optionally substituted alkyl.

In another embodiment, one of $R'_1$ and $R'_2$ is H and the other of $R'_1$ and $R'_2$ is a moiety comprising a polymerizable group. In such a case, the moiety comprising a polymerizable group, is preferably a moiety comprising a (meth)acrylate group. The moiety comprising a polymerizable group may correspond to the following formula (Acr):

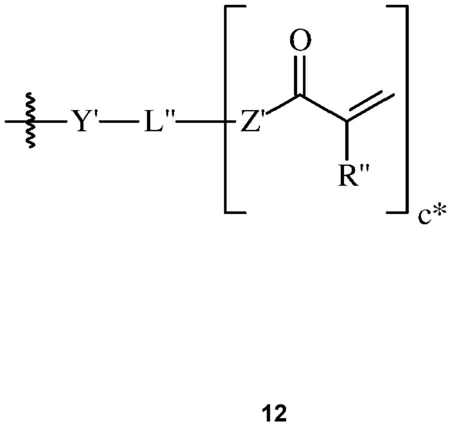

(Acr)

wherein

- Y' is -O-, -S- or -$NR^{14}$-;
- each Z' is independently -O- or -$NR^{15}$-;
- each R" is independently H or methyl;
- $R^{14}$ and $R^{15}$ are independently H or an optionally substituted alkyl;
- L" is a (c*+1)valent linker;
- c* is an integer from 1 to 6;

In particular, the moiety comprising a polymerizable group may correspond to the following formula (Acr):

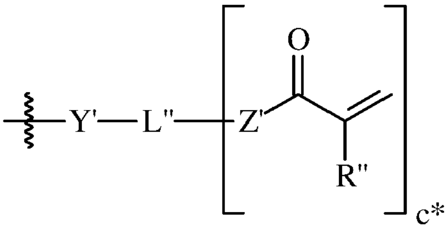
(Acr)

- Y' is-O- or -$NR^{14}$-;
- each Z' is -O- or -$NR^{15}$;
- each R" is independently H or methyl;
- $R^{14}$ and $R^{15}$ are preferably H;
- L" is a (c*+1)valent linker;
- c* is an integer from 1 to 4.

In another embodiment, one of $R'_1$ and $R'_2$ is H and the other of $R'_1$ and $R'_2$ is a moiety comprising a phosphine oxide group. In such a case, the phoshpine oxide group may have the following formula (PO):

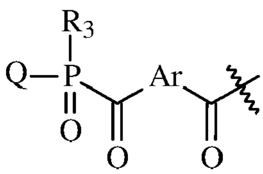
(PO).

wherein Q, $R_3$ and Ar are as defined above.

In another embodiment, $R'_2$ is H and $R'_1$ forms a 5-8 membered ring with Y. In such a case, the photoinitiator is preferably according to formula (6) or (7)

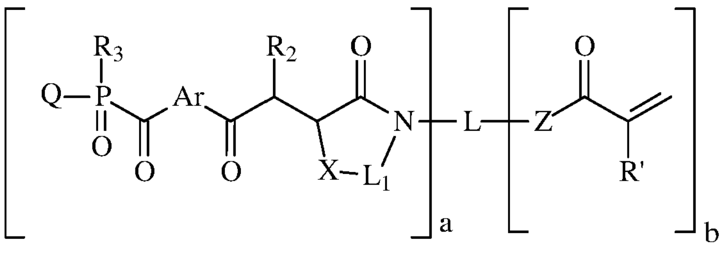
(6)

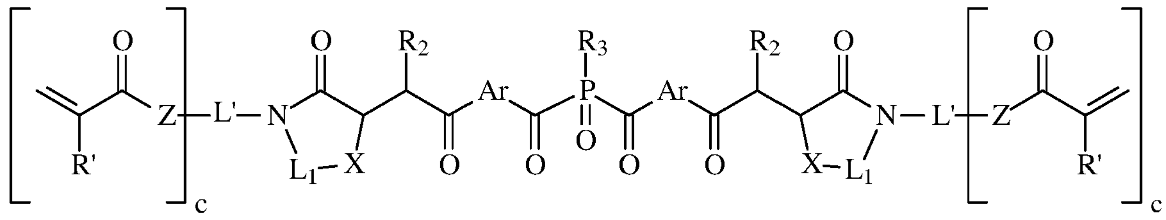
(7)

wherein:

- Ar, L, L', Q, R', $R_2$, $R_3$, Z, a, b and c are as defined herein;
- each X is independently selected from -O-, -S- and $-NR^{18}-$;
- $R^{18}$ is H or an optionally substituted alkyl;
- $L_1$ is an optionally substituted C1-C4 alkylene.

In formulae (6) and (7), each Z is preferably -O-. In formula (6) and (7), each X is preferably -O-. In formulae (6) and (7), a, b and c are preferably equal to 1. All of the other preferable recitations for formula (1) and (2) detailed herein equally apply to formula (6) and (7).
In formulae (1) and (2), each $R_3$ is independently an optionally substituted group selected from alkyl, aryl and alkoxy. In particular, each $R_3$ may independently be an optionally substituted phenyl, methoxy or ethoxy. Preferably, each $R_3$ is independently phenyl or ethoxy.
In formulae (1) and (2), Q is an optionally substituted aryl or a group of formula (3):

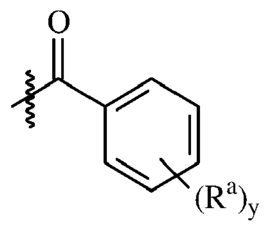
(3)

wherein:

- each $R^a$ is independently an optionally substituted group selected from alkyl, aryl, alkoxy, aryloxy, thioalkyl and thioaryl; and
- y is a number chosen from 0 to 5.

In one embodiment, Q may be an unsubstituted aryl such as phenyl.
In another embodiment, Q may be a group of formula (3) bearing from 1 to 5, preferably from 2 to 4, substituents $R^a$ as detailed above. Preferably such substituent(s) is (are) methyl group(s).
According to a preferred embodiment, Q may be phenyl or a group of formula (3a):

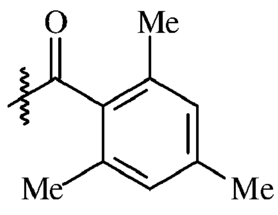
(3a).

In formulae (1) and (2), each Y is independently -O-, $-NR^{16}-$, or a group represented by the following formula (4):

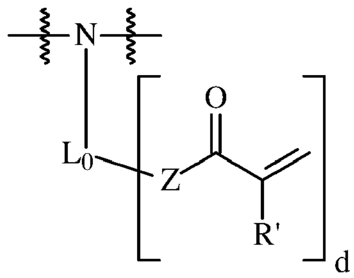

(4)

wherein

- Z and R' are as defined herein;
- each $L_0$ is independently a (d+1)valent linker;
- each d is independently an integer from 1 to 6.

In particular, each Y may be -O-.
Alternatively, each Y may be -S-.
Alternatively, each Y may be $-NR^{16}-$. In particular, $R^{16}$ may be H or $R^{16}$ may, together with the nitrogen atom to which it is attached, form a 5-8 membered ring with $R'_1$.
Alternatively, each Y may be a group of formula (4) wherein:

- $L_0$ is preferably alkylene;
- Z is preferably -O-;
- R' is H or methyl;
- d is preferably equal to 1.

In a preferred embodiment, each Y is independently -O, $-NR^{16}-$, or a group of formula (4).
In formulae (1) and (2), each Z is independently -O- or $-NR^{17}-$ wherein each $R^{17}$ is independently H or an optionally substituted group selected from alkyl and aryl.
In particular, each Z may be -O-.
Alternatively, each Z may be $-NR^{17}-$. In particular, $R^{17}$ may be H.
In a preferred embodiment, each Z is independently -O- or $-NR^{17}-$. When Z is $-NR^{17}-$, then $R^{17}$ is preferably H.
In formulae (1) and (2), each Y may be -O- and each Z may be -O-.
Alternatively, each Y may be -S- and each Z may be -O-.
Alternatively, each Y may be -NH- and each Z may be -NH-.
Alternatively, each Y may form a 5-8 membered ring with $R'_1$ and each Z may be -NH-.
Alternatively, each Y may be a group of formula (4) and each Z may be -O-. More particularly, each Y may be a group of formula (4) wherein

- $L_0$ is preferably alkylene;
- Z is preferably -O-;
- R' is H or methyl;
- d is preferably equal to 1

and each Z may be -O.
In formulae (1), (2) and (Acr), L, L' and L" are multivalent linkers. In particular, each L, L' and L" may independently be a divalent, trivalent, tetravalent, pentavalent or hexavalent linker. More particularly, each L, L' and L" may independently be a divalent, trivalent or tetravalent linker.
Each L, L' and L" may independently be selected from an aromatic linker, an aliphatic linker, a cycloaliphatic linker, a polyether linker, a polythioether linker, a polyalkylene imine linker, a polyester linker, a polycarbonate linker, a polyurethane linker, a polyorganosiloxane linker, a polybutadiene linker, and combinations thereof. Preferably, each L, L' and L" is independently selected from an aromatic linker, an aliphatic linker, a cycloaliphatic linker, a polyether linker, a polythioether linker, a polyalkylene imine linker, a polyester linker, a polyorganosiloxane linker, and combinations thereof.
Each L, L' and L" may independently be selected from:

- a divalent moiety according to any one of formulae (8) to (17):

$-(CR_4R'_4)e-$ (8)

$-CH_2-O-CH_2-$ (9)

$-[(CR_5R'_5)_f-W]_g-(CR_5R'_5)_f-$ (10)

$-[(CR_6R'_6)_h-W]_i-(CR_7R'_7)_j-[W-(CR_6R'_6)_h]_i-$ (11)

$-[(CR_8R'_8)_k-C(=O)O]_l-(CR_9R'_9)_m-$ (12)

$-(CR_9R'_9)_m-[(CR_8R'_8)_k-C(=O)O]_l-$ (13)

$-[(CR_{10}R'_{10})_n-O-C(=O)-(CR_{11}R'_{11})_o-C(=O)-O]_p-(CR_{10}R'_{10})_n-$ (14)

$-(CR_{12}R'_{12})_q-C(=O)-O-(CR_{13}R'_{13})_r-O-C(=O)-(CR_{12}R'_{12})_q-$ (15)

$-(CR_{14}R'_{14})_s-Cy-[L-Cy]_t-(CR_{14}R'_{14})_s-$ (16)

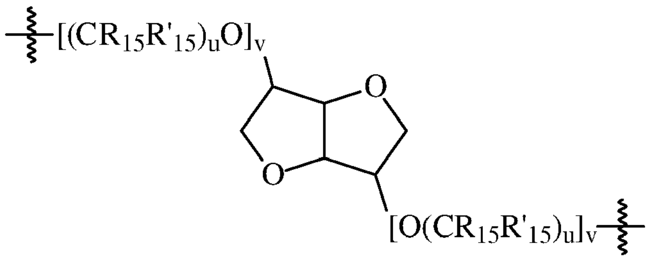

(17)

wherein:

- $R_4$, $R'_4$, $R_7$, $R'_7$, $R_9$, $R'_9$, $R_{10}$, $R'_{10}$, $R_{11}$, $R'_{11}$, $R_{12}$, $R'_{12}$, $R_{13}$, $R'_{13}$, $R_{14}$ and $R'_{14}$ are independently H or alkyl;
- $R_5$, $R'_5$, $R_6$, $R'_6$, $R_8$, $R'_8$, $R_{15}$ and $R'_{15}$ are independently H or methyl;
- each W is independently -O- or -S-;
- Cy is an optionally substituted ring, in particular an optionally substituted cyclohexylene or phenylene;
- L is a bond or a linker such as Alk, -C(=O)-, -C(=O)-O-Alk-O-C(=O)-, -SO-, $-SO_2-$, $-C(=CCl_2)-$ and -Alk-Ph-Alk-;
- Alk is an optionally substituted alkylene;
- Ph is an optionally substituted phenylene;
- e, j, m, n, o and r are independently an integer from 2 to 20;
- each s is independently an integer from 0 to 20;
- f, h and u are independently an integer from 2 to 4;
- t is an integer equal to 0 or 1;
- g, l, p and q are independently an integer from 1 to 20;
- each v is independently an integer from 0 to 10, in particular from 1 to 6;
- each i is independently an integer from 0 to 20 with the proviso that at least one i is not 0;
- k is an integer from 3 to 12;

- a trivalent moiety according to any one of formulae (18) to (23):

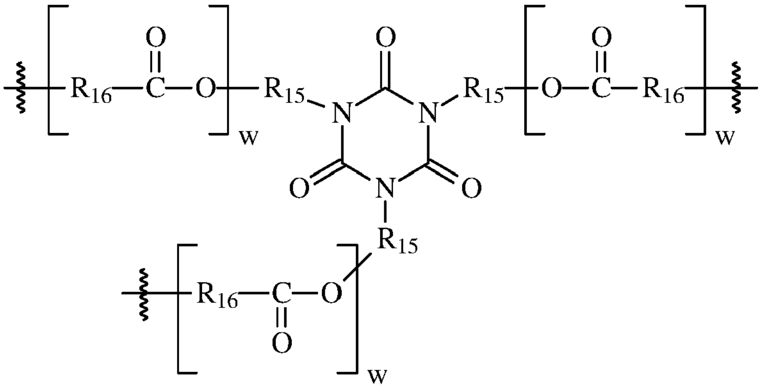

(18)

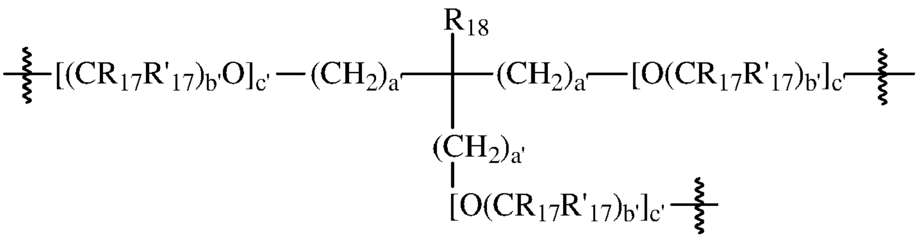

(19)

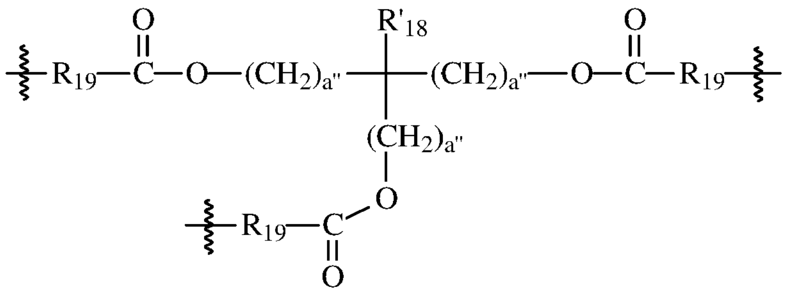

(20)

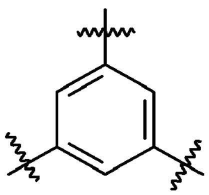

(21)

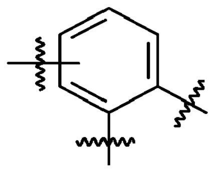

(22)

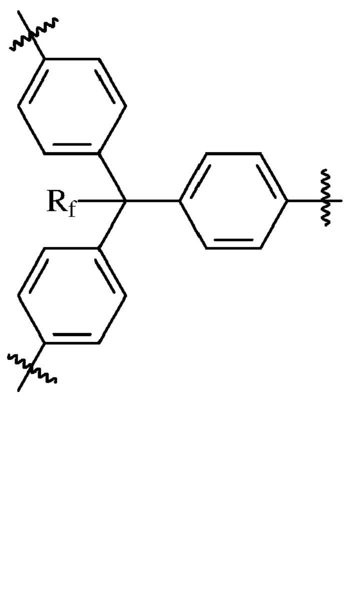

(23)

wherein:

- $R_{15}$ and $R_{16}$ are independently a linear or branched alkylene;
- $R_{17}$ and $R'_{17}$ are independently H or methyl;
- $R_{18}$ and $R'_{18}$ are independently H, alkyl or alkoxy, preferably $R_{18}$ and $R'_{18}$ are alkyl;
- each $R_{19}$ is independently a linear or branched alkylene;
- $R_f$ is H or methyl;
- w is an integer equal to 0 or 1;
- each a' is independently an integer from 0 to 2 with the proviso that not more than one a' is equal to 0, preferably each a' is equal to 1 or one a' is equal to 0 and the two other a' are equal to 1;
- each a" is independently an integer from 0 to 2 with the proviso that not more than one a" is equal to 0, preferably each a" is equal to 1 or one a" is equal to 0 and the two other a" are equal to 1;
- each b' is independently an integer from 2 to 4, in particular 2;
- each c' is independently an integer from 0 to 10, in particular from 1 to 6;

- a tetravalent moiety according to any one of formulae (24) to (27):

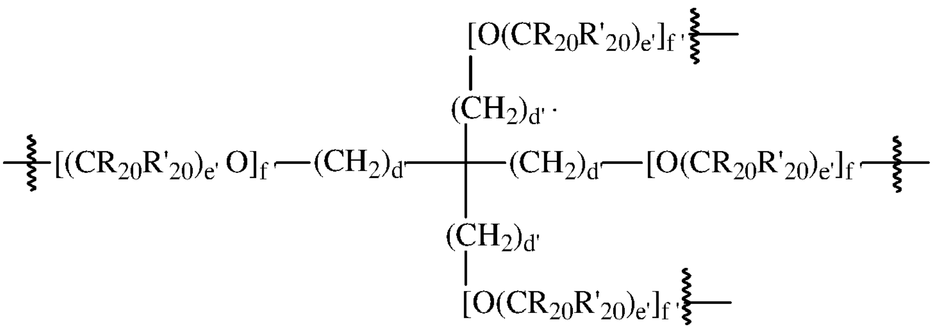

(24)

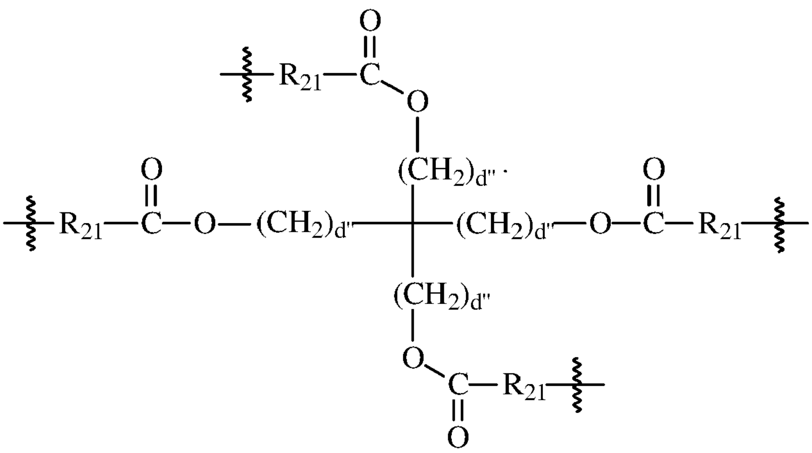

(25)

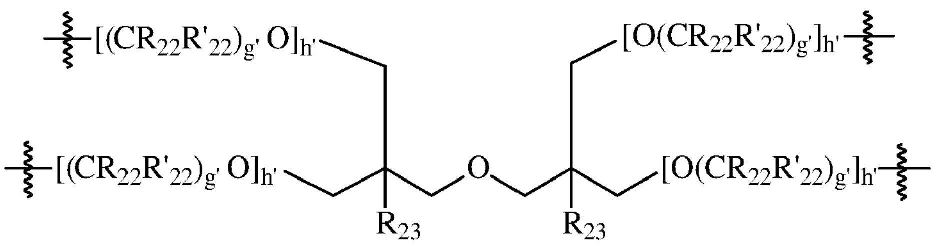

(26)

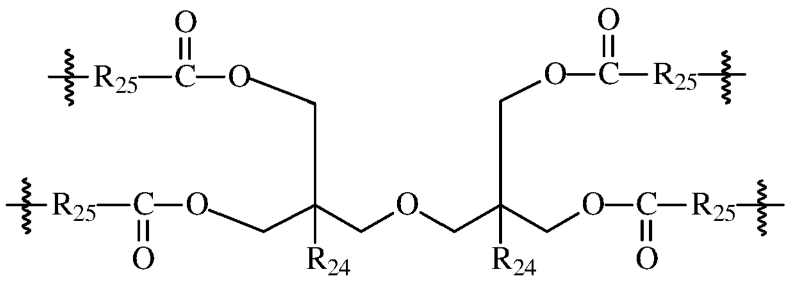

(27)

wherein:

- $R_{20}$, $R'_{20}$, $R_{22}$ and $R'_{22}$ are independently H or methyl;
- $R_{21}$ and $R_{25}$ is independently a linear or branched alkylene;
- $R_{23}$ and $R_{24}$ are independently H, alkyl or alkoxy, preferably alkyl;
- each d' is independently an integer from 0 to 2 with the proviso that not more than one d' is equal to 0, preferably each d' is equal to 1;
- each d" is independently an integer from 0 to 2 with the proviso that not more than one d" is equal to 0, preferably each d" is equal to 1;
- e' and g' are independently an integer from 2 to 4, in particular 2;
- f' and h' are independently an integer from 0 to 10, in particular from 1 to 6;

- a tetra-, penta- or hexavalent moiety according to formula (28):

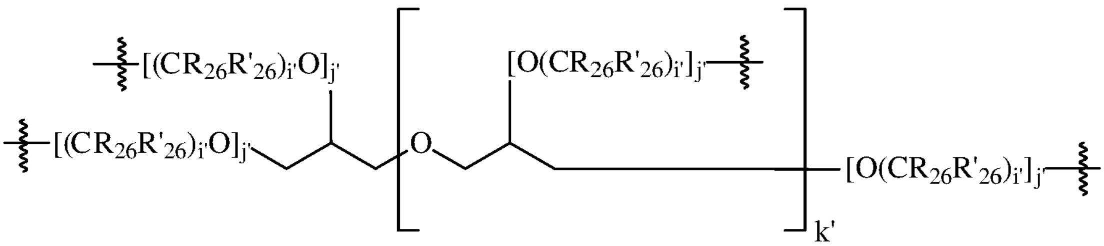

(28)

wherein:

- $R_{26}$ and $R'_{26}$ are independently H or methyl;
- each i' is independently an integer from 2 to 4, in particular 2;
- each j' is independently an integer from 0 to 10, in particular from 1 to 6;
- k' is an integer from 1 to 3;

- a tri-, tetra-, penta- or hexavalent moiety according to formula (29):

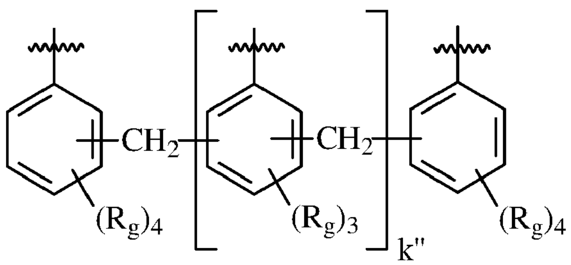

(29)

wherein

- each $R_g$ is independently selected from H, alkyl, cycloalkyl, aryl, alkaryl, aralkyl, alkoxy, -C(=O)O-Alkyl and a halogen atom;
- k" is an integer from 1 to 4.

- a hexavalent moiety according to any one of formulae (30) to (32):

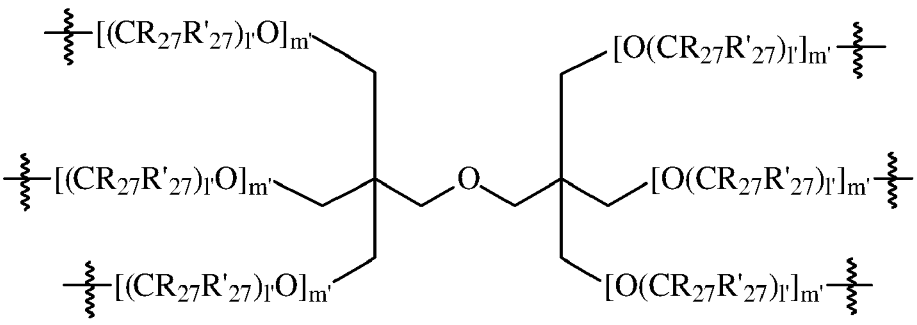

(30)

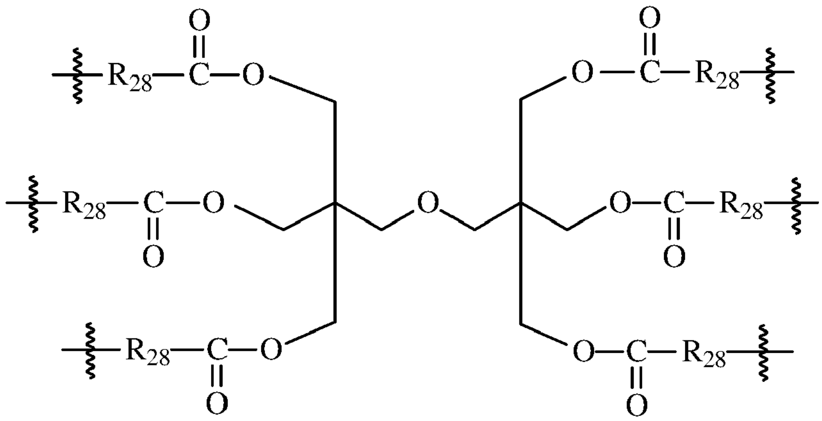

(31)

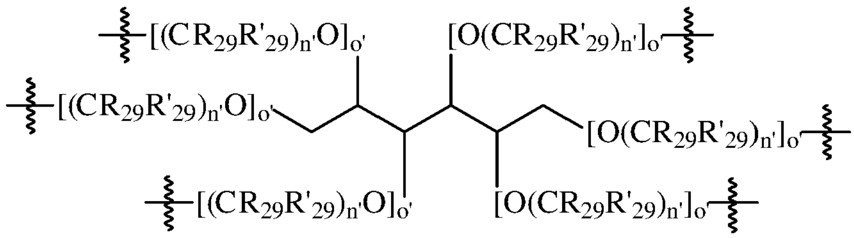

(32)

wherein

- $R_{27}$, $R'_{27}$, $R_{29}$ and $R'_{29}$ are independently H or methyl;
- each $R_{28}$ is independently a linear or branched alkylene;
- l' and n' are independently an integer from 2 to 4, in particular 2;
- m' and o' are independently an integer from 0 to 10, in particular from 1 to 6.

According to some embodiments, each L, L' and L" may independently be the residue of a polyol (i.e the residue that is obtained by removing the OH groups of a polyol). Examples of suitable polyols, referred to herein as $P_{OH}$, include ethylene glycol, 1,2- or 1,3-propylene glycol, 1,2-, 1,3- or 1,4-butylene glycol, 1,5-pentanediol, 1,6-hexanediol, 1,7-heptanediol, 1,8-octanediol, 1,9-nonanediol, 1,10-decanediol, 1,12-dodecanediol, 2-methyl-1,3-propanediol, 2,2-diethyl-1,3-propanediol, 3-methyl-1,5-pentanediol, 3,3-dimethyl-1,5-pentanediol, neopentyl glycol, 2,4-diethyl-1,5-pentanediol, 3,3-butylethyl-1,5-pentane diol, cyclohexanediol, cyclohexane-1,4-dimethanol, norbornene dimethanol, norbornane dimethanol, tricyclodecanediol, tricyclodecane dimethanol, dicyclopentadiene diol, hydroquinone bis(2-hydroxyethyl) ether, pyrocatechol, resorcinol, cardol, phloroglucinol, pyrogallol, tris(hydroxyphenyl)methane, tris(hydroxyphenyl)ethane, bisphenol A, B, F or S, hydrogenated bisphenol A, B, F or S, trimethylolmethane, trimethylolethane, trimethylolpropane, di(trimethylolpropane), triethylolpropane, pentaerythritol, di(pentaerythritol), tri(pentaerythritol), glycerol, di-, tri- or tetraglycerol, a polyglycerol, di-, tri- or tetra(ethylene glycol), di-, tri- or tetra(1,2-propylene glycol), di-, tri- or tetra(1,3-propylene glycol), di-, tri- or tetra(1,4-butylene glycol), a polyethylene glycol), a polypropylene glycol), a

poly(trimethylene glycol), a poly(tetramethylene glycol), a polyethylene glycol-co-propylene glycol), an alditol (i.e. erythritol, threitol, arabitol, xylitol, ribitol, mannitol, sorbitol, galactitol, fucitol or iditol), a dianhydrohexitol (i.e. isosorbide, isomannide, isoidide), tris(2-hydroxyethyl)isocyanurate, a hydroxylated vegetable oil, a $C_{36}$ dimer diol, a polybutadiene polyol, a polyester polyol, a polyether polyol, a polyorganosiloxane polyol (such as Silmer OH A0-UP, Silmer OH C50, Silmer OH J10, Silmer OH Di-10, Silmer OH Di-50, Silmer OHT A0, Silmer OHT Di-10, Silmer OHT Di-50, Silmer OHT Di-100, Silmer OHT Di-400, Simer OHT E13 which are available from Siltech or SiSiB® OF0035, SiSiB® OF0042, SiSiB® OF0156A, SiSiB® OF0156B, SiSiB® OF1300-M1100, SiSiB® OF1300-M2000, SiSiB® OF1300-M4000, SiSiB® OF6053, SiSiB® OF6055, SiSiB® OF9020 which are available from Sinosil) , a polycarbonate polyol, as well as the alkoxylated (e.g., ethoxylated and/or propoxylated) derivatives thereof and the derivatives obtained by ring-opening polymerization of a lactone (such as ε-caprolactone) initiated with one of the aforementioned polyols, and combinations thereof.

In particular, each L, L' and L" may independently be the residue of a polyol selected from an optionally alkoxylated trimethylolpropane, an optionally alkoxylated di(trimethylolpropane), an optionally alkoxylated pentaerythritol, an optionally alkoxylated di(pentaerythritol), an optionally alkoxylated glycerol, an optionally alkoxylated di-, tri or tetraglycerol, an optionally alkoxylated sorbitol, a polyethylene glycol), a polypropylene glycol), a polyethylene glycol-co-propylene glycol), a poly(trimethylene glycol), a poly(tetramethylene glycol), a polycaprolactone polyol, and combinations thereof.

According to some embodiments, each L, L' and L" may independently be the residue of a polythiol (i.e the residue that is obtained by removing the SH groups of a polythiol). Examples of suitable polythiols, also referred to herein as $P_{SH}$, include ethane-1,2-dithiol, propane-1,3-dithiol, butane-1,4-dithiol, hexane-1.6-dithiol, octane-1,8-dithiol, decane-1,10-dithiol, 1,8-dimercapto-3,6-dioxaoctane (DMDO), di-, tri- or polyethylene glycol di(ethanethiol), ethylene glycol bis(mercaptoacetate), ethylene glycol bis(3-mercaptopropionate), ethylene glycol bis(3-mercaptobutyrate), 1,2-propylene glycol bis(mercaptoacetate), 1,2-propylene glycol bis(3-mercaptopropionate), 1,2-propylene glycol bis(3-mercaptobutyrate), 1,3-propylene glycol bis(mercaptoacetate), 1,3-propylene glycol bis(3-mercaptopropionate), 1,3-propylene glycol bis(3-mercaptobutyrate), 1,4-butanediol bis(mercaptoacetate), 1,4-butanediol bis(3-mercaptopropionate), 1,4-butanediol bis(3-mercaptobutyrate), 1,6-hexanediol bis(mercaptoacetate), 1,6-hexanediol bis(3-mercaptopropionate), 1,6-hexanediol bis(3-mercaptobutyrate), di-, tri- or polyethylene glycol bis(mercaptoacetate), di-, tri- or polyethylene glycol bis(3-mercaptopropionate), di-, tri- or polyethylene glycol bis(3-mercaptobutyrate), di-, tri- or polypropylene glycol bis(mercaptoacetate), di-, tri- or polypropylene glycol bis(3-mercaptopropionate), di-, tri- or polypropylene glycol bis(3-mercaptobutyrate), trimethylolpropane tris(mercaptoacetate), trimethylolpropane tris(3-mercaptopropionate), trimethylolpropane tris(3-mercaptobutyrate), pentaerythritol tris(mercaptoacetate), pentaerythritol tris(3-mercaptopropionate), pentaerythritol tris(3-mercaptobutyrate), pentaerythritol tetrakis(mercaptoacetate), pentaerythritol tetrakis(3-mercaptopropionate), pentaerythritol tetrakis(3-mercaptobutyrate), tris[2-(3-mercaptopropionyloxy)ethyl] isocyanurate, tris[2-(3-mercaptopropionyloxy)ethyl] isocyanurate, tris[2-(3-mercaptobutyryloxy)ethyl] isocyanurate, mercaptan-terminated polymers (such as Capcure® 3-800 (BASF), GPM-800 (Gabriel Performance Products), Capcure® LOF (BASF), GPM-800LO (Gabriel Performance Products), KarenzMT PE-1 (Showa Denko)), a mercapto-functionalized polyorganosiloxane (such as Silmer SH JO, Silmer SH Q20 and Silmer SH 208-30Q available from Siltech), as well as the alkoxylated (e.g., ethoxylated and/or propoxylated) derivatives thereof, and combinations thereof.

According to some embodiments, each L, L' and L" may independently be the residue of a polyamine (i.e the residue that is obtained by removing the primary and secondary amine groups of a polyamine). Examples of suitable polyamines, also referred to herein as $P_{NH}$, include 1-amino-3-aminomethyl-3,5,5-trimethyl cyclohexane (IPDA), bis(4-aminocyclohexyl)methane, bis(4-amino-3-methylcyclohexyl)methane, 2-methyl pentamethylene diamine, ethylene diamine, 1,2- or 1,3-propanediamine, 2-methyl-1,2-propanediamine, 2,2-dimethyl-1,3-propanediamine, 1,3- or 1,4-butane diamine, 1,3- or 1,5-pentane diamine, 2-methyl-1,5-pentane diamine, 1,6-hexane diamine, 2,5-dimethyl-2,5-hexane diamine, 2,2,4- or 2,4,4-trimethyl-1,6-hexane diamine, 1,7-heptane diamine, 1,8-octane diamine, 1,9-nonane diamine, 1,10-decanediamine, 1,11-undecane diamine, 1,12-dodecane diamine, 2,4- or 2,6-hexahydrotoluylene diamine, 2,4'- or 4,4'-diaminodicyclohexylmethane, 1,3- or 1,4-cyclohexane diamine, 1,3- or 1,4-bis(methylamino)cyclohexane, 1,8-p-menthane diamine, hydrazine, phenylene diamine, 2,3- 2,4- 3,4- or 2,6-toluylene diamine, o-, m- or p-xylylene diamine, 2,4'- or 4,4'-diaminodiphenyl methane, benzidine, N-(2-aminoethyl)-1,3-propane diamine, N,N'-di-(2-aminoethyl)piperazine, a polyetheramine (in particular a Jeffamine® such as Jeffamine® D-230, Jeffamine® D-400, Jeffamine® D-2000, Jeffamine® D-2010, Jeffamine® D-4000, Jeffamine® ED-600, Jeffamine® ED-900, Jeffamine® ED-2003, Jeffamine® EDR-148, Jeffamine® EDR-176, Jeffamine® THF-100, Jeffamine® THF-170, Jeffamine® T403, Jeffamine® T3000, Jeffamine® T5000, Jeffamine® RFD-270), an amino-functionalized polyorganosiloxane (such as Silmer NH C50, Silmer NH Di-8 and Silmer NH Di-50 available from Siltech), and combinations thereof.

In particular, each L, L' and L" may independently be the residue of a polyetheramine, more particularly a Jeffamine® such as Jeffamine® D-230, Jeffamine® D-400, Jeffamine® D-2000, Jeffamine® D-2010, Jeffamine® D-4000, Jeffamine® ED-600, Jeffamine® ED-900, Jeffamine® ED-2003, Jeffamine® EDR-148, Jeffamine® EDR-176, Jeffamine® THF-100, Jeffamine® THF-170, Jeffamine® T403, Jeffamine® T3000, Jeffamine® T5000, Jeffamine® RFD-270.

According to some embodiments, each L, L' and L" may independently be the residue of an aminoalcohol bearing

at least one primary or secondary amine group and at least one hydroxy group (i.e the residue that is obtained by removing the primary or secondary amine groups and the hydroxy group(s) of said aminoalcohol). Examples of suitable aminoalcohols are monoethanolamine, diethanolamine, diisopropanolamine, 3-methylamino-1,2-propanediol, 2-(N-methylamino)-1,3-propanediol, tris(hydroxymethyl)aminomethane, 1-(N-methylamino)butane-1,3-diol, N-methylethanolamine, N-ethylethanolamine, N-isopropylethanolamine, N-butylethanolamine, N-nonylethanolamine, N-(2-aminoethyl)ethanolamine, N-(3-aminopropyl)ethanolamine, N-ethyl-N-(2-aminoethyl)-ethanolamine, and N-methyl-N-(3-aminopropyl)ethanolamine, N-(2-hydroxyethyl)piperazine, 2-amino-1-propanol, 2-amino-2-methyl-1-propanol.

Alternatively, each L and L' may independently be a plurivalent moiety corresponding to the following formula (33):

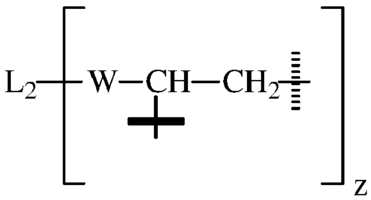

(33)

wherein

- $L_2$ is a z-valent linker;
- W is a bond, #-O-$CH_2$- or #-C(=O)-O-$CH_2$-;
- z is an integer of at least 2;
- the symbol # represents a point of attachment to $L_2$;
- the bold line represents a point of attachment to a (meth)acrylate group;
- the hashed line represents a point of attachment to a phosphine oxide-containing group or to a (meth)acrylate group, provided that at least one of the hashed lines represents a point of attachment to a phosphine oxide-containing group.

In formula (33), $L_2$ may be selected from:

- a divalent moiety according to any one of formulae (8) to (17) as defined above for L and L';
- a trivalent moiety according to any one of formulae (18) to (23) as defined above for L and L';
- a tetravalent moiety according to any one of formulae (24) to (27) as defined above for L and L';
- a tetra-, penta- or hexavalent moiety according to formula (28) as defined above for L and L';
- a tri-, tetra-, penta- or hexavalent moiety according to formula (29) as defined above for L and L';
- a hexavalent moiety according to any one of formulae (30) to (32) as defined above for L and L'.

In particular, $L_2$ may be the residue of a polyepoxide (i.e. the residue obtained by removing the epoxy groups of a polyepoxide). Examples of suitable polyepoxides, referred to herein as $P_{EPOX}$, diglycidyl ether, 1,2,3,4-diepoxybutane, 1,2,4,5-diepoxypentane, 1,2,5,6-diepoxyhexane, 1,2,7,8-diepoxyoctane, 1,2,9,10-diepoxydecane, ethylene glycol diglycidyl ether, 1,2- or 1,3-propylene glycol diglycidyl ether, 1,2-, 1,3- or 1,4-butanediol diglycidyl ether, 1,5-pentanediol diglycidyl ether, 1,6-hexanediol diglycidyl ether, 1,7-hexanediol diglycidyl ether, 1,8-octanediol diglycidyl ether, 1,9-nonanediol diglycidyl ether, 1,10-decanediol diglycidyl ether, 1,12-dodecanediol diglycidyl ether, 2-methyl-1,3-propanediol diglycidyl ether, neopentyl glycol diglycidyl ether, 2,2-diethyl-1,3-propane diol diglycidyl ether, 3-methyl-1,5-pentanediol diglycidyl ether, 3,3-dimethyl-1,5-pentanediol diglycidyl ether, 2,4-diethyl-1,5-pentanediol diglycidyl ether, 3,3-butylethyl-1 ,5-pentane diol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a polyethylene glycol) diglycidyl ether, a polypropylene glycol) diglycidyl ether, a poly(trimethylene glycol) diglycidyl ether, a poly(tetramethylene glycol) diglycidyl ether, a polyethylene glycol-co-propylene glycol) diglycidyl ether, glycerol triglycidyl ether, a polyglycerol polyglycidyl ether, trimethylolmethane triglycidyl ether, trimethylolethane triglycidyl ether, trimethylolpropane triglycidyl ether, di(trimethylolpropane) tetraglycidyl ether, pentaerythritol tetraglycidyl ether, diglycidyl cyclohexanedicarboxylate, cyclohexane diglycidyl ether, cyclohexane-1,4-dimethanol diglycidyl ether, tricyclodecane dimethanol diglycidyl ether, isosorbide diglycidyl ether, pyrocatechol diglycidyl ether, resorcinol diglycidyl ether, cardol diglycidyl ether, phloroglucinol triglycidyl ether, pyrogallol triglycidyl ether, tris(hydroxyphenyl)methane triglycidyl ether, tris(hydroxyphenyl)ethane triglycidyl ether, bisphenol A, B, F or S diglycidyl ether, hydrogenated bisphenol A, B, F or S diglycidyl ether, diglycidyl phthalate, diglycidyl terephthalate, diglycidyl isophthalate; an epoxidized vegetable oil (such as epoxidized soybean oil and epoxidized linseed oil), epoxidized polybutadiene; triglycidyl isocyanurate, an epoxy-functionalized polyorganosiloxane, and combinations thereof.

In particular, each $L_2$ may independently be the residue of a polyepoxide selected from 1,4-butanediol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a polyethylene glycol) diglycidyl ether, a polypropylene glycol) diglycidyl ether, a poly(trimethylene glycol) diglycidyl ether, a poly(tetramethylene glycol) diglycidyl ether, a polyethylene glycol-co-propylene glycol) diglycidyl ether, glycerol triglycidyl ether, a polyglycerol polyglycidyl ether, and combinations thereof.

In formula (33), W is a bond, #-O-$CH_2$- or #-C(=O)-O-$CH_2$-. In particular, W may be #-O-$CH_2$- or #-C(=O)-O-$CH_2$-. More particularly W may be #-O-$CH_2$-.

In formula (33), z is an integer of at least 2. In particular, z is an integer from 2 to 6. More particularly, z is an integer equal to 2, 3, 4, 5 or 6, preferably 2, 3 or 4, more preferably 2 or 3.

In formulae (1), (2), (6) and (7), each R' is independently H or methyl. In one embodiment, each R' is H. In another embodiment, each R' is methyl. In yet another embodiment, part of the R' groups are H and the remaining R' groups are methyl.

In formulae (1), (2), (4), (6) and (7), a, b, c and d are independently an integer from 1 to 6.

In formulae (1) and (6), a may be an integer equal to 1, 2, 3, 4, 5 or 6. In particular, a may be an integer equal to 1, 2 or 3, more particularly a may be an integer equal to 1 or 2.

In formulae (1) and (6), b may be an integer equal to 1, 2, 3, 4, 5 or 6. In particular, b may be an integer equal to 1, 2, 3 or 4, more particularly b may be an integer equal to 1, 2 or 3.

In formulae (2) and (7), c may be an integer equal to 1, 2, 3, 4, 5 or 6. In particular, c may be an integer equal to 1, 2, 3 or 4, more particularly c may be an integer equal to 1, 2 or 3.

In formula (4), d may be an integer equal to 1 or 2. In particular, d may be an integer equal to 1.

Non-limiting examples of photoinitiators of formulae (1) and (2) are detailed below:

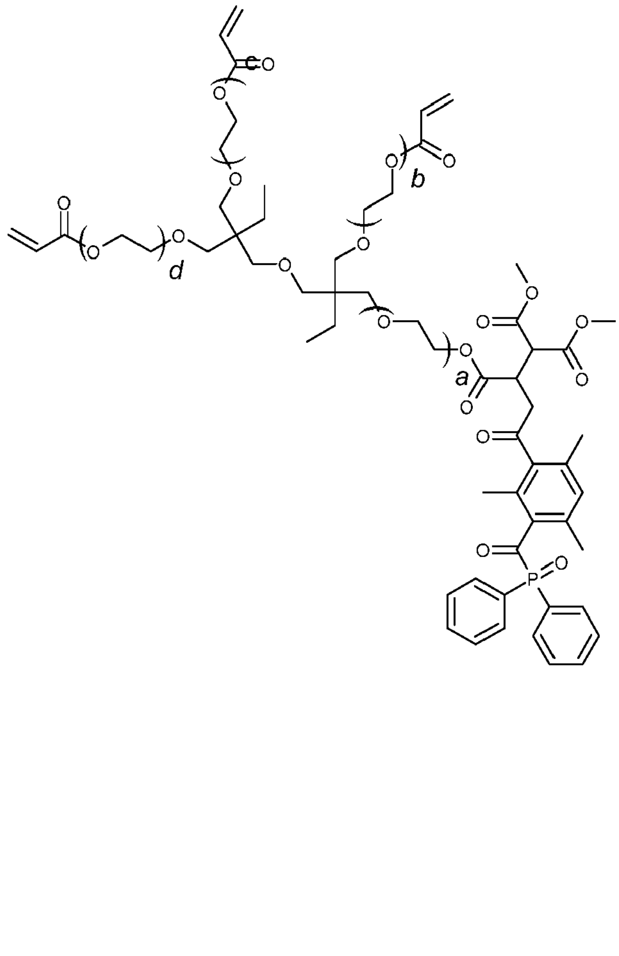

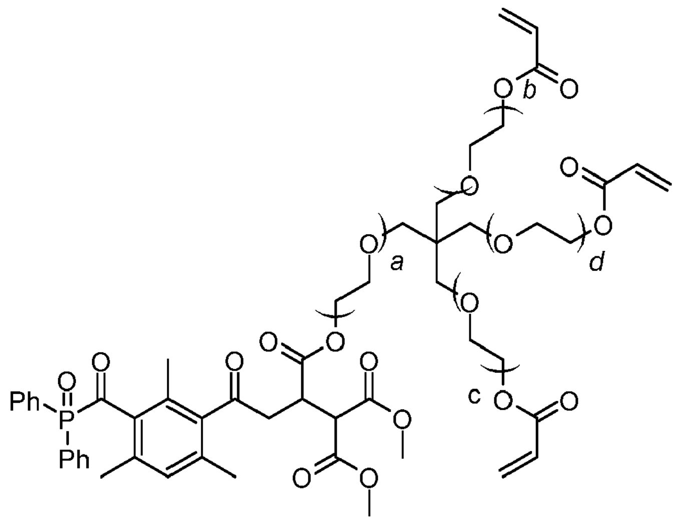

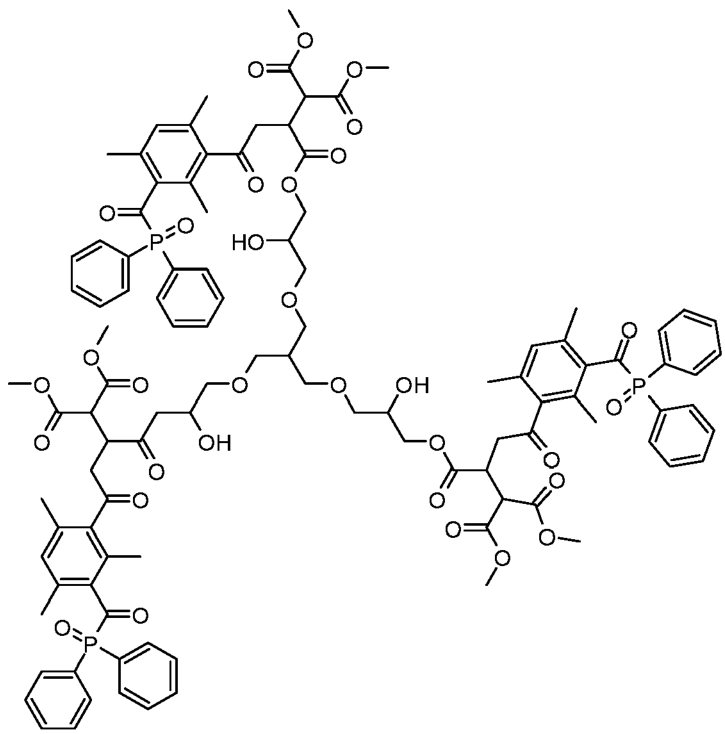

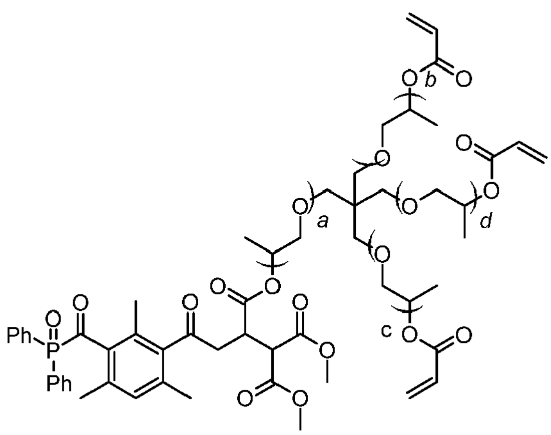

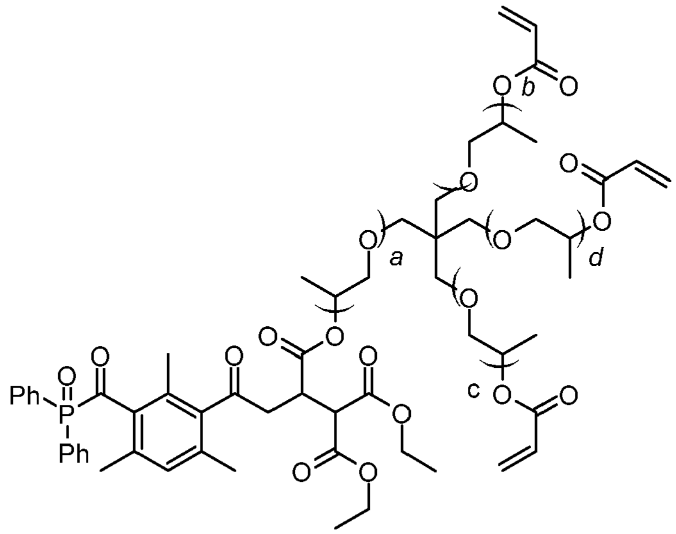

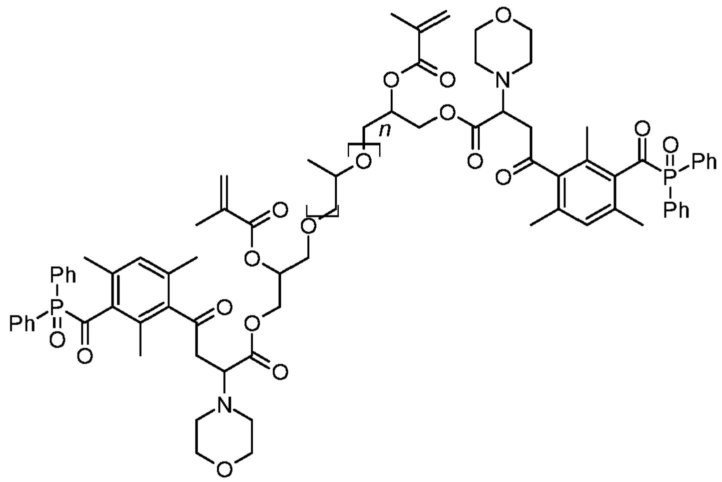

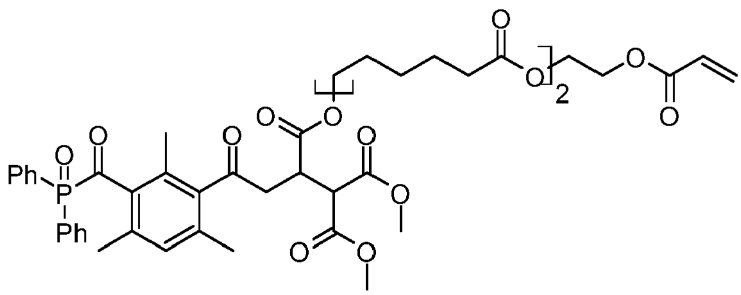

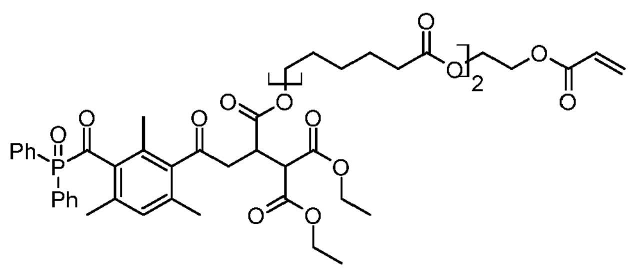

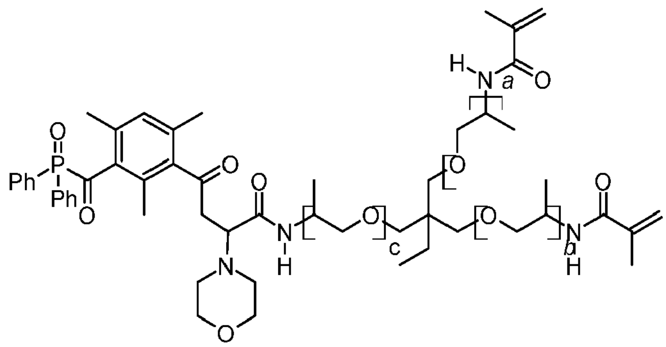

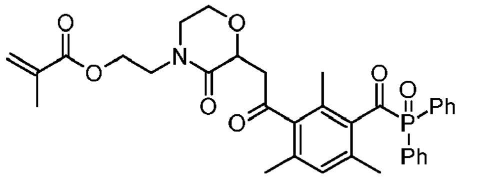

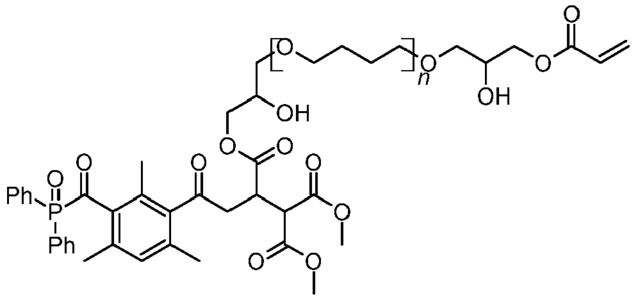

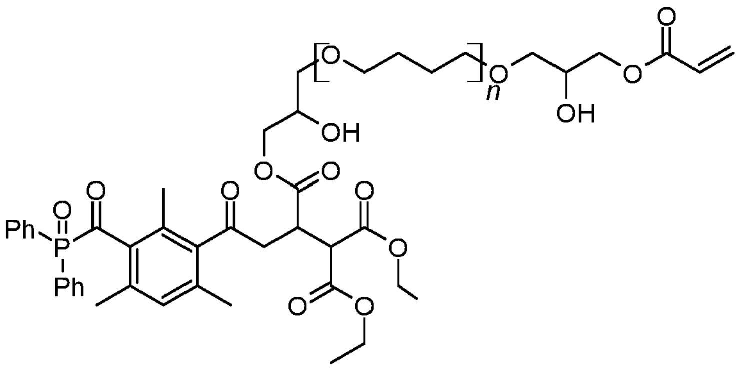

and isomers therof;
wherein each a, b, c, d and n independently represents an integer from 0 to 50.

In the formulas above, one or more of the oxyethylene units may indifferently be replaced by an oxypropylene unit and/or one or more of the oxypropylene units may indifferently be replaced by an oxyethylene unit.

The photoinitiators of formulae (1), (2), (6) and (7) may be prepared by a process as detailed below.

## Preparation processes and precursors

All of the particular and preferred embodiments described above for the photoinitiators of formula (1), (2), (6) and (7) equally apply to the following processes and precursors.

### *Process n°1 and related precursors*

The photoinitiator of formula (1) or (2) as described above may be prepared by a process comprising reacting at least one precursor of formula (34) or (35) with at least one product of formula (36):

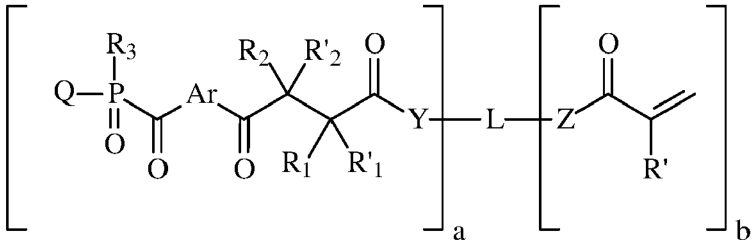

(1)

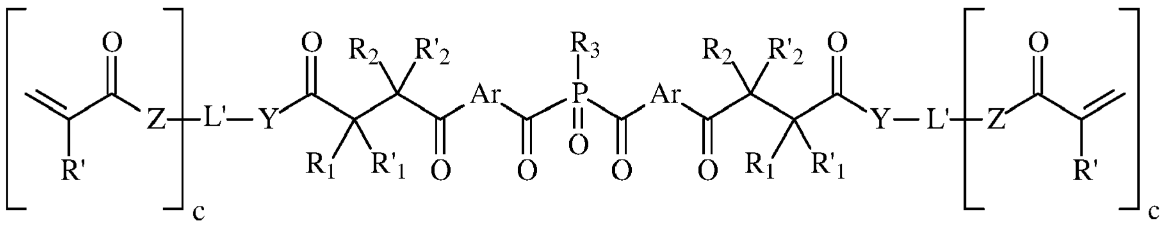

(2)

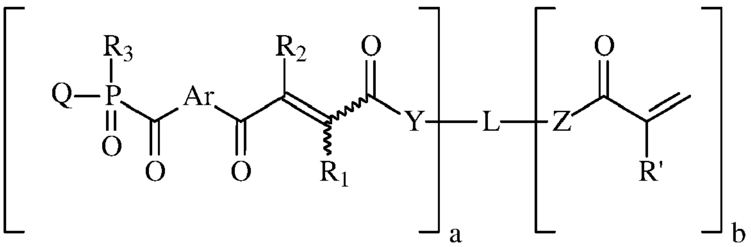

(34)

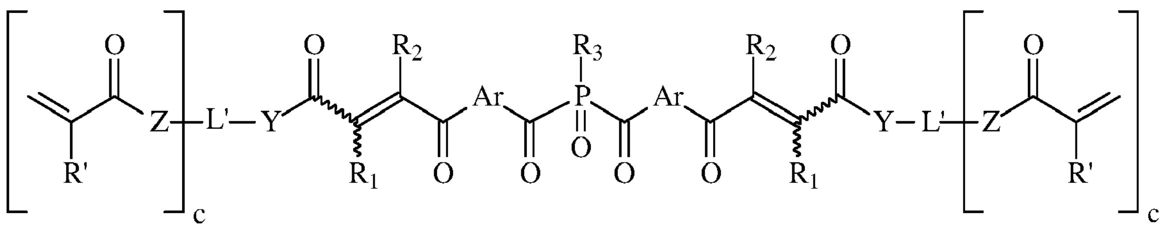

(35)

$R'_1$-$R'_2$ (36)

wherein Ar, $R_1$, $R_2$, $R_3$, $R'_1$, $R'_2$, Q, L, L' Y, Z, R', a, b and c are as defined above.

The wavy bonds illustrated in the formulas (34) and (35) represent either the cis or trans isomer.

Preferably, the product of formula (36) may be selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, *N*-methylpiperazine, oxazolidine, thiazolidine, thiomorpholine, azepane), more particularly a secondary cyclic amine (for example morpholine, piperidine, pyrrolidine, *N*-methylpiperazine, oxazolidine, thiazolidine, thiomorpholine, azepane);
- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);
- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile);

- a partially (meth)acrylated polyol and the polyol is as listed above for $P_{OH}$;
- a partially (meth)acrylated polyamine and the polyamine is as listed above for PNH.

The above reaction may be carried out in the presence of one or more compounds selected from:

- a base, in particular a base chosen from sodium or potassium hydroxide, sodium or potassium carbonate or an amine base, such as a tertiary amine base, for example triethylamine, *N*,*N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as toluene, xylene, 2-butanone, methanol, *N*-methylpyrrolidinone, *N,N*-dimethylformamide, *N,N*-dimethylacetamide, dimethyl sulfoxide, sulfolane and mixtures thereof.

Said reaction may be carried out at a temperature from 10 to 120°C and preferably from 50 to 100°C. Said reaction may be carried out for a duration from 30 min to 24 hours and preferably from 1 to 10 hours. Once the reaction is finished, the reaction medium may be washed one or more times with an aqueous solution, for example an aqueous solution of hydrochloric acid, an aqueous solution of sodium bicarbonate and/or an aqueous solution of sodium chloride. The solvent(s) may be evaporated from the resulting organic phase.

The invention also relates to a precursor of formula (34) or (35):

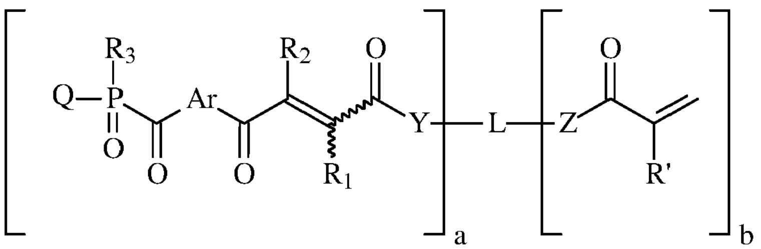

(34)

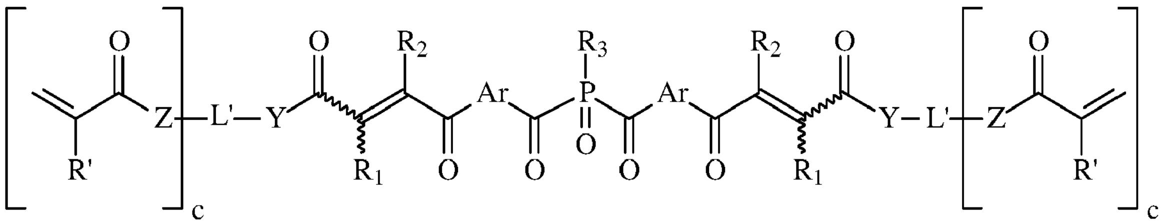

(35)

wherein Ar, $R_1$, $R_2$, $R_3$, Q, L, L', Y, Z, R', a, b and c are as defined above.

Examples of suitable precursors of formula (34) and (35) are listed below:

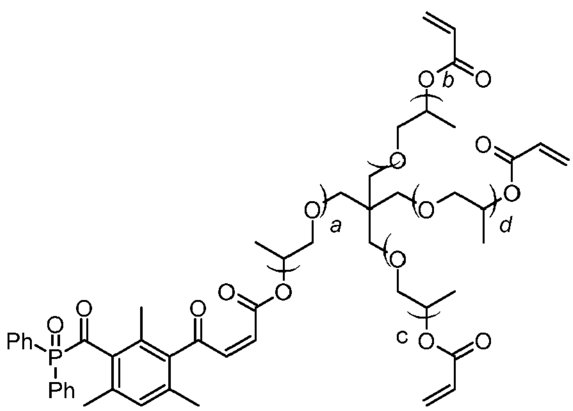

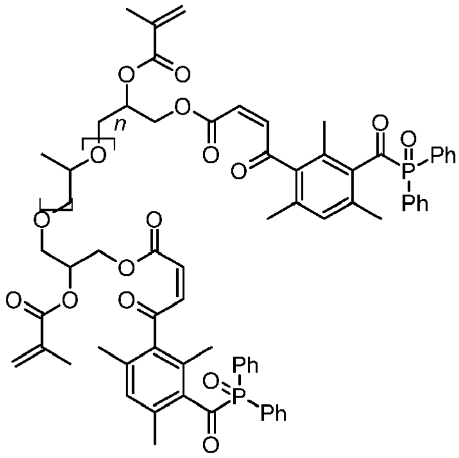

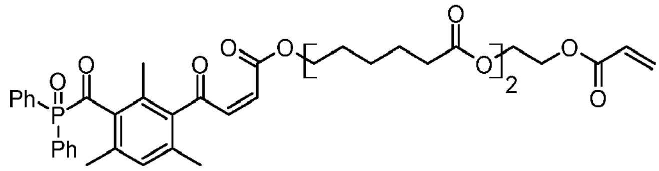

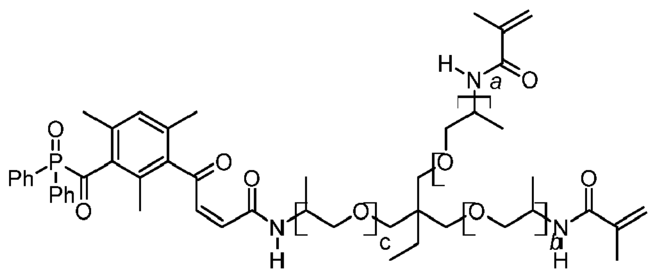

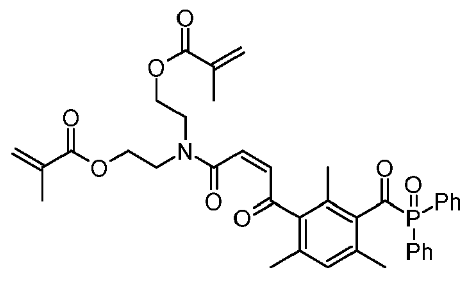

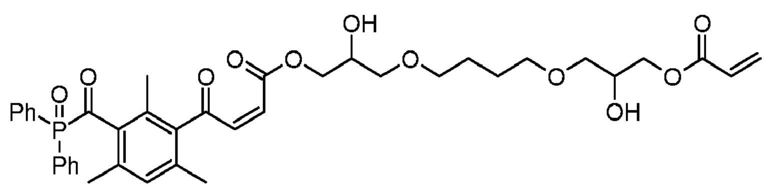

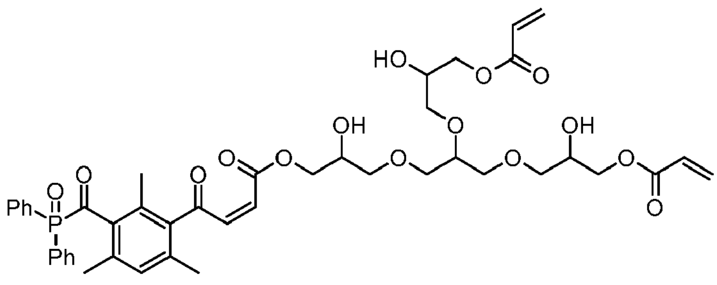

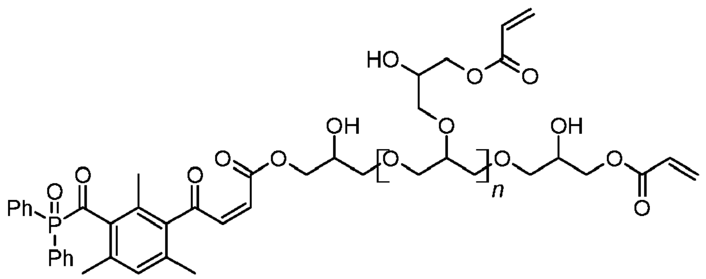

and isomers therof;

wherein each a, b, c, d and n independently represents an integer from 1 to 50. In the formulas above, one or more of the oxyethylene units may indifferently be replaced by an oxypropylene unit and/or one or more of the oxypropylene units may indifferently be replaced by an oxyethylene unit.

The precursor of formula (34) may be prepared by a process comprising:

- reacting at least one precursor of formula (37) with a compound of formula (38); or
- reacting at least one precursor of formula (37) with a compound of formula (39) and a compound of formula (40); or
- reacting at least one precursor of formula (37) with a compound of formula (41) and a compound of formula (40):

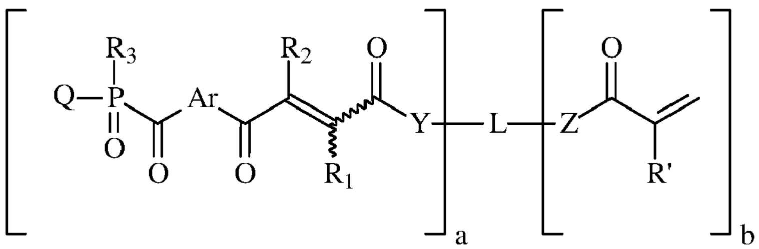

(34)

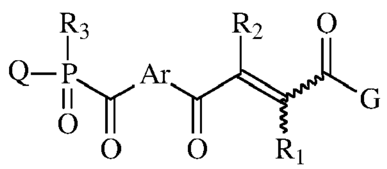

(37)

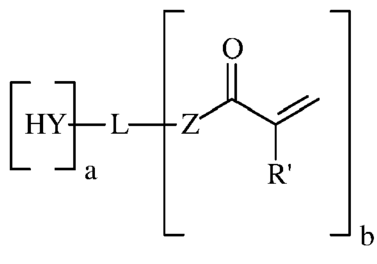

(38)

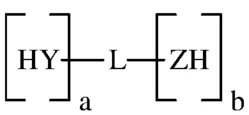

(39)

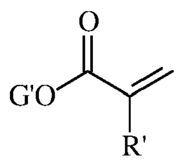

(40)

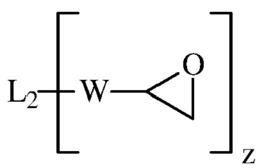

(41)

wherein:

- Ar, $R_1$, $R_2$, $R_3$, Q, L, $L_2$, W, Y, Z, R', a, b and z are as defined herein;
- G and G' are independently OH, a halogen atom or -O-C(=O)-J;
- J is alkyl or aryl, in particular tert-butyl.

The wavy bonds illustrated in formula (37) represent either the cis or trans isomer.

The reaction of the at least one precursor of formula (37) with at least one product of formula (39) or (41) and at least one product of formula (40) may be carried out simultaneously or in successive steps (i.e. in a first step the at least one precursor of formula (37) reacts with at least one product of formula (39) or (41) and in a second step at least one product of formula (40) is added to the resulting product).

The above reaction may be carried out in the presence of one or more compounds selected from:

- a catalyst, in particular a catalyst chosen from a zirconium catalyst, a titanium catalyst, a quaternary ammonium salt and an acid catalyst, preferably chosen from a zirconium (IV) catalyst, a titanium (IV) catalyst, a tetraalkylammonium salt, sulfuric acid or a sulfonic acid, more preferably chosen from zirconium(IV) acetylacetonate, titanium(IV) isopropoxide, titanium (IV) oxyacetylacetonate, tetrabutylammonium bromide, tetrabutylammonium chloride, sulfuric acid, methanesulfonic acid, para-toluenesulfonic acid or trifluoromethanesulfonic acid;
- a solvent, in particular a solvent selected from toluene, xylene, acetonitrile, acetone, tetrahydrofuran and mixtures thereof;
- a co-solvent such as *N*-methylpyrrolidinone, *N,N*-dimethylformamide, *N,N*-dimethylacetamide, dimethyl sulfoxide, sulfolane and mixtures thereof.
- a stabilizer/polymerization inhibitor, in particular a polymerization inhibitor selected from hydroquinone (HQ), hydroquinone monomethyl ether (MEHQ, 4-methoxyphenol), 4-tert-butylcatechol (TBC), 3,5-di-tertiobutyl-4-hydroxytoluene (BHT), phenothiazine (PTZ), 4-hydroxy-TEMPO or TEMPOL (4-hydroxy-2,2,6,6-tetramethylpiperidin-1-oxyl) and mixtures thereof.

Said reaction may be carried out in the presence of a zirconium catalyst, a titanium catalyst or an acid catalyst when the reaction corresponds to an esterification, amidification or thioesterification reaction. Said reaction may be carried out in the presence of a quaternary ammonium salt as the catalyst when the reaction corresponds to the opening of an epoxy ring. Said reaction may be carried out at a temperature from 70 to 140°C and preferably from 90 to 130°C. Said reaction may be carried out for a duration from 1 to 72 hours and preferably from 4 to 24 hours. Said reaction may be carried out so as to eliminate the water that is formed during the reaction. For example, the reaction may be carried out in a reactor equipped with a condenser (i.e. Dean-Stark) and the reaction medium may be heated at a temperature sufficient to evaporate the water (optionally as an azeotropic mixture with a solvent). Once the reaction is finished, the reaction medium may be washed one or more times with an aqueous solution, for example an aqueous solution of sodium chloride. The solvent(s) may be evaporated from the resulting organic phase.

In one embodiment, the precursor of formula (34) may be prepared by a process comprising reacting at least one precursor of formula (37) with at least one compound of formula (38a):

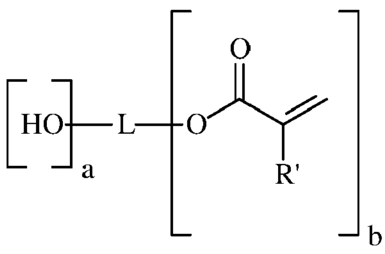

(38a)

wherein L, R', a and b are as defined above.

Preferably, the compound of formula (38a) is a partially (meth)acrylated polyol and the polyol is as listed above for $P_{OH}$.

Alternatively, the precursor of formula (34) may be prepared by a process comprising reacting at least one precursor of formula (37) with at least one compound of formula (38b):

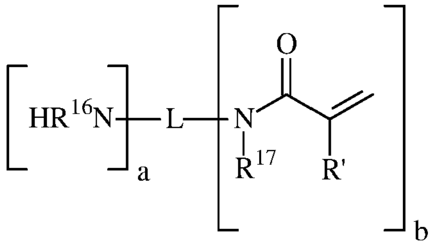

(38b)

wherein L, R’, $R^{16}$, $R^{17}$, a and b are as defined above.

Preferably, the compound of formula (38b) is a partially (meth)acrylated polyamine and the polyamine is as listed above for $P_{NH}$.

Alternatively, the precursor of formula (34) may be prepared by a process comprising reacting at least one precursor of formula (37) with at least one compound of formula (41) and at least one compound of formula (40):

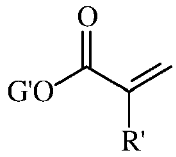

(40)

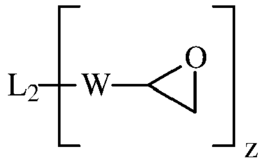

(41)

wherein G’, $L_2$, R’, W and z are as defined above.

Preferably, the compound of formula (41) is a polyepoxide as defined above for PEPOX.

The invention also relates to a process for the preparation of a precursor of formula (35) as defined above, wherein the process comprises:

- reacting at least one precursor of formula (42) with a compound of formula (43); or
- reacting at least one precursor of formula (42) with a compound of formula (44) and a compound of formula (40); or
- reacting at least one precursor of formula (42) with a compound of formula (41) and a compound of formula (40):

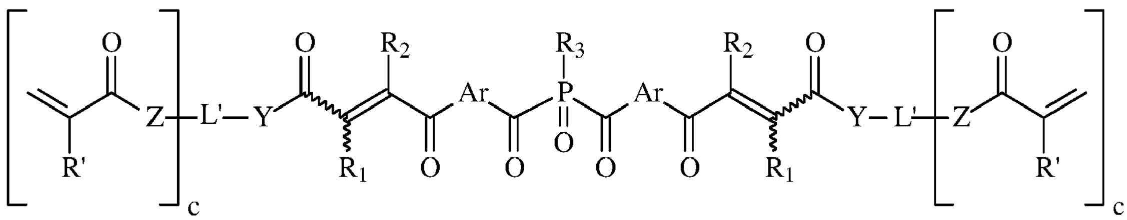

(35)

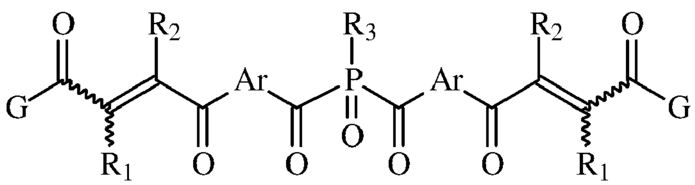

(42)

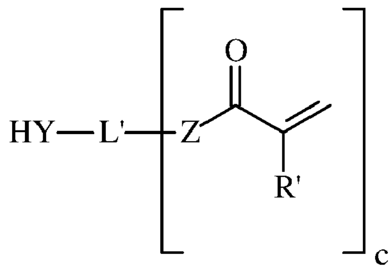

(43)

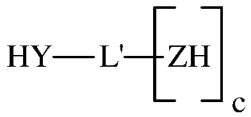 (44) 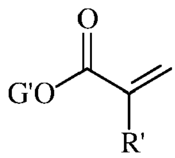 (40) 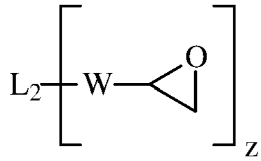 (41)

wherein

- Ar, $R_1$, $R_2$, $R_3$, L', $L_2$, W, Y, Z, R', c and z are as defined above;
- G and G' are independently OH, a halogen atom or -O-C(=O)-J;
- J is alkyl or aryl, in particular tert-butyl.

The reaction of the at least one precursor of formula (42) with at least one product of formula (44) or (41) and at least one product of formula (40) may be carried out simultaneously or in successive steps (i.e. in a first step the at least one precursor of formula (42) reacts with at least one product of formula (44) or (41) and in a second step at least one product of formula (40) is added to the resulting product).

In one embodiment, the precursor of formula (35) may be prepared by a process comprising reacting at least one precursor of formula (42) with at least one compound of formula (43a)

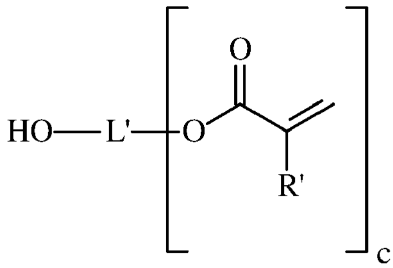 (43a)

wherein L', R' and c are as defined above.

Preferably, the compound of formula (43a) is a partially (meth)acrylated polyol and the polyol is as listed above for $P_{OH}$.

In another embodiment, the precursor of formula (35) may be prepared by a process comprising reacting at least one precursor of formula (42) with at least one compound of formula (43b):

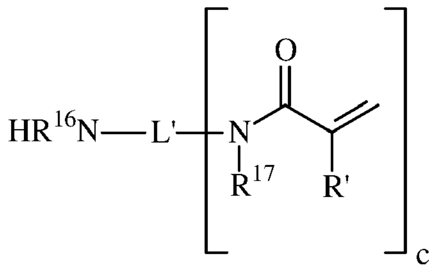 (43b)

wherein L, R', $R^{16}$, $R^{17}$, a and b are as defined.

Preferably, the compound of formula (43b) is a partially (meth)acrylated polyamine and the polyol is as listed above for $P_{NH}$.

In another embodiment, the precursor of formula (35) may be prepared by a process comprising reacting at least one precursor of formula (42) with at least one compound of formula (41) and at least one compound of formula (40):

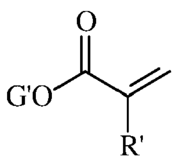 (40) 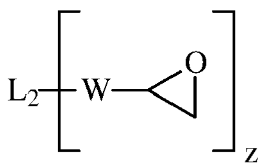 (41)

wherein G', $L_2$, R', W and z are as defined above.

Preferably, the compound of formula (41) is a polyepoxide as defined above for PEPOX.

The invention also relates to a precursor of formula (37) or (42):

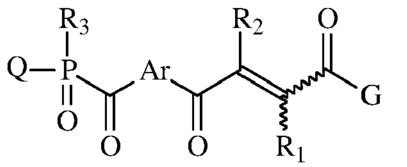

(37)

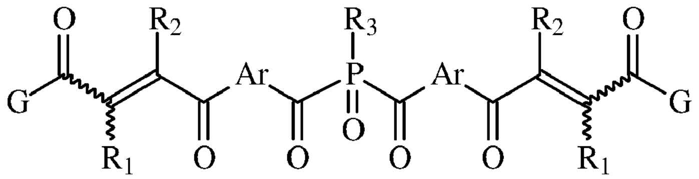

(42)

wherein:

- Ar, $R_1$, $R_2$, $R_3$, Q are as defined above;
- G is OH, a halogen atom or -O-C(=O)-J;
- J is alkyl or aryl, in particular tert-butyl.

Examples of suitable precursors of formula (37) and (42) are listed below:

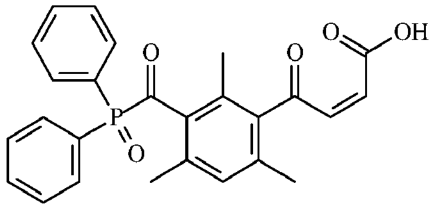

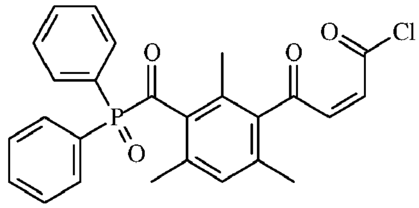

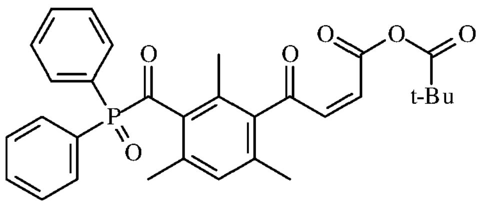

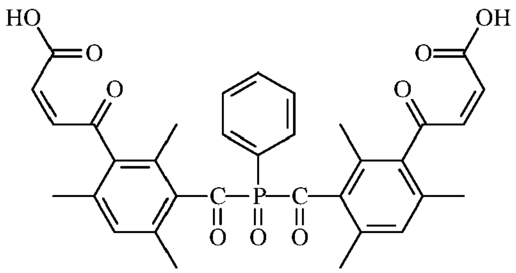

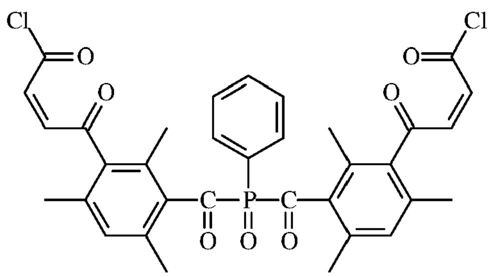

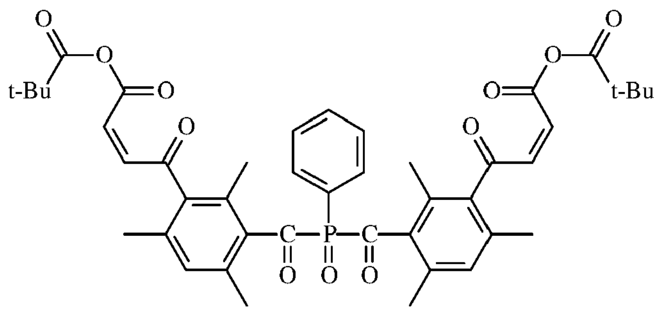

The precursors of formula (37) and (42) may be prepared by a process as described in PCT application n° PCT/EP2023/077292 filed on October 2, 2023.

*Process n°2 and related precursors*

The photoinitiator of formula (1) as described above may be prepared by a process comprising:

- reacting at least one precursor of formula (45) with at least one compound of formula (38); or
- reacting at least one precursor of formula (45) with at least one compound of formula (39) and at least one compound of formula (40); or
- reacting at least one precursor of formula (45) with at least one compound of formula (41) and at least one compound of formula (40);

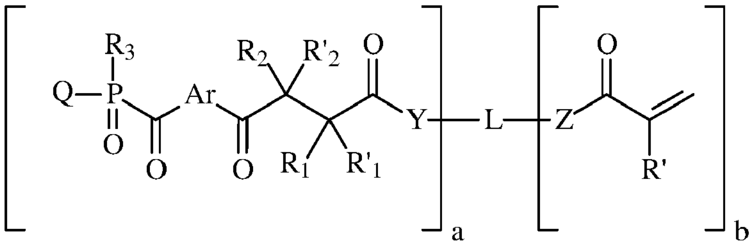
(1)

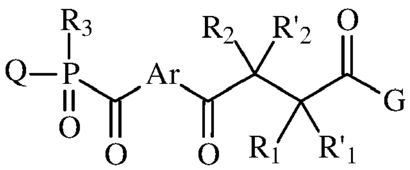
(45)

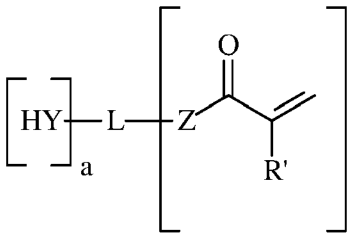
(38)

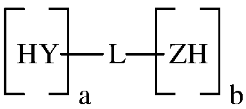
(39)

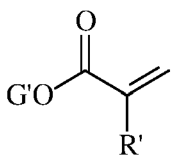
(40)

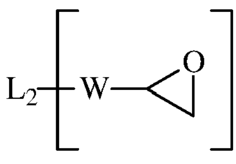
(41)

wherein:

- Ar, $R_1$, $R_2$, $R'_1$, $R'_2$, $R_3$, Q, L, $L_2$, W, Y, Z, R', a, b and z are as defined above;
- G and G' are independently OH, a halogen atom or -O-C(=O)-J;
- J is alkyl or aryl, in particular tert-butyl.

The above reaction may be carried out as defined above for the preparation process of the precursor of formula (34).

The reaction of the at least one precursor of formula (45) with at least one product of formula (39) or (41) and at least one product of formula (40) may be carried out simultaneously or in successive steps (i.e. in a first step the at least one precursor of formula (45) reacts with at least one product of formula (39) or (41) and in a second step at least one product of formula (40) is added to the resulting product).

In one embodiment, the photoinitiator of formula (1) may be prepared by a process comprising reacting at least one precursor of formula (45) with at least one compound of formula (38a):

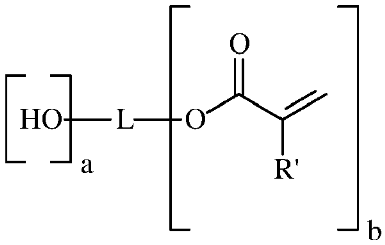

(38a)

wherein L, R’, a and b are as defined above.

Preferably, the compound of formula (38a) is a partially (meth)acrylated polyol and the polyol is as listed above for $P_{OH}$.

Alternatively, the photoinitiator of formula (1) may be prepared by a process comprising reacting at least one precursor of formula (45) with at least one compound of formula (38b):

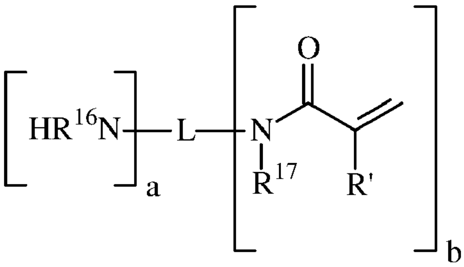

(38b)

wherein L, R’, $R^{14}$, $R^{15}$, a and b are as defined above. Preferably the compound of formula (38b) is a polyamine as listed above for $P_{NH}$.

Alternatively, the photoinitiator of formula (1) may be prepared by a process comprising reacting at least one precursor of formula (45) with at least one compound of formula (41) and at least one compound of formula (40):

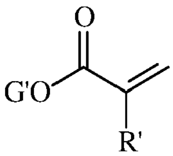

(40)

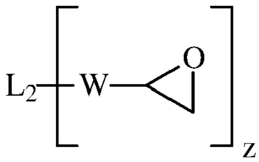

(41)

wherein G’, $L_2$, R’, W and z are as defined above.

Preferably, the compound of formula (41) is a polyepoxide as listed above for $P_{EPOX}$.

The photoinitiator of formula (2) as described above may be prepared by a process comprising:

- reacting at least one precursor of formula (46) with a compound of formula (43); or
- reacting at least one precursor of formula (46) with a compound of formula (44) and a compound of formula (40); or
- reacting at least one precursor of formula (46) with a compound of formula (41) and a compound of formula (40):

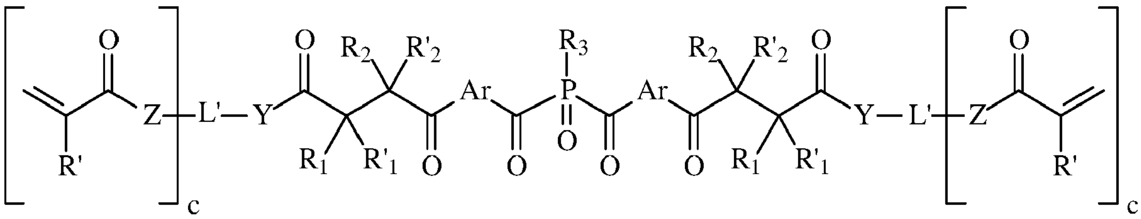

(2)

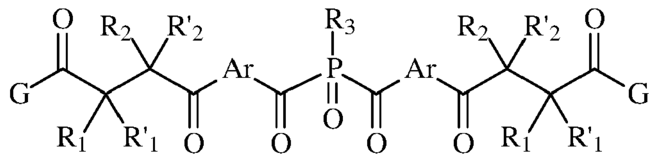

(46)

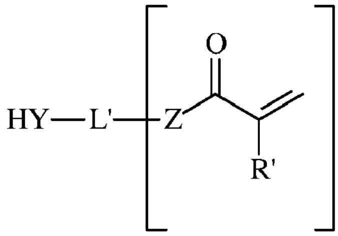

(43)

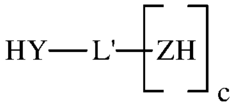

(44)

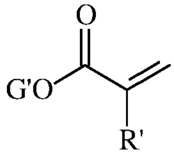

(40)

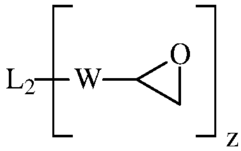

(41)

wherein

- Ar, $R_1$, $R_2$, $R_3$, $R'_1$, $R'_2$, L', $L_2$, W, Y, Z, R', c and z are as defined above;
- G and G' are independently OH, a halogen atom or -O-C(=O)-J;
- J is alkyl or aryl, in particular tert-butyl.

The reaction of the at least one precursor of formula (46) with at least one product of formula (44) or (41) and at least one product of formula (40) may be carried out simultaneously or in successive steps (i.e. in a first step the at least one precursor of formula (46) reacts with at least one product of formula (44) or (41) and in a second step at least one product of formula (40) is added to the resulting product).

In one embodiment, the photoinitiator of formula (2) may be prepared by a process comprising reacting at least one precursor of formula (46) with at least one compound of formula (43a)

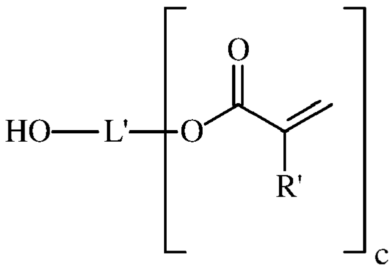

(43a)

wherein L', R' and c are as defined above.

Preferably, the compound of formula (43a) is a partially (meth)acrylated polyol and the polyol is as listed above for $P_{OH}$.

In another embodiment, the photoinitiator of formula (2) may be prepared by a process comprising reacting at least one precursor of formula (46) with at least one compound of formula (43b):

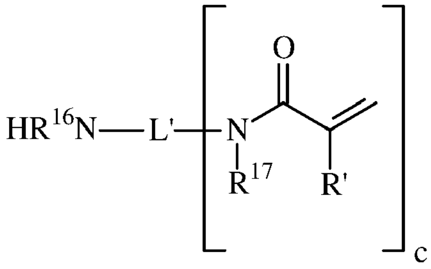

(43b)

wherein L, R', $R^{16}$, $R^{17}$, a and b are as defined above.

Preferably, the compound of formula (43b) is a partially (meth)acrylated polyamine and the polyol is as listed above for $P_{NH}$.

In another embodiment, the photoinitiator of formula (2) may be prepared by a process comprising reacting at least one precursor of formula (46) with at least one compound of formula (41) and at least one compound of formula (40):

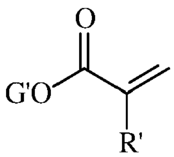

(40)

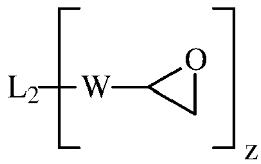

(41)

wherein G', $L_2$, R', W and z are as defined above.

Preferably, the compound of formula (41) is a polyepoxide as defined above for PEPOX.

The invention also relates to a precursor of formula (45) or (46):

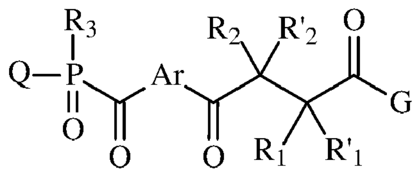

(45)

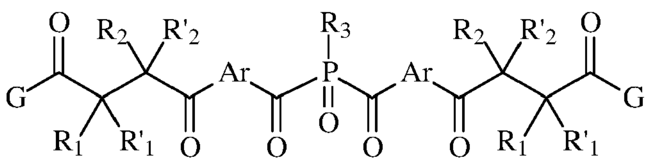

(46)

wherein:

- Ar, $R_1$, $R_2$, $R_3$, $R'_1$, $R'_2$ and Q are as defined above;
- G is OH, a halogen atom or -O-C(=O)-J;
- J is alkyl or aryl, in particular tert-butyl.

Non-limiting examples of precursors of formula (45) or (46) are listed below:

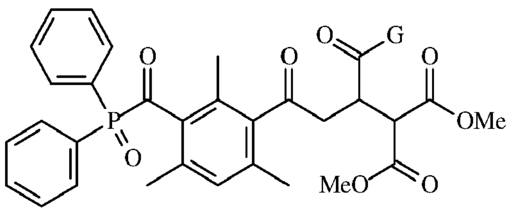

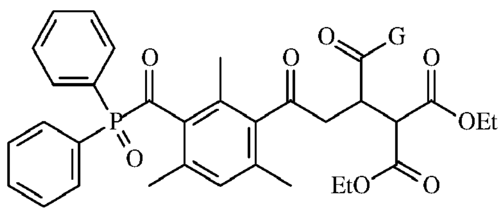

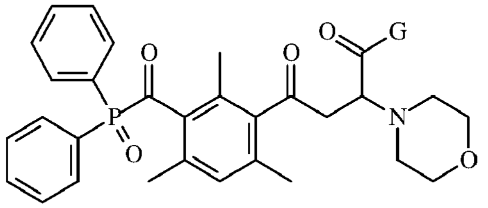

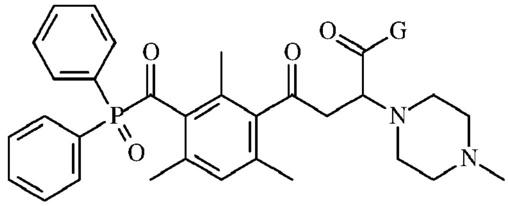

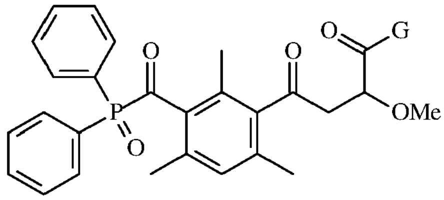

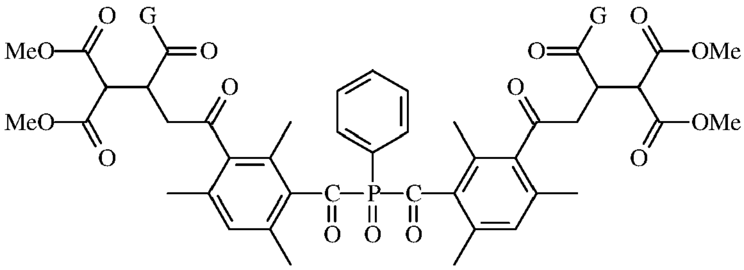

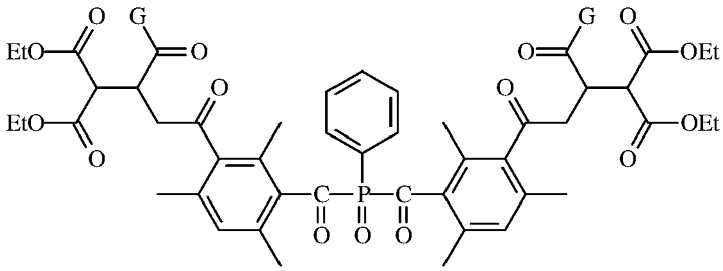

wherein G is OH, a halogen atom or -O-C(=O)-J.

The precursors of formula (45) and (46) may be prepared by a process as described in PCT application n° PCT/EP2023/077292 filed on October 2, 2023.

*Process n°3 and related precursors*

The photoinitiator of formula (6) as described above may be prepared by a process comprising reacting at least one precursor of formula (37) with at least one product of formula (47) and at least one product of formula (40):

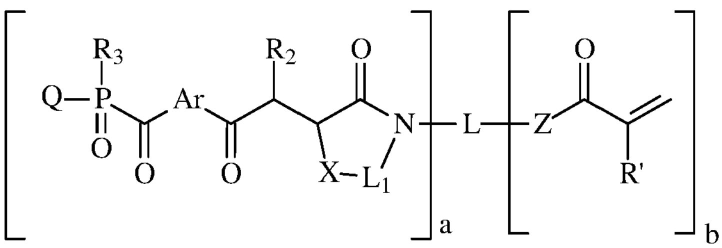
(6)

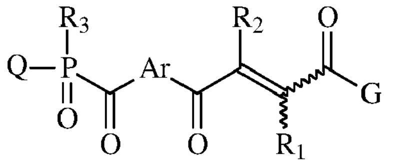

(37)

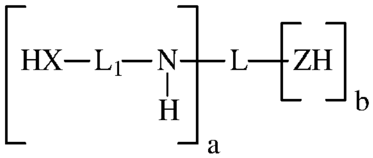

(47)

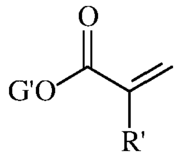

(40)

wherein:

- Ar, $R_1$, $R_2$, $R_3$, Q, L, Z, R', a and b are as defined in any one of claims 1 to 7 and 9 to 23;
- X and $L_1$ are as defined in claim 8,
- G and G' are independently OH, a halogen atom or -O-C(=O)-J;
- J is alkyl or aryl, in particular tert-butyl.

Preferably the product of formula (47) is a compound bearing at least one amino group and at least two functional groups independently selected from hydroxyl, amino and thiol.

More preferably the product of formula (47) is an aminoalcohol (for example diethanolamine or diisopropanolamine).

The photoinitiator of formula (7) as described above may be prepared by a process comprising reacting at least one precursor of formula (38) with at least one product of formula (48) and at least one product of formula (40):

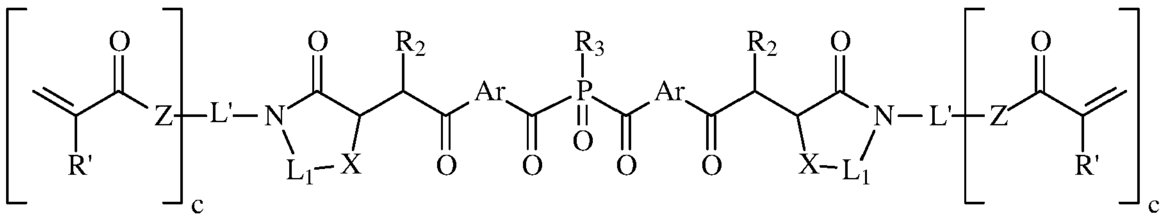

(7)

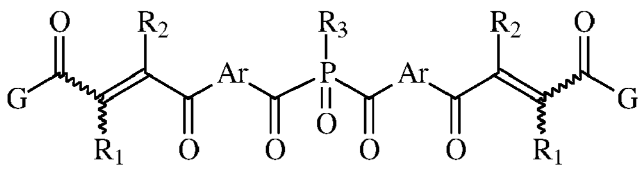

(38)

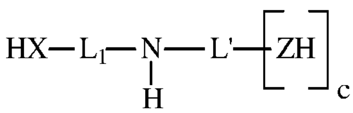

(48)

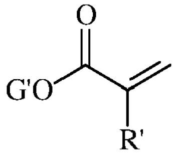

(40)

wherein:

- Ar, $R_1$, $R_2$, $R_3$, L', Z, R' and c are as defined above;
- X and $L_1$ are as defined in claim 8,
- G and G' are independently OH, a halogen atom or -O-C(=O)-J;
- J is alkyl or aryl, in particular tert-butyl;

Preferably, the product of formula (48) is a compound bearing an amino group and at least two functional groups independently selected from hydroxyl, amino and thiol,

More preferably, the product of formula (48) is an aminoalcohol (for example diethanolamine or diisopropanolamine).

The precursors of formula (37) and (38) may be prepared according to the process described in Process n°1 and related precursors.

The reaction of the at least one precursor of formula (37) or (38) with at least one product of formula (47) or (48) and at least one product of formula (40) may be carried out simultaneously or in successive steps (i.e. in a first step the at least one precursor of formula (37) or (38) reacts with at least one product of formula (47) or (48) and in a second step at least one product of formula (40) is added to the resulting product).

Said reaction may be carried out in the presence of one or more compounds selected from:

- a base, in particular a base chosen from sodium or potassium hydroxide, sodium or potassium carbonate or an amine base, such as a tertiary amine base, for example triethylamine, *N*,*N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as toluene, xylene, 2-butanone, methanol, *N*-methylpyrrolidinone, *N*,*N*-dimethylformamide, *N*,*N*-dimethylacetamide, dimethyl sulfoxide, sulfolane and mixtures thereof.

Said reaction may be carried out at a temperature from 10 to 100°C and preferably from 20 to 50°C. Said reaction may be carried out for a duration from 30 min to 24 hours and preferably from 3 to 20 hours. Once the reaction is finished, the reaction medium may be washed one or more times with an aqueous solution, for example an aqueous solution of hydrochloric acid, an aqueous solution of sodium bicarbonate and/or an aqueous solution of sodium chloride. The solvent(s) may be evaporated from the resulting organic phase.

## Photoinitiator composition

The present disclosure also relates to a photoinitiator composition comprising:

- a mixture of at least two photoinitiators of formula (1) according to the invention;
- a mixture of at least two photoinitiators of formula (2) according to the invention;
- a mixture of at least one photoinitiator of formula (1) according to the invention and at least one precursor of formula (34) according to the invention; or
- a mixture of at least one photoinitiator of formula (2) according to the invention and at least one precursor of formula (35) according to the invention.

Advantageously, a photoinitiator composition comprising a mixture of such photoinitiators may be liquid at 20°C.

In addition, the present disclosure relates to a photoinitiator composition comprising a photoinitiator of formula (1) or (2) according to the invention and a photoinitiator other than a photoinitiator of formula (1) or (2).

The photoinitiator other than a photoinitiator of formula (1) or (2) may be a photoinitiator having Norrish type I activity and/or Norrish type II activity, more particularly a radical photoinitiator having Norrish type I activity.

Non-limiting types of other photoinitiators suitable for use in the photoinitiator composition of the invention include, for example, benzoins, benzoin ethers, acetophenones, α-hydroxy acetophenones, benzil, benzil ketals, anthraquinones, phosphine oxides, acylphosphine oxides, α-hydroxyketones, phenylglyoxylates, α-aminoketones, benzophenones, thioxanthones, xanthones, acridine derivatives, phenazine derivatives, quinoxaline derivatives, triazine compounds, benzoyl formates, aromatic oximes, metallocenes, acylsilyl or acylgermanyl compounds, camphorquinones, polymeric derivatives thereof, and mixtures thereof.

Examples of suitable other photoinitiators include, but are not limited to, 2-methylanthraquinone, 2-ethylanthraquinone, 2-chloroanthraquinone, 2-benzyanthraquinone, 2-t-butylanthraquinone, 1,2-benzo-9,10-anthraquinone, benzoin ethers, benzoin, benzoin methyl ether, benzoin ethyl ether, benzoin isopropyl ether, alpha-methylbenzoin, alpha-phenylbenzoin, Michler's ketone, acetophenones such as 2,2-dialkoxybenzophenones and 1-hydroxyphenyl ketones, benzophenone, 4,4'-bis-(diethylamino) benzophenone, acetophenone, 2,2-diethyloxyacetophenone, , 2-isopropylthioxanthone, thioxanthone, diethyl thioxanthone, 1,5-acenaphthylene, benzil, α-hydroxyketone, 2,4,6-trimethylbenzoyldiphenyl phosphine oxide, , 2,2-dimethoxy-1,2-diphenylethanone, 1-hydroxycyclohexyl phenyl ketone, 2-methyl-1-[4-(methylthio) phenyl]-2-morpholinopropanone, 2-hydroxy-2-methyl-1-phenyl-propanone, oligomeric α-hydroxy ketone, benzoyl phosphine oxides, phenylbis(2,4,6-trimethylbenzoyl)phosphine oxide, ethyl(2,4,6-trimethylbenzoyl)phenyl phosphinate, anisoin, anthraquinone, anthraquinone-2-sulfonic acid sodium salt monohydrate, (benzene) tricarbonylchromium, , benzoin isobutyl ether, benzophenone/1-hydroxycyclohexyl phenyl ketone 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone, 4,4'-bis(dimethylamino)benzophenone, camphorquinone, 2-chlorothioxanthen-9-one, dibenzosuberenone, 4,4'-dihydroxybenzophenone, , 4-(dimethylamino)benzophenone, 4,4'-dimethylbenzil, 2,5-dimethylbenzophenone, 3,4-dimethylbenzophenone, diphenyl(2,4,6-trimethylbenzoyl)phosphine oxide /2-hydroxy-2-methylpropiophenone 50/50 blend, 4'-ethoxyacetophenone, 2,4,6-trimethylbenzoyldiphenylphosphine oxide, , 3'-hydroxyacetophenone, 4'-hydroxyacetophenone, 3-hydroxybenzophenone, 4-hydroxybenzophenone, 2-methylbenzophenone, 3-methylbenzophenone, methybenzoylformate, phenanthrenequinone, 4'-phenoxyacetophenone, (cumene) cyclopentadienyl iron(ii) hexafluorophosphate, 9,10-diethoxy and 9,10-dibutoxyanthracene, 2-ethyl-9,10-dimethoxyanthracene, and combinations thereof.

In particular, the other photoinitiator may be selected from a benzophenone such as SpeedCure® BP (benzophenone), a polymeric benzophenone, SpeedCure® EMK (4,4'-bis(diethylamino)benzophenone) or SpeedCure® BMS (4-benzoyl-4'-methyldiphenyl sulphide); a thioxanthone such as SpeedCure® 7010 (polymeric thioxanthone), SpeedCure® ITX (isopropyl thioxanthone), SpeedCure® DETX (2,4-diethylthioxanthone) or SpeedCure® CPTX (1-chloro-4-propoxythioxanthone); an $\alpha$-hydroxy acetophenone such as SpeedCure® 73 (2-hydroxy-2-methyl-1-phenylpropanone); an acylphosphine oxide such as SpeedCure® BPO (phenyl bis(2,4,6-trimethylbenzoyl)-phosphine oxide), SpeedCure® TPO (2,4,6-trimethylbenzoyldiphenylphosphine oxide) or SpeedCure® TPO-L (ethyl (2,4,6-trimethylbenzoyl)phenyl phosphinate); a phenylglyoxylate such as SpeedCure® MBF (methylbenzoylformate); and mixtures thereof.

More particularly, the other photoinitiator may be a phenylglyoxylate, in particular SpeedCure® MBF (methylbenzoylformate). Alternatively, the other photoinitiator may be an $\alpha$-hydroxy acetophenone, in particular SpeedCure® 73 (2-hydroxy-2-methyl-1-phenylpropanone). Alternatively, the other photoinitiator may be a benzophenone, in particular a polymeric benzophenone.

## Photopolymerization process

The photoinitiator of formula (1) or (2) as defined above or the photoinitiator composition as defined above may be used in a photopolymerization process, i.e. a process for photopolymerizing (e.g. curing) one or more ethylenically unsaturated compounds.

The process for photopolymerizing one or more ethylenically unsaturated compounds comprises contacting one or more ethylenically unsaturated compounds with a photoinitiator of formula (1) or (2) according to the invention or a photoinitiator composition according to the invention, and irradiating the mixture, in particular with UV, near-UV, visible, infrared and/or near-infrared radiation.

The ethylenically unsaturated compound(s) may be as defined below.

## Curable composition

The curable (or polymerizable) composition of the invention comprises a photoinitiator of formula (1) or (2) according to the invention or a photoinitiator composition according to the invention, referred to as component a). The curable composition of the invention further comprises an ethylenically unsaturated compound (or a mixture of ethylenically unsaturated compounds), referred to as component b).

The curable composition of the invention may comprise:

- from 0.05 to 30 %, preferably from 0.1 to 20 %, more preferably from 0.2 to 15 %, more preferably 0.5 to 10 %, and even more preferably from 1 to 5 % of component a);
- from 70 to 99.95 %, preferably from 80 to 99.9 %, more preferably from 85 to 99.8 %, more preferably from 90 to 99.5 % and even more preferably from 95 to 99 % of component b);

the % being % by weight based on the total weight of components a) and b).

The curable composition of the invention may further comprise one or more compounds selected from:

- a cationically-polymerizable compound;
- a cationic photoinitiator;
- a polyol and/or a polythiol;
- an amine synergist;
- an additive; and
- a solvent.

*Ethylenically unsaturated compounds*

As used herein, the term "ethylenically unsaturated compound" means a compound that comprises a polymerizable carbon-carbon double bond. A polymerizable carbon-carbon double bond is a carbon-carbon double bond that can react with another carbon-carbon double bond in a polymerization reaction. A polymerizable carbon-carbon double bond is generally comprised in a group selected from acrylate (including cyanoacrylate), methacrylate, acrylamide, methacrylamide, styrene, maleate, fumarate, itaconate, allyl, propenyl, vinyl and combinations thereof, preferably selected from acrylate, methacrylate, allyl and vinyl, more preferably selected from acrylate and methacrylate. The carbon-carbon double bonds of a phenyl ring are not considered as polymerizable carbon-carbon double bonds.

According to some preferred embodiments, the ethylenically unsaturated compound may be selected from a (meth)acrylate-functionalized monomer, a (meth)acrylate-functionalized oligomer, an amine-modified acrylate and mixtures thereof. In particular, the ethylenically unsaturated compound comprises a (meth)acrylate functionalized monomer and optionally an amine-modified acrylate.

As used herein, the term "(meth)acrylate-functionalized monomer" means a monomer comprising a (meth)acrylate group, in particular an acrylate group. The term "(meth)acrylate-functionalized oligomer" means an oligomer comprising a (meth)acrylate group, in particular an acrylate group. The term "(meth)acrylate group" encompasses acrylate groups ($-O-CO-CH=CH_2$) and methacrylate groups ($-O-CO-C(CH_3)=CH_2$).

The total amount of ethylenically unsaturated compound (including (meth)acrylate functionalized monomer, (meth)acrylate functionalized oligomer and amine-modified acrylate) in the curable composition may be from 40 to 99.5%, in particular 50 to 95%, more particularly 60 to 90%, by weight based on the weight of the composition. In particular, the curable composition may comprise 40 to 80%, or 40 to 75% or 40 to 70% or 40 to 65% or 40 to 60% by weight of ethylenically unsaturated compound based on the weight of the composition. Alternatively, the curable composition may comprise 60 to 99.5%, or 65 to 99.5% or 70 to 99.5% or 75 to 99.5% or 80 to 99.5% by weight of ethylenically unsaturated compound based on the weight of the composition.

According to some embodiments, the ethylenically unsaturated compound comprises a (meth)acrylate-functionalized monomer. The ethylenically unsaturated compound may comprise a mixture of (meth)acrylate-functionalized monomers.

The (meth)acrylate-functionalized monomer may have a molecular weight of less than 600 g/mol, in particular from 100 to 550 g/mol, more particularly 200 to 500 g/mol.

The (meth)acrylate-functionalized monomer may have 1 to 6 (meth)acrylate groups, in particular 1 to 3 (meth) acrylate groups.

The (meth)acrylate-functionalized monomer may comprise a mixture of (meth)acrylate-functionalized monomers having different functionalities. For example the (meth)acrylate-functionalized monomer may comprise a mixture of a (meth)acrylate-functionalized monomer containing a single acrylate or methacrylate group per molecule (referred to herein as "mono(meth)acrylate-functionalized compounds") and a (meth)acrylate-functionalized monomer containing 2 or more, preferably 2 or 3, acrylate and/or methacrylate groups per molecule.

In one embodiment, the (meth)acrylate functionalized monomer comprises a mono(meth)acrylate-functionalized monomer. The mono(meth)acrylate-functionalized monomer may advantageously function as a reactive diluent and reduce the viscosity of the composition.

Examples of suitable mono(meth)acrylate-functionalized monomers include, but are not limited to, mono-(meth) acrylate esters of aliphatic alcohols (wherein the aliphatic alcohol may be straight chain, branched or alicyclic and may be a mono-alcohol, a di-alcohol or a polyalcohol, provided only one hydroxyl group is esterified with (meth)acrylic acid); mono-(meth)acrylate esters of aromatic alcohols (such as phenols, including alkylated phenols); mono-(meth)acrylate esters of alkylaryl alcohols (such as benzyl alcohol); mono-(meth)acrylate esters of oligomeric and polymeric glycols such as diethylene glycol, triethylene glycol, dipropylene glycol, tripropylene glycol, polyethylene glycol, and polypropylene glycol); mono-(meth)acrylate esters of monoalkyl ethers of glycols and oligoglycols; mono-(meth)acrylate esters of alkoxylated (e.g., ethoxylated and/or propoxylated) aliphatic alcohols (wherein the aliphatic alcohol may be straight chain, branched or alicyclic and may be a mono-alcohol, a di-alcohol or a polyalcohol, provided only one hydroxyl group of the alkoxylated aliphatic alcohol is esterified with (meth)acrylic acid); mono-(meth)acrylate esters of alkoxylated (e.g., ethoxylated and/or propoxylated) aromatic alcohols (such as alkoxylated phenols); caprolactone mono(meth)acrylates; and the like.

The following compounds are specific examples of mono(meth)acrylate-functionalized monomers suitable for use in component a): methyl (meth)acrylate; ethyl (meth)acrylate; n-propyl (meth)acrylate; n-butyl (meth)acrylate; isobutyl (meth)acrylate; n-hexyl (meth)acrylate; 2-ethylhexyl (meth)acrylate; n-octyl (meth)acrylate; isooctyl (meth)acrylate; n-decyl (meth)acrylate; n-dodecyl (meth)acrylate; tridecyl (meth)acrylate; tetradecyl (meth)acrylate; hexadecyl (meth) acrylate; 2-hydroxyethyl (meth)acrylate; 2- and 3-hydroxypropyl (meth)acrylate; 2-methoxyethyl (meth)acrylate; 2-ethoxyethyl (meth)acrylate; 2- and 3-ethoxypropyl (meth)acrylate; tetrahydrofurfuryl (meth)acrylate; alkoxylated tetrahydrofurfuryl (meth)acrylate; 2-(2-ethoxyethoxy)ethyl (meth)acrylate; cyclohexyl (meth)acrylate; glycidyl (meth)acrylate;

isodecyl (meth)acrylate; lauryl (meth)acrylate; 2-phenoxyethyl (meth)acrylate; alkoxylated phenol (meth)acrylates; alkoxylated nonylphenol (meth)acrylates; cyclic trimethylolpropane formal (meth)acrylate; isobornyl (meth)acrylate; tricyclodecanemethanol (meth)acrylate; tert-butylcyclohexanol (meth)acrylate; trimethylcyclohexanol (meth)acrylate; diethylene glycol monomethyl ether (meth)acrylate; diethylene glycol monoethyl ether (meth)acrylate; diethylene glycol monobutyl ether (meth)acrylate; triethylene glycol monoethyl ether (meth)acrylate; ethoxylated lauryl (meth)acrylate; methoxy polyethylene glycol (meth)acrylates; hydroxyl ethyl-butyl urethane (meth)acrylates; 3-(2-hydroxyalkyl)oxazolidinone (meth)acrylates; and combinations thereof.

In one embodiment, the (meth)acrylate functionalized monomer may comprise a (meth)acrylate-functionalized monomer containing two or more (meth)acrylate groups per molecule.

Examples of suitable (meth)acrylate-functionalized monomers containing two or more (meth)acrylate groups per molecule include acrylate and methacrylate esters of polyols. Examples of suitable polyols are as listed above for $P_{OH}$. Such polyols may be fully or partially esterified (with (meth)acrylic acid, (meth)acrylic anhydride, (meth)acryloyl chloride or the like), provided they contain at least two (meth)acrylate functional groups per molecule.

Exemplary (meth)acrylate-functionalized monomers containing two or more (meth)acryloyloxy groups per molecule may include bisphenol A di(meth)acrylate; hydrogenated bisphenol A di(meth)acrylate; ethylene glycol di(meth)acrylate; diethylene glycol di(meth)acrylate; triethylene glycol di(meth)acrylate; tetraethylene glycol di(meth) acrylate; polyethylene glycol di(meth)acrylate; propylene glycol di(meth)acrylate; dipropylene glycol di(meth)acrylate; tripropylene glycol di(meth)acrylate; tetrapropylene glycol di(meth)acrylate; polypropylene glycol di(meth)acrylate; polytetramethylene glycol di(meth)acrylate; 1,2-butanediol di(meth)acrylate; 2,3-butanediol di(meth)acrylate; 1,3-butanediol di(meth)acrylate; 1,4-butanediol di(meth)acrylate; 1,5-pentanediol di(meth)acrylate; 1,6-hexanediol di(meth)acrylate; 1,8-octanediol di(meth)acrylate; 1,9-nonanediol di(meth)acrylate; 1,10-nonanediol di(meth)acrylate; 1,12-dodecanediol di(meth)acrylate; neopentyl glycol di(meth)acrylate; 2-methyl-2,4-pentanediol di(meth)acrylate; polybutadiene di(meth)acrylate; cyclohexane-1,4-dimethanol di(meth)acrylate; tricyclodecane dimethanol di(meth)acrylate; metallic di(meth)acrylates; modified metallic di(meth)acrylates; glyceryl di(meth)acrylate; glyceryl tri(meth)acrylate; trimethylolethane tri(meth)acrylate; trimethylolethane di(meth)acrylate; trimethylolpropane tri(meth)acrylate; trimethylolpropane di(meth)acrylate; pentaerythritol di(meth)acrylate; pentaerythritol tri(meth)acrylate; pentaerythritol tetra(meth)acrylate, di(trimethylolpropane) diacrylate; di(trimethylolpropane) triacrylate; di(trimethylolpropane) tetraacrylate, sorbitol penta(meth)acrylate; di(pentaerythritol) tetraacrylate; di(pentaerythritol) pentaacrylate; di(pentaerythritol) hexa(meth)acrylate; tris (2-hydroxyethyl) isocyanurate tri(meth)acrylate; as well as the alkoxylated (e.g., ethoxylated and/or propoxylated) derivatives thereof; and combinations thereof.

Component a) may comprise 0 to 99.5%, in particular 5 to 90%, more particularly 10 to 80%, even more particularly 15 to 75%, more particularly still 20 to 70% by weight of (meth)acrylate-functionalized monomer based on the total weight of the component a). In particular, component a) may comprise 5 to 50% or 10 to 50% or 15 to 50% or 20 to 50% or 25 to 50% or 30 to 50%, by weight of (meth)acrylate-functionalized monomer based on the total weight of component a). Alternatively, component a) may comprise 50 to 99.5% or 55 to 99.5% or 60 to 99.5% or 65 to 99.5% or 70 to 99.5%, by weight of (meth)acrylate-functionalized monomer based on the total weight of component a).

In one embodiment, the ethylenically unsaturated compound comprises a (meth)acrylate-functionalized oligomer. The ethylenically unsaturated compound may comprise a mixture of (meth)acrylate-functionalized oligomers.

The (meth)acrylate-functionalized oligomer may be selected in order to enhance the flexibility, strength and/or modulus, among other attributes, of a cured polymer prepared using Composition A.

The (meth)acrylate functionalized oligomer may have 1 to 18 (meth)acrylate groups, in particular 2 to 6 (meth) acrylate groups, more particularly 2 to 6 acrylate groups.

The (meth)acrylate functionalized oligomer may have a number average molecular weight equal or more than 600 g/mol, in particular 800 to 15,000 g/mol, more particularly 1,000 to 5,000 g/mol.

In particular, the (meth)acrylate-functionalized oligomers may be selected from the group consisting of (meth) acrylate-functionalized urethane oligomers (sometimes also referred to as "urethane (meth)acrylate oligomers," "polyurethane (meth)acrylate oligomers" or "carbamate (meth)acrylate oligomers"), (meth)acrylate-functionalized epoxy oligomers (sometimes also referred to as "epoxy (meth)acrylate oligomers"), (meth)acrylate-functionalized polyether oligomers (sometimes also referred to as "polyether (meth)acrylate oligomers"), (meth)acrylate-functionalized polydiene oligomers (sometimes also referred to as "polydiene (meth)acrylate oligomers"), (meth)acrylate-functionalized polycarbonate oligomers (sometimes also referred to as "polycarbonate (meth)acrylate oligomers"), and (meth)acrylate-functionalized polyester oligomers (sometimes also referred to as "polyester (meth)acrylate oligomers") and mixtures thereof.

Preferably, the (meth)acrylate-functionalized oligomer comprises a (meth)acrylate-functionalized urethane oligomer, more preferably an acrylate-functionalized urethane oligomer.

Advantageously, the (meth)acrylate-functionalized oligomer comprises a (meth)acrylate-functionalized urethane oligomer having two (meth)acrylate groups, more preferably an acrylate-functionalized urethane oligomer having two acrylate groups.

Exemplary polyester (meth)acrylate oligomers include the reaction products of acrylic or methacrylic acid or mixtures or synthetic equivalents thereof with hydroxyl group-terminated polyester polyols. The reaction process may be conducted such that all or essentially all of the hydroxyl groups of the polyester polyol have been (meth)acrylated, particularly in cases where the polyester polyol is difunctional. The polyester polyols can be made by polycondensation reactions of polyols (in particular, diols) and polycarboxylic acid functional compounds (in particular, dicarboxylic acids and anhydrides). The polyol and polycarboxylic acid functional compounds can each have linear, branched, cycloaliphatic or aromatic structures and can be used individually or as mixtures.

Examples of suitable epoxy (meth)acrylates include the reaction products of acrylic or methacrylic acid or mixtures thereof with an epoxy resin (polyglycidyl ether or ester). The epoxy resin may, in particular, by selected from bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)cyclohexane-1,4-dioxane, bis(3,4-epoxycyclohexylmethyl)adipate, bis(3,4-epoxy-6-methylcyclohexylmethyl)adipate, 3,4-epoxy-6-methylcyclohexyl-3',4'-epoxy-6'-methylcyclohexanecarboxylate, dicyclopentadiene diepoxide, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of a polyether polyol obtained by the addition of one or more alkylene oxides to an aliphatic polyhydric alcohol such as ethylene glycol, propylene glycol and glycerol, diglycidyl esters of aliphatic C6-C22 dibasic acids, glycidyl esters of C30-36 dimers of fatty acids, an epoxidized vegetable oil (such as epoxidized soybean oil and epoxidized linseed oil), epoxidized polybutadiene, and the like.

Suitable polyether (meth)acrylate oligomers include, but are not limited to, the condensation reaction products of acrylic or methacrylic acid or synthetic equivalents or mixtures thereof with polyetherols which are polyether polyols (such as polyethylene glycol, polypropylene glycol or polytetramethylene glycol). Suitable polyetherols can be linear or branched substances containing ether bonds and terminal hydroxyl groups. Polyetherols can be prepared by ring opening polymerization of cyclic ethers such as tetrahydrofuran or alkylene oxides (e.g., ethylene oxide and/or propylene oxide) with a starter molecule. Suitable starter molecules include water, polyhydroxyl functional materials, polyester polyols and amines.

Polyurethane (meth)acrylate oligomers (sometimes also referred to as "urethane (meth)acrylate oligomers") suitable for use in Composition A include urethanes based on aliphatic, cycloaliphatic and/or aromatic polyester polyols and polyether polyols and aliphatic, cycloaliphatic and/or aromatic polyester diisocyanates and polyether diisocyanates capped with (meth)acrylate end-groups. Suitable polyurethane (meth)acrylate oligomers include, for example, aliphatic polyester-based urethane di- and tetra-acrylate oligomers, aliphatic polyether-based urethane di- and tetra-acrylate oligomers, as well as aliphatic polyester/polyether-based urethane di- and tetra-acrylate oligomers.

The polyurethane (meth)acrylate oligomers may be prepared by reacting aliphatic, cycloaliphatic and/or aromatic polyisocyanates (e.g., diisocyanate, triisocyanate) with OH group terminated polyester polyols, polyether polyols, polycarbonate polyols, polycaprolactone polyols, polyorganosiloxane polyols (e.g., polydimethylsiloxane polyols), or polydiene polyols (e.g., polybutadiene polyols), or combinations thereof to form isocyanate-functionalized oligomers which are then reacted with hydroxyl-functionalized (meth)acrylates (such as 2-hydroxyethyl (meth)acrylate or 3-hydroxypropyl (meth)acrylate) to provide terminal (meth)acrylate groups. For example, the polyurethane (meth)acrylate oligomers may contain two, three, four or more (meth)acrylate functional groups per molecule. Other orders of addition may also be practiced to prepare the polyurethane (meth)acrylate, as is known in the art. For example, the hydroxyl-functionalized (meth)acrylate may be first reacted with a polyisocyanate to obtain an isocyanate-functionalized (meth)acrylate, which may then be reacted with an OH group terminated polyester polyol, polyether polyol, polycarbonate polyol, polycaprolactone polyol, polydimethylsiloxane polyol, polybutadiene polyol, or a combination thereof. In yet another embodiment, a polyisocyanate may be first reacted with a polyol, including any of the aforementioned types of polyols, to obtain an isocyanate-functionalized polyol, which is thereafter reacted with a hydroxyl-functionalized (meth)acrylate to yield a polyurethane (meth)acrylate. Alternatively, all the components may be combined and reacted at the same time.

Suitable acrylic (meth)acrylate oligomers (sometimes also referred to in the art as "acrylic oligomers") include oligomers which may be described as substances having an oligomeric acrylic backbone which is functionalized with one or (meth)acrylate groups (which may be at a terminus of the oligomer or pendant to the acrylic backbone). The acrylic backbone may be a homopolymer, random copolymer or block copolymer comprised of repeating units of acrylic monomers. The acrylic monomers may be any monomeric (meth)acrylate such as C1-C6 alkyl (meth)acrylates as well as functionalized (meth)acrylates such as (meth)acrylates bearing hydroxyl, carboxylic acid and/or epoxy groups. Acrylic (meth)acrylate oligomers may be prepared using any procedures known in the art, such as by oligomerizing monomers, at least a portion of which are functionalized with hydroxyl, carboxylic acid and/or epoxy groups (e.g., hydroxyalkyl(meth) acrylates, (meth)acrylic acid, glycidyl (meth)acrylate) to obtain a functionalized oligomer intermediate, which is then reacted with one or more (meth)acrylate-containing reactants to introduce the desired (meth)acrylate functional groups.

The curable composition of the invention may comprise 0 to 99.5 %, in particular 5 to 90 %, more particularly 10 to 80 %, even more particularly 15 to 75 %, more particularly still 20 to 70 % by weight of (meth)acrylate-functionalized oligomer based on the total weight of the curable composition. In particular, the curable composition of the invention may comprise 5 to 50 % or 10 to 50 % or 15 to 50 % or 20 to 50 % or 25 to 50 % or 30 to 50 %, by weight of (meth)acrylate-functionalized oligomer based on the total weight of the curable composition. Alternatively, the curable composition of the invention may comprise 50 to 99.5 % or 55 to 99.5 % or 60 to 99.5 % or 65 to 99.5 % or 70 to 99.5 %, by weight of (meth) acrylate-functionalized oligomer based on the total weight of the curable composition.

In one embodiment, the ethylenically unsaturated compound comprises an amine-modified acrylate. The ethylenically unsaturated compound may comprise a mixture of amine-modified acrylates.

An amine-modified acrylate is obtained by reacting an acrylate-functionalized compound with an amine-containing compound (aza-Michael addition). The amine-modified acrylate comprises at least one remaining acrylate group (i.e. an acrylate group that has not reacted with the amine-containing compound during the aza-Michael addition) and/or at least one (meth)acrylate group (which may not be reactive towards primary or secondary amines).

The acrylate-functionalized compound may be an acrylate-functionalized monomer and/or acrylate-functionalized oligomer as defined above.

The amine-containing compound comprises a primary or secondary amine group and optionally a tertiary amine group. The amine-containing compound may comprise more than one primary and/or secondary amine groups. The amine-containing compound may be selected from monoethanolamine (2-aminoethanol), 2-ethylhexylamine, octylamine, cyclohexylamine, sec-butylamine, isopropylamine, diethylamine, diethanolamine, dipropylamine, dibutylamine, 2-(methylamino)ethano-1,2-methoxyethylamine, bis(2-hydroxypropyl)amine, diisopropylamine, dipentylamine, dihexylamine, bis(2-ethylhexyl)amine, 1,2,3,4-tetrahydroisoquinoline, N-benzylmethylamine, morpholine, piperidine, dioctylamine, and di-cocoamine, dimethylaminopropylamine, dimethylaminopropylaminopropylamine, 1,4-bis(3-aminopropyl) piperazine, 1,3-bis(aminomethyl)cyclohexane, 1,4-bis(3-aminopropyl)piperazine, aniline and an optionally substituted benzocaine (ethyl-4-aminobenzoate).

Examples of commercially available amine-modified acrylates include CN3705, CN3715, CN3755, CN381, CN386 and LM7401, all available from Arkema. Polymeric or multi-amino versions are also suitable.

The curable composition may comprise from 0% to 25%, in particular 2.5% to 20%, more particularly 5 to 15%, by weight of amine-modified acrylate based on the total weight of the curable composition.

The composition may comprise one or more ethylenically unsaturated compounds other than a (meth)acrylate-functionalized monomer or oligomer. Examples of such ethylenically unsaturated compounds include:

- polyvinylic and/or polyallylic monomers (in particular divinyl benzene, 1,4-butanediol divinyl ether, tri(ethylene glycol) divinyl ether, diallyl ether, glycerol diallyl ether, glycerol triallyl ether, trimethylolpropane diallyl ether, trimethylolpropane triallyl ether, pentaerythritol triallyl ether, pentaerythritol tetraallyl ether, diallyl phthalate, triallyl isocyanurate, 2,4,6-triallyloxy-1,3,5-triazine, glyoxal bis(diallyl acetal) and mixtures thereof);
- vinyl esters of carboxylic acids (in particular vinyl acetate, vinyl propionate, vinyl hexanoate, vinyl 2-ethylhexanoate, vinyl octanoate, vinyl pelargonate, vinyl laurate, vinyl stearate, a vinyl ester of versatic acid and mixtures thereof);
- vinyl ethers (in particular vinyl methyl ether, vinyl ethyl ether, vinyl n-butyl ether, vinyl iso-butyl ether and mixtures thereof, ethylene glycol divinyl ether, triethylene glycol divinyl ether and trimethylolpropane trivinyl ether);
- cycloaliphatic vinyl monomers (in particular vinylcyclohexane);
- olefins (in particular ethylene, propene, 1-butene, isobutylene, diisobutylene, 1-nonene, 1-decene and mixtures thereof);
- conjugated dienes (in particular butadiene, isoprene, pentadiene, chlorodiene and mixtures thereof);
- vinyl aromatic monomers (in particular styrene, alpha-methylstyrene, tert-butylstyrene, ortho-, meta-, and para-methylstyrene, ortho-, meta- and para-ethylstyrene, o-methyl-p-isopropylstyrene, p-chlorostyrene, p-bromostyrene, o,p-dichlorostyrene, o,p-dibromostyrene, ortho-, meta- and para-methoxystyrene, optionally substituted indenes, optionally substituted vinylnaphthalenes, acenaphthylene, diphenylethylene, vinyl anthracene and mixtures thereof);
- mono- or dicarboxylic acid monomers, cyclic anhydride monomers and salts thereof (in particular 3-butenoic acid, crotonic acid, vinyl acetic acid, fumaric acid, maleic acid, maleic anhydride, tetrahydrophthalic acid, tetrahydrophthalic anhydride, itaconic acid, mesaconic acid, citraconic acid, glutaconic acid, muconic acid and mixtures thereof);
- unsaturated polymers such as polybutadiene;
- as well as the alkoxylated (e.g., ethoxylated and/or propoxylated) derivatives thereof
- and mixtures thereof.

*Cationically polymerizable compounds*

The curable composition of the present invention may further comprise a cationically polymerizable compound. The curable composition may comprise a mixture of cationically polymerizable compounds.

The term "cationically-polymerizable compound" means a compound (other than an ethylenically unsaturated compound) comprising at least one polymerizable functional group which polymerizes via a cationic mechanism, for example a heterocyclic group. In a cationic polymerization mechanism, a cationic initiator forms a Bronsted or Lewis acid species that binds to the cationically-polymerizable compound which then becomes reactive and leads to chain growth by reaction with another cationically-polymerizable compound.

The cationically polymerizable compound may be selected from epoxides, oxetanes, oxolanes, cyclic acetals, cyclic lactones, thiiranes, thiethanes, spiro orthoesters, and mixtures thereof.

In a preferred embodiment, the cationically polymerizable compound may be selected from epoxides, oxetanes and mixtures thereof.

Examples of suitable polyepoxides are as listed above for $P_{EPOX}$. Examples of suitable cycloaliphatic polyepoxides are as listed above for $P_{CYCLO\ EPOX}$.

Examples of suitable oxetanes include trimethylene oxide, 3,3-dimethyloxetane, 3,3-dichloromethyloxetane, 3-ethyl-3-phenoxymethyloxetane, and bis(3-ethyl-3-methyloxy)butane, 3-ethyl-3-oxetanemethanol.

Examples of suitable oxolanes include tetrahydrofuran and 2,3-dimethyltetrahydrofuran.

Examples of suitable cyclic acetals include trioxane, 1,3-dioxolane, and 1,3,6-trioxanecyclooctane.

Examples of suitable cyclic lactones include β-propiolactone and ε-caprolactone.

Examples of suitable thiiranes include ethylene sulfide, 1,2-propylene sulfide, and thioepichlorohydrin.

Examples of suitable thiethanes capable of being cationically polymerized include trimethylene sulfide, 2-propylthietane and 3,3-dimethylthiethane.

Examples of suitable spiro orthoesters capable of being cationically polymerized are compounds obtained by the reaction of an epoxy compound and a lactone.

When the composition of the invention comprises a cationically polymerizable compound, it may further comprise a polyol. Suitable polyols are as listed above for POH.

The curable composition of the invention may comprise 10 to 80%, in particular 15 to 75%, more particularly 20 to 70%, by weight of cationically polymerizable compound based on the total weight of the curable composition.

*Cationic photoinitiator*

The curable composition of the invention may further comprise a cationic photoinitiator. The curable composition may comprise a mixture of cationic photoinitiators.

As used herein, a cationic photoinitiator refers to a compound that is capable of initiating a cationic polymerization reaction by generating a Brønsted or Lewis acid species after exposure to a suitable light source.

In particular, the cationic photoinitiator may be selected from onium salts with anions of weak nucleophilicity, such as halonium salts or sulfonium salts (e.g., triarylsulfonium salts such as triarylsulfonium hexafluoroantimonate salts); sulfoxonium salts; diazonium salts; metallocene salts; and mixtures thereof.

More particularly, the cationic photoinitiator may be a halonium salt. A halonium salt is an ionic compound comprising a halonium cation (i.e. a halogen atom carrying a positive charge). The halonium cation may be represented by the general structure R-X+-R', where X is a halogen, preferably iodine, and R and R' are any group, preferably an aryl. The halonium cation may be cyclic or an open chain molecular structure. Halonium cations comprising a fluorine, chlorine, bromine, and iodine atom are respectively called fluoronium, chloronium, bromonium, and iodonium. The counter-ion of the salt may be any type of anion such as $Cl^-$, $Br^-$, $I^-$, fluoroalkyl-$SO3^-$, Aryl$SO3^-$, $SbF6^-$, $SbF5OH^-$, $AsF6^-$, $PF6^-$, $BF4^-$ or $B(C6F5)4^-$. Mixtures of iodonium salts can be used if desired. Preferred iodonium salts include diaryliodonium salts such as diphenyliodonium chloride, diphenyliodonium hexafluorophosphate, diphenyliodonium hexafluoroantimonate, diphenyliodonium tetrafluoroborate, di(4-methylphenyl)iodonium tetrafluoroborate; phenyl-4-methylphenyliodonium tetrafluoroborate; di(4-heptylphenyl)iodonium tetrafluoroborate; di(3-nitrophenyl)iodonium hexafluorophosphate; di(4-chlorophenyl)iodonium hexafluorophosphate; di(naphthyl)iodonium tetrafluoroborate; di(4-trifluoromethylphenyl)iodonium tetrafluoroborate; di(4-methylphenyl) iodonium hexafluorophosphate; diphenyliodonium, hexafluoroarsenate; di(4-phenoxyphenyl)iodonium tetrafluoroborate; phenyl-2-thienyliodonium hexafluorophosphate; 3,5-dimethylpyrazolyl-4-phenyliodonium hexafluorophosphate; 2,2'- diphenyliodonium tetrafluoroborate; di(2,4-dichlorophenyl) iodonium hexafluorophosphate; di(4-bromophenyl)iodonium hexafluorophosphate; di(4-methoxyphenyl)iodonium hexafluorophosphate; di(3-carboxyphenyl)iodonium hexafluorophosphate; di(3-methoxycarbonylphenyl)iodonium hexafluorophosphate; di(3-methoxysulfonylphenyl)iodonium hexafluorophosphate; di(4-acetamidophenyl)iodonium hexafluorophosphate; di(2-benzothienyl)iodonium hexafluorophosphate; and diphenyliodonium hexafluoroantimonate. Particularly preferred iodonium salts are diaryliodonium hexafluorophosphate, diaryliodonium hexafluoroantimonate, 4-octyloxyphenyl phenyliodonium hexafluoroantimonate, 4-(2-hydroxytetradecyloxyphenyl)phenyliodonium hexafluoroantimonate, and 4-(1-methylethyl)phenyl 4-methylphenyliodonium tetrakis(pentafluorophenyl)borate.

The curable composition may comprise from 0.01 to 10%, from 0.1 to 9%, from 0.2 to 8%, from 0.5 to 7% or from 1 to 6%, by weight of component b) based on the total weight of the curable composition.

*Polyol and Thiol*

When the composition of the invention comprises a cationically polymerizable compound, it may further comprise a polyol and/or a polythiol. Suitable polyols and polythiols are as listed above for $P_{OH}$ and $P_{SH}$.
Polyols may be of particular use when the composition of the invention comprises a cationically polymerizable compound.
Polythiols may be of particular use when the composition of the invention comprises an ethylenically unsaturated compound other than a (meth)acrylate-functionalized monomer or oligomer, in particular a polyvinylic and/or polyallylic monomer.
The amount of polyol and polythiol in the curable composition will vary depending on the type of compound that is used. Typically, however, the curable composition is formulated to comprise from 0 to 10%, from 0.5 to 8%, from 1 to 5% or from 1.5 to 4%, by weight of polyol and/or polythiol based on the weight of the curable composition.

*Amine synergist*

The curable composition of the present invention may comprise an amine synergist. The curable composition may comprise a mixture of amine synergists.
Amine synergists may be introduced in the curable composition of the present invention in order to reduce oxygen inhibition. Amine synergists are typically tertiary amines. Tertiary amines are able to convert unreactive peroxy species, formed by reaction between oxygen and free radicals, to reactive alkyl-amino radicals, thus reducing the effects of oxygen on curing.
When the curable composition comprises an amine-modified acrylate monomer or oligomer as defined above, an amine synergist may not need to be added to the composition.
Examples of suitable amine synergists include low-molecular weight tertiary amines (i.e. having a molecular weight of less than 200 g/mol) such as triethanol amine, N-methyldiethanol amine. Other types of amine synergists are aminobenzoates, polymerizable aminobenzoates, polymeric aminobenzoates and mixtures thereof. Examples of aminobenzoates include ethyl 4-(dimethylamino)benzoate (EDB), pentyl 4-(dimethylamino)benzoate, 2-ethylhexyl 4-(dimethylamino)benzoate and 2-butoxyethyl 4-(dimethylamino)benzoate (BEDB).
The concentration of amine synergist in the curable composition will vary depending on the type of compound that is used. Typically, however, the curable composition is formulated to comprise from 0% to 25%, in particular 0.5% to 20%, more particularly 1 to 15%, by weight of amine synergist based on the total weight of the curable composition.

*Additives*

The curable composition of the present invention may further comprise an additive. The curable composition may comprise a mixture of additives.
In particular, the additive may be selected from sensitizers, stabilizers, antioxidants, light blockers, polymerization inhibitors, foam inhibitors, flow or leveling agents, colorants, pigments, dispersants (wetting agents, surfactants), slip additives, fillers, thixotropic agents, matting agents, impact modifiers, waxes and mixtures thereof; and any other additive conventionally used in the coating, sealant, adhesive, molding, 3D printing or ink arts.
According to some embodiments, the curable composition may comprise a stabilizer.
Stabilizers may be introduced in the curable composition of the present invention in order to provide adequate storage stability and shelf life. Further, stabilizers may be used during the preparation of the curable composition, to protect against unwanted reactions during processing of the ethylenically unsaturated components of the curable composition. A stabilizer may be a compound or substance which retards or prevents reaction or curing of actinically-polymerizable functional groups present in a composition in the absence of actinic radiation. However, it will be advantageous to select an amount and type of stabilizer such that the composition remains capable of being cured when exposed to actinic radiation (that is, the stabilizer does not prevent radiation curing of the composition). The stabilizer may, in particular be a free radical stabilizer (i.e. a stabilizer which functions by inhibiting free radical reactions).
Any of the stabilizers known in the art related to (meth)acrylate-functionalized compounds may be utilized in the present invention. Quinones represent a particularly preferred type of stabilizer which can be employed in the context of the present invention. As used herein, the term "*quinone*" includes both quinones and hydroquinones as well as ethers thereof such as monoalkyl, monoaryl, monoaralkyl and bis(hydroxyalkyl) ethers of hydroquinones. Hydroquinone monomethyl ether is an example of a suitable stabilizer which can be utilized. Other stabilizers known in the art such as hydroquinone (HQ), 4-tert-butylcatechol (TBC), 3,5-di-tertiobutyl-4-hydroxytoluene (BHT), phenothiazine (PTZ), pyrogallol, phosphite compounds, triphenyl antimony and tin(II) salts.
The concentration of stabilizer in the curable composition will vary depending upon the particular stabilizer or combination of stabilizers selected for use and also on the degree of stabilization desired and the susceptibility of

components in the curable compositions towards degradation in the absence of stabilizer. Typically, however, the curable composition is formulated to comprise from 5 to 5000 ppm stabilizer. According to certain embodiments of the invention, the reaction mixture during each stage of the method employed to make the curable composition contains at least some stabilizer, e.g., at least 10 ppm stabilizer.

The curable composition may comprise a colorant. A colorant may be a dye, a pigment and mixtures thereof. The term "dye", as used herein means a colorant having a solubility of 10 mg/L or more in the medium in which it is introduced at 25°C. The term "pigment" is defined in DIN 55943, as a colorant that is practically insoluble in the application medium under the pertaining ambient conditions, hence having a solubility of less than 10 mg/L therein at 25°C. The term "C.I." is used as an abbreviation for Colour Index.

The colorant may be a pigment. Organic and/or inorganic pigments may be used. If the colorant is not a self-dispersible pigment, the inkjet inks preferably also contain a dispersant, more preferably a polymeric dispersant. The pigment may be black, cyan, magenta, yellow, red, orange, violet, blue, green, brown and mixtures thereof. Pigments may be chosen from those disclosed by HERBST, Willy, et al. Industrial Organic Pigments, Production, Properties, Applications. 3rd edition. Wiley - VCH , 2004. ISBN 3527305769.

Particular pigments include:

- Carbon black;
- C.I. Pigment White 1, 3, 4, 5, 6, 7, 10, 11, 12, 14, 17, 18, 19, 21, 24, 25, 27, 28 and 32;
- C.I. Pigment Yellow 1, 3, 10, 12, 13, 14, 17, 55, 65, 73, 74, 75, 83, 93, 97, 109, 111, 120, 128, 138, 139, 150, 151, 154, 155, 180, 185 and 213;
- C.I. Pigment Red 17, 22, 23, 41, 48:1 , 48:2, 49:1, 49:2, 52:1, 57:1, 81 :1, 81 :3, 88, 112, 122, 144, 146, 149, 169, 170, 175, 176, 184, 185, 188, 202, 206, 207, 210, 216, 221, 248, 251, 254, 255, 264, 270 and 272;
- C.I. Pigment Violet 1, 2, 19, 23, 32, 37 and 3;
- C.I. Pigment Blue 15:1, 15:2, 15:3, 15:4, 15:6, 16, 56, 61 and (bridged) aluminium phthalocyanine pigments;
- C.I. Pigment Orange 5, 13, 16, 34, 40, 43, 59, 66, 67, 69, 71 and 73;
- C.I. Pigment Green 7 and 36;
- C.I. Pigment Brown 6 and 7;

and mixtures thereof.

The curable composition of the invention may comprise a dispersant. The dispersant may be used to disperse an insoluble material such as a pigment or filler in the curable composition.

The dispersant may be a polymeric dispersant, a surfactant and mixtures thereof.

Typical polymeric dispersants are copolymers of two, three, four, five or even more monomers. The properties of polymeric dispersants depend on both the nature of the monomers and their distribution in the polymer. Copolymeric dispersants preferably have the following polymer compositions:

- random copolymer (e.g. ABBAABAB);
- alternating copolymer (e.g. ABABABAB);
- gradient copolymer (e.g. AAABAABBABBB) ;
- block copolymers (e.g. AAAAABBBBBB);
- graft copolymers (polymeric backbone with polymeric side chains attached to the backbone);

and mixed forms of these copolymers.

The polymeric dispersant may have a number average molecular weight Mn between 500 and 30,000 g/mol, more preferably between 1,500 and 10,000 g/mol.

Commercial examples of polymeric dispersants include:

- DISPERBYK® dispersants available from BYK CHEMIE GMBH;
- SOLSPERSE® dispersants available from LUBRIZOL;
- TEGO® DISPERSE dispersants from EVONIK;
- DISPEX®, EFKA® and JONCRYL® dispersants from BASF;
- DISPONER® dispersants from ELEMENTIS.

*Solvents*

The curable composition of the invention may comprise a solvent. As used herein, the term "solvent" means a non-reactive organic solvent, i.e. a solvent comprising carbon and hydrogen atom that does not react when exposed to the actinic radiation used to cure the curable compositions described herein.

Advantageously, the curable composition of the present invention may be formulated to be solvent-free. For example, the curable composition of the present invention may contain little or no solvent, e.g., less than 10 %, or less than 5 %, or less than 1 %, or even 0 % by weight of solvent, based on the total weight of the curable composition.

According to some embodiments, the curable composition is a liquid at 25°C. In various embodiments of the invention, the curable compositions described herein are formulated to have a viscosity of less than 10,000 mPa.s, or less than 5,000 mPa.s, or less than 1,000 mPa.s, or less than 500 mPa.s, or less than 250 mPa.s, or even less than 100 mPa.s as measured at 25°C using a Brookfield viscometer, model DV-II, using a 27 spindle (with the spindle speed varying typically between 20 and 200 rpm, depending on viscosity). In advantageous embodiments of the invention, the viscosity of the curable composition is from 10 to 10,000 mPa.s, or from 10 to 5,000 mPa.s, or from 10 to 1,000 mPa.s, or from 10 to 500 mPa.s, or from 10 to 250 mPa.s, or from 10 to 100 mPa.s at 25°C.

*Formulations*

The curable compositions described herein may be compositions that are to be subjected to curing by means of free radical polymerization. In particular embodiments, the curable compositions may be photocured (i.e., cured by exposure to actinic radiation, in particular UV, near-UV, visible, infrared and/or near-infrared radiation).

The curable composition of the invention may be an ink composition, a coating composition, an adhesive composition, a sealant composition, a molding composition, a dental composition, a nail polish composition or a 3D-printing composition.

End use applications for the curable compositions include, but are not limited to, inks, coatings, adhesives, additive manufacturing resins (such as 3D printing resins), molding resins, sealants, composites, antistatic layers, electronic applications, recyclable materials, smart materials capable of detecting and responding to stimuli, packaging materials, personal care articles, nail polishes, articles for use in agriculture, water or food processing, or animal husbandry, and biomedical materials. The curable compositions of the invention thus find utility in the production of biocompatible articles. Such articles may, for example, exhibit high biocompatibility, low cytotoxicity and/or low extractables.

The composition according to the invention may in particular be used to obtain a cured product according to the following processes.

## Process for the preparation of a cured product

The process for the preparation of a cured product according to the invention comprises curing the curable composition of the invention. In particular, the curable composition may be cured by exposing the composition to radiation. More particularly, the curable composition may be cured by exposing the composition to UV, near-UV, visible, infrared and/or near-infrared radiation. The curable composition may advantageously be cured by exposing the composition to a LED light source.

Curing may be accelerated or facilitated by supplying energy to the curable composition, such as by heating the curable composition. Thus, the cured product may be deemed as the reaction product of the curable composition, formed by curing. A curable composition may be partially cured by exposure to actinic radiation, with further curing being achieved by heating the partially cured article.

For example, a product formed from the curable composition may be heated at a temperature of from 40°C to 120°C for a period of time from 5 minutes to 12 hours.

Prior to curing, the curable composition may be applied to a substrate surface in any known conventional manner, for example, by spraying, jetting, knife coating, roller coating, casting, drum coating, dipping, and the like and combinations thereof. Indirect application using a transfer process may also be used.

The substrate on which the curable composition is applied and cured may be any kind of substrate. Suitable substrates are detailed below. When used as an adhesive, the curable composition may be placed between two substrates and then cured, the cured composition thereby bonding the substrates together to provide an adhered article. Curable compositions in accordance with the present invention may also be formed or cured in a bulk manner (e.g., the curable composition may be cast into a suitable mold and then cured).

The substrate may be a ceramic, metallic, mineral, cellulosic, animal-based or polymeric substrate. The substrate may also be a part of a human body, such as a tooth or a nail.

The substrate may be porous or substantially non-porous. The substrates may be transparent, translucent or opaque.

Examples of ceramic substrates include alumina-based ceramics and zirconia-based ceramics.

Examples of metallic substrates include titanium, gold, silver, copper, brass, steel and bronze.

Examples of mineral substates include glass, asbestos and basalt.

Examples of cellulosic substrates include plain paper or resin coated paper (e.g. polyethylene or polypropylene

coated paper). There is no real limitation on the type of paper and it includes newsprint paper, magazine paper, office paper, wallpaper but also paper of higher grammage, usually referred to as boards, such as white lined chipboard, corrugated board and packaging board. Further examples of cellulosic substrates include bamboo, cotton, flax, hemp, jute, lyocell, modal, rayon, raffia, ramie and sisal.

Examples of cellulosic substrates include wool, fur, silk and leather.

Examples of polymeric substrates include polyethylene, polypropylene, polycarbonate, polyvinyl chloride, polyethylene terephthalate, polyethylene naphthalate, polylactide, polyamide, polyimide, polyacrylonitrile, polyurethane, acrylonitrile butadiene styrene.

There is no restriction on the shape of the substrate. It can be a sheet, a film, a nonwoven or woven fiber mat or a three dimensional object.

In particular, the substrate may be selected from a food and beverage packaging, a pharmaceutical packaging, a textile, a nail, a tooth, a medical device, a food and beverage processing equipment, a water pipe.

The cured product obtained with the process of the invention may be an ink, a coating, an adhesive, a sealant, a molded article, a dental material, a nail polish or a 3D-printed article.

## Process of 3D printing

A 3D-printed article may, in particular, be obtained with a 3D printing process that comprises printing a 3D article with the composition of the invention. In particular, the process may comprise printing a 3D article layer by layer or continuously.

Three-dimensional (3D) printing (also referred to as additive manufacturing) is a process in which a 3D digital model is manufactured by the accretion of construction material. The 3D printed object is created by utilizing the computer-aided design (CAD) data of an object through sequential construction of two dimensional (2D) layers or slices that correspond to cross-sections of 3D objects. The radiation can be in the form of electromagnetic waves or an electron beam. The most commonly applied energy source is UV, near-UV, visible, infrared and/or near-infrared radiation.

A plurality of layers of a curable composition in accordance with the present invention may be applied to a substrate surface; the plurality of layers may be simultaneously cured (by exposure to a single dose of radiation, for example) or each layer may be successively cured before application of an additional layer of the curable composition.

Non-limiting examples of suitable 3D printing processes include stereolithography (SLA); digital light process (DLP); liquid crystal device (LCD); inkjet head (or multjet) printing; Continuous Liquid Interface Production (CLIP); extrusion type processes such as continuous fiber 3D printing and cast-in-motion 3D printing; and volumetric 3D printing. The building method may be "layer by layer" or continuous. The liquid may be in a vat, or deposited with an inkjet or gel deposition, for example.

Stereolithography and other photocurable 3D printing methods typically apply low intensity light sources to radiate each layer of a photocurable resin to form the desired article. As a result, photocurable resin polymerization kinetics and the green strength of the printed article are important criteria if a particular photocurable resin will sufficiently polymerize (cure) when irradiated and have sufficient green strength to retain its integrity through the 3D printing process and post-processing.

The curable compositions of the invention may be used as 3D printing resin formulations, that is, compositions intended for use in manufacturing three-dimensional articles using 3D printing techniques. Such three-dimensional articles may be free-standing/self-supporting and may consist essentially of or consist of a composition in accordance with the present invention that has been cured. The three-dimensional article may also be a composite, comprising at least one component consisting essentially of or consisting of a cured composition as previously mentioned as well as at least one additional component comprised of one or more materials other than such a cured composition (for example, a metal component or a thermoplastic component or inorganic filler or fibrous reinforcement). The curable compositions of the present invention are particularly useful in digital light printing (DLP), although other types of three-dimensional (3D) printing methods may also be practiced using the inventive curable compositions (e.g., SLA, inkjet, multi-jet printing, piezoelectric printing, actinically-cured extrusion, and gel deposition printing). The curable compositions of the present invention may be used in a three-dimensional printing operation together with another material which functions as a scaffold or support for the article formed from the curable composition of the present invention.

Thus, the curable compositions of the present invention are useful in the practice of various types of three-dimensional fabrication or printing techniques, including methods in which construction of a three-dimensional object is performed in a stepwise or layer-by-layer manner. In such methods, layer formation may be performed by solidification (curing) of the curable composition under the action of exposure to radiation, such as visible, UV or other actinic irradiation. For example, new layers may be formed at the top surface of the growing object or at the bottom surface of the growing object. The curable compositions of the present invention may also be advantageously employed in methods for the production of three-dimensional objects by additive manufacturing wherein the method is carried out continuously. For example, the object may be produced from a liquid interface. Suitable methods of this type are sometimes referred to in the

art as "*continuous liquid interface (or interphase) product (or printing)*" ("CLIP") methods. Such methods are described, for example, in WO 2014/126830; WO 2014/126834; WO 2014/126837; and Tumbleston et al., "Continuous Liquid Interface Production of 3D Objects", Science Vol. 347, Issue 6228, pp. 1349-1352 (March 20, 2015.

The curable composition may be supplied by ejecting it from a printhead rather than supplying it from a vat. This type of process is commonly referred to as inkjet or multijet 3D printing. One or more UV curing sources mounted just behind the inkjet printhead cures the curable composition immediately after it is applied to the build surface substrate or to previously applied layers. Two or more printheads can be used in the process which allows application of different compositions to different areas of each layer. For example, compositions of different colors or different physical properties can be simultaneously applied to create 3D printed parts of varying composition. In a common usage, support materials - which are later removed during post-processing - are deposited at the same time as the compositions used to create the desired 3D printed part. The printheads can operate at temperatures from about 25°C up to about 100°C. Viscosities of the curable compositions are less than 30 mPa.s at the operating temperature of the printhead.

The process for the preparation of a 3D-printed article may comprise the steps of:

a) providing (e.g., coating) a first layer of a curable composition in accordance with the present invention onto a surface;
b) curing the first layer, at least partially, to provide a cured first layer;
c) providing (e.g., coating) a second layer of the curable composition onto the cured first layer;
d) curing the second layer, at least partially, to provide a cured second layer adhered to the cured first layer; and
e) repeating steps c) and d) a desired number of times to build up the three-dimensional article.

Alternatively, the process for the preparation of a 3D-printed article may comprise the steps of:

a) providing a carrier and an optically transparent member having a build surface, the carrier and build surface defining a build region therebetween;
b) filling the build region with a composition as defined above;
c) continuously or intermittently curing part of the composition in the build region according to the method as defined above to form a cured composition; and
d) continuously or intermittently advancing the carrier away from the build surface to form the 3D-printed article from the cured composition.

After the 3D article has been printed, it may be subjected to one or more post-processing steps. The post-processing steps can be selected from one or more of the following steps removal of any printed support structures, washing with water and/or organic solvents to remove residual resins, and post-curing using thermal treatment and/or actinic radiation either simultaneously or sequentially. The post-processing steps may be used to transform the freshly printed article into a finished, functional article ready to be used in its intended application.

## Process of inkjet printing

The process of inkjet printing according to the invention comprised jetting the curable composition of the invention onto a substrate.

The substrate on which the curable composition is jetted may be any kind of substrate. Suitable substrates are as detailed above.

The curable composition may be jetted by one or more print heads ejecting small droplets in a controlled manner through nozzles onto a substrate moving relative to the print head(s).

The print head may be a piezoelectric head or a continuous type print head.

The inkjet printing process may be carried out in a single pass or with a multi-pass printing mode.

The inkjet printing process may further comprise a UV-curing step. In inkjet printing, the UV curing device may be arranged in combination with the print head of the inkjet printer, travelling therewith so that the liquid UV curable inkjet ink is exposed to curing radiation very shortly after been jetted.

In a particularly preferred embodiment, the UV curing step is performed using UV LED light sources.

For facilitating curing, the inkjet printer may include one or more oxygen depletion units. The oxygen depletion units place a blanket of nitrogen or other relatively inert gas (e.g. $CO_2$), with adjustable position and adjustable inert gas concentration, in order to reduce the oxygen concentration in the curing environment.

## Process of coating a nail

The process of coating a nail according to the invention comprises applying the curable composition of the

invention on a nail, and curing the composition on the nail.

## Uses

The compound of formula (1) or (2) of the invention or the photoinitiator composition of the invention may be used as a photoinitiator or a photoinitiating system in a radiation curable composition, in particular in a UV or LED-curable composition.

As used herein, "*UV curable composition*" means a composition cured by exposure to UV light emitted by a mercury light source, in particular a mercury-vapor lamp, and "*LED-curable composition*" means curing by exposure to UV light emitted by a LED light source, in particular a LED light source having an emission band in the range from 365 to 420 nm.

The compound of formula (1) or (2) of the invention or the photoinitiator composition of the invention may be used in a photopolymerization reaction. The photopolymerization reaction may be used to cure one or more ethylenically unsaturated compounds as defined above.

The compound of formula (1) or (2) of the invention or the photoinitiator composition of the invention may be used to obtain a cured product having a reduced amount of extractables. In particular, the cured product may be an ink, an overprint varnish, a coating, an adhesive, a sealant, a molded article, a dental material, a nail-polish or a 3D-printed article.

The reduction in the amount of extractables may be assessed in comparison with a cured product obtained with a conventional photoinitiator.

The extractables may be any component that migrates from the cured product. In particular, the extractables may be a photoinitiator or a residue thereof.

Migration in inkjet inks may occur in different ways:

- Penetration Migration - through the substrate to the reverse-side of the print;
- Set-off Migration - from the printed side of a substrate to the reverse side of the substrate while stacked or stored on a roll;
- Vapor-phase migration - evaporation of volatile compounds when heated;
- Condensation Extraction - condensation of critical compounds when cooked or sterilized.

The amount of extractables may be determined quantitatively using a suitable analytical method such as liquid chromatography mass spectroscopy (LC-MS). For example, the curable composition can be applied in 12 $\mu$m thickness film on a glass substrate, and crosslinked using a UV Hg lamp. Resulting cured films are removed from the glass plate, weighed and soaked in solvent such as acetonitrile or dichloromethane. The liquid fraction is finally evaporated and the residue, corresponding to the extractables part, is weighed, allowing to determine the amount of product that is uncured (not trapped within the photocured network).

Analytical methods such as nuclear magnetic resonance (NMR), liquid chromatography mass spectroscopy (LC-MS) or gas chromatography mass spectroscopy (GC-MS) may then be used to identify the nature of the extractables and refine their corresponding content.

In particular, the cured product may have less than 5 %, less than 2 %, less than 1 %, less than 0.5 %, less than 0.25 % or less than 0.1 %, by weight of extractables based on the weight of the cured product.

The curable composition of the invention may be used to obtain an ink, an overprint varnish, a coating, an adhesive, a sealant, a molded article, a dental material or a 3D-printed article, in particular an ink.

## ASPECTS

The invention may be as described in any one of the following Aspects:

Aspect 1. A photoinitiator according to formula (1) or (2):

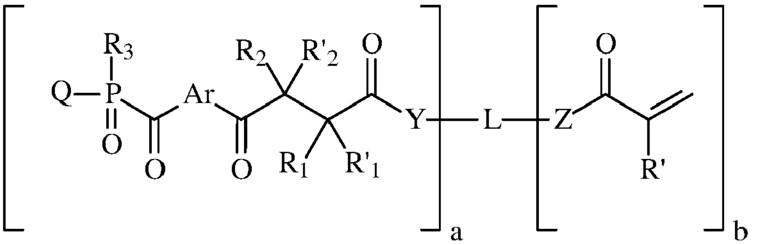

(1)

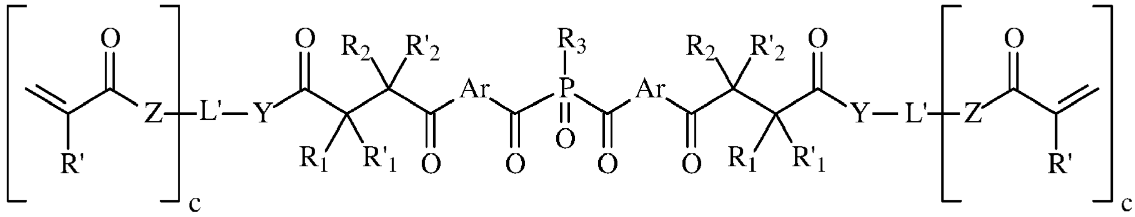

(2)

wherein:

- each Ar is independently an optionally substituted arylene;
- $R_1$ and $R_2$ are independently H or an optionally substituted group selected from alkyl and aryl; or $R_1$ and $R_2$, together with the carbon atoms to which they are attached, form a ring;
- one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-W^2-R^{10})$, $-C(R^{11})(CO-W^3-R^{12})(CN)$, $-C(R^{13})(CN)_2$, a moiety comprising a polymerizable group and a moiety comprising a phosphine oxide group; or $R'_2$ is H and $R'_1$ and Y, together with the atoms to which they are attached, form a 5-8 membered ring;
- each $R_3$ is independently an optionally substituted group selected from alkyl, aryl and alkoxy;
- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom;
- Q is an optionally substituted aryl or a group of formula (3):

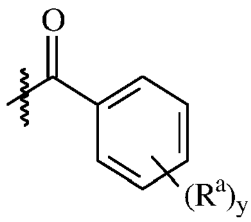

(3)

wherein:

- each $R^a$ is independently an optionally substituted group selected from alkyl, aryl, alkoxy, aryloxy, thioalkyl and thioaryl; and
- y is a number chosen from 0 to 5;

- each Y is independently -O-, -S-, $-NR^{16}-$, or a group represented by the following formula (4):

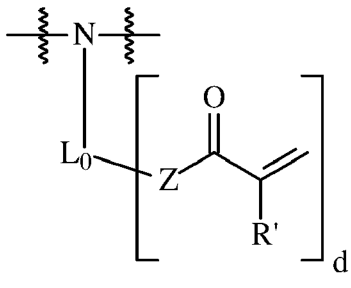

(4)

- each Z is independently -O- or $-NR^{17}-$;
- each $R^{16}$ is independently H or an optionally substituted group selected from alkyl, and aryl; or $R^{16}$, together with

the nitrogen atom to which it is attached, forms a 5-8 membered ring with $R'_1$;

- each $R^{17}$ is independently H or an optionally substituted group selected from alkyl and aryl;
- L is a (a+b)valent linker;
- L' is a (c+1)valent linker;
- $L_0$ is a (d+1)valent linker;
- each R' is independently H or methyl;
- a, b, c and d are independently an integer from 1 to 6.

Aspect 2. The photoinitiator according to Aspect 1, wherein each Ar is independently an optionally substituted phenylene, preferably a meta-phenylene substituted by one or more optionally substituted groups selected from alkyl, aryl, alkoxy, aryloxy, thioalkyl and thioaryl; and more preferably Ar is a group of formula (5):

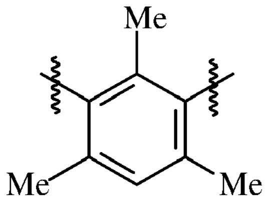
(5).

Aspect 3. The photoinitiator according to Aspect 1 or 2, wherein $R_1$ and $R_2$ are both H, or $R_1$ and $R_2$, together with the carbon atoms to which they are attached, form a six-membered ring, preferably a six-membered cycloaliphatic ring, and wherein preferably $R_1$ and $R_2$ are both H.

Aspect 4. The photoinitiator according to any one of Aspects 1 to 3, wherein one of $R'_1$ and $R'_2$ is H and the other of $R'_1$ and $R'_2$ is $-OR^4$, and wherein preferably $R^4$ is an optionally substituted alkyl.

Aspect 5. The photoinitiator according to any one of Aspects 1 to 3, wherein one of $R'_1$ and $R'_2$ is H and the other of $R'_1$ and $R'_2$ is $-SR^5$, and wherein preferably $R^5$ is an optionally substituted alkyl.

Aspect 6. The photoinitiator according to any one of Aspects 1 to 3, wherein one of $R'_1$ and $R'_2$ is H and the other of $R'_1$ and $R'_2$ is $-NR^6R^7$, and wherein preferably $R^6$ and $R^7$, together with the nitrogen atom to which they are attached, form a 5-7 membered ring; in particular an optionally substituted ring selected from morpholine, piperidine, pyrrolidine, oxazolidine, piperazine, thiazolidine, thiomorpholine and azepane.

Aspect 7. The photoinitiator according to any one of Aspects 1 to 3, wherein one of $R'_1$ and $R'_2$ is H and the other of $R'_1$ and $R'_2$ is $-C(R^8)(CO-W^1-R^9)(CO-W^2-R^{10})$, and wherein preferably

- $R^8$ is H;
- $W^1$ and $W^2$ are independently a bond or an oxygen atom; and
- $R^9$ and $R^{10}$ are independently an optionally substituted alkyl.

Aspect 8. The photoinitiator according to any one of Aspects 1 to 3, wherein one of $R'_1$ and $R'_2$ is H and the other of $R'_1$ and $R'_2$ is a moiety comprising a polymerizable group, and wherein preferably the moiety comprising a polymerizable group corresponds to the following formula (Acr):

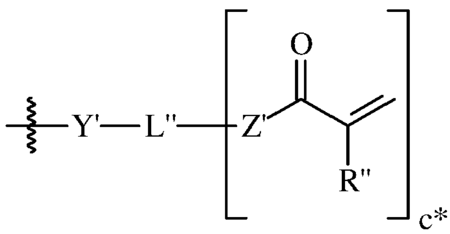
(Acr)

- Y' is -O- or $-NR^{14}-$;
- each Z' is -O- or $-NR^{15}$;

- each R" is independently H or methyl;
- $R^{14}$ and $R^{15}$ are preferably H;
- L" is a (c*+1)valent linker;
- c* is an integer from 1 to 4.

Aspect 9. The photoinitiator according to any one of Aspects 1 to 3, wherein $R'_2$ is H and $R'_1$ forms a 5-8 membered ring with Y, and wherein preferably the photoinitiator is according to formula (6) or (7):

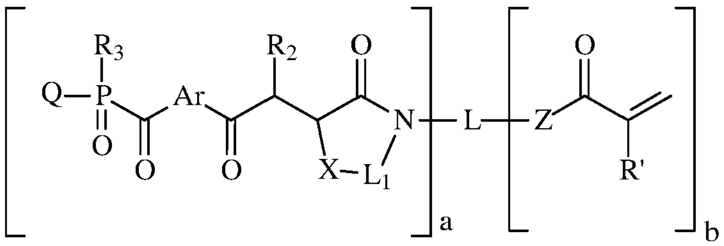

(6)

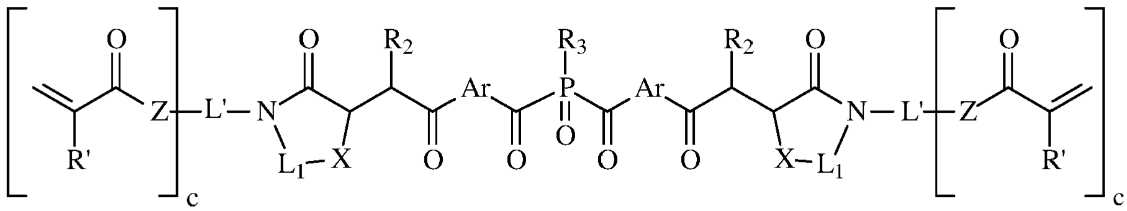

(7)

wherein

- Ar, $R_2$, $R_3$, Q, L, L', Z, R', a, b and c are as defined in any one of Aspects 1 to 3;
- each X is independently selected from -O-, -S- and $-NR^{18}-$;
- $R^{18}$ is H or an optionally substituted alkyl;
- $L_1$ is an optionally substituted C1-C4 alkylene.

Aspect 10. The photoinitiator according to any one of Aspects 1 to 9, wherein each $R_3$ is independently an optionally substituted phenyl, methoxy or ethoxy; preferably each $R_3$ is independently phenyl or ethoxy.

Aspect 11. The photoinitiator according to any one of Aspects 1 to 10, wherein Q is phenyl or a group of formula (3a):

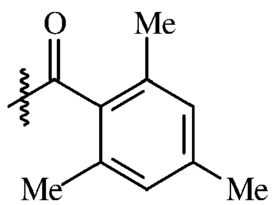

(3a).

Aspect 12. The photoinitiator according to any one of Aspects 1 to 8, 10 and 11, wherein Y is -O-.

Aspect 13. The photoinitiator according to any one of Aspects 1 to 8 and 10 to 12, wherein Z is -O-.

Aspect 14. The photoinitiator according to any one of Aspects 1 to 8, 10 and 11, wherein Y is -S-.

Aspect 15. The photoinitiator according to any one of Aspects 1 to 8, 10, 11 and 14 wherein Z is -O-.

Aspect 16. The photoinitiator according to any one of Aspects 1 to 8, 10 and 11, wherein Y is $-NR^{16}-$ and $R^{16}$ is preferably H.

Aspect 17. The photoinitiator according to any one of Aspects 1 to 8, 10, 11 and 16 wherein Z is $-NR^{17}-$ and $R^{17}$ is preferably H.

Aspect 18. The photoinitiator according to any one of Aspects 1 to 8, 10 and 11, wherein Y is a group of formula (4):

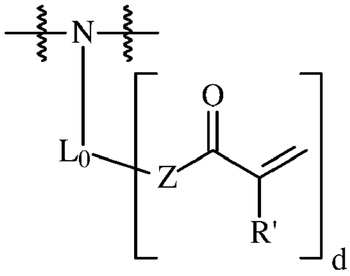

(4)

wherein

- $L_0$ is preferably alkylene;
- Z is preferably -O-;
- R' is H or methyl;
- d is preferably equal to 1.

Aspect 19. The photoinitiator according to Aspect 18 wherein Z is -O-.

Aspect 20. The photoinitiator according to any one of Aspects 1 to 19, wherein L, L' and L" are independently selected from an aromatic linker, an aliphatic linker, a cycloaliphatic linker, a polyether linker, a polythioether linker, a polyalkylene imine linker, a polyester linker, a polycarbonate linker, a polyurethane linker, a polyorganosiloxane linker, a polybutadiene linker, and combinations thereof;
preferably L and L' are independently selected from an aromatic linker, an aliphatic linker, a cycloaliphatic linker, a polyether linker, a polythioether linker, a polyalkylene imine linker, a polyester linker, a polyorganosiloxane linker, and combinations thereof.

Aspect 21. The photoinitiator according to any one of Aspect 1 to 20, wherein L, L' and L" are independently selected from:

- a divalent moiety according to any one of formulae (8) to (17):

$-(CR_4R'_4)_e-$ (8)

$-CH_2-O-CH_2-$ (9)

$-[(CR_5R'_5)_f-W]_g-(CR_5R'_5)_f-$ (10)

$-[(CR_6R'_6)_h-W]_i-(CR_7R'_7)_j-[W-(CR_6R'_6)_h]_i-$ (11)

$-[(CR_8R'_8)_k-C(=O)O]_l-(CR_9R'_9)_m-$ (12)

$-(CR_9R'_9)_m-[(CR_8R'_8)_k-C(=O)O]_l-$ (13)

$-[(CR_{10}R'_{10})_n-O-C(=O)-(CR_{11}R'_{11})_o-C(=O)-O]_p-(CR_{10}R'_{10})_n-$ (14)

$-(CR_{12}R'_{12})_q-C(=O)-O-(CR_{13}R'_{13})_r-O-C(=O)-(CR_{12}R'_{12})_q-$ (15)

$-(CR_{14}R'_{14})_s-Cy-[L-Cy]_t-(CR_{14}R'_{14})_s-$ (16)

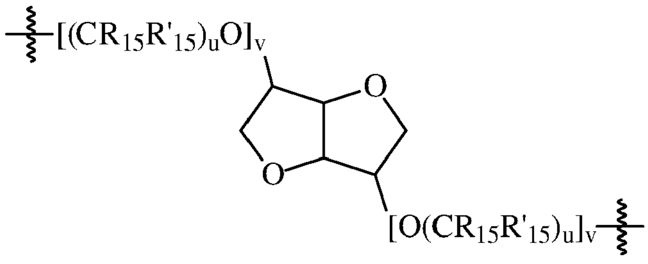

(17)

wherein:

- $R_4$, $R'_4$, $R_7$, $R'_7$, $R_9$, $R'_9$, $R_{10}$, $R'_{10}$, $R_{11}$, $R'_{11}$, $R_{12}$, $R'_{12}$, $R_{13}$, $R'_{13}$, $R_{14}$ and $R'_{14}$ are independently H or alkyl;
- $R_5$, $R'_5$, $R_6$, $R'_6$, $R_8$, $R'_8$, $R_{15}$ and $R'_{15}$ are independently H or methyl;
- each W is independently -O- or -S-;
- Cy is an optionally substituted ring, in particular an optionally substituted cyclohexylene or phenylene;
- L is a bond or a linker such as Alk, -C(=O)-, -C(=O)-O-Alk-O-C(=O)-, -SO-, $-SO_2-$, $-C(=CCl_2)-$ and -Alk-Ph-Alk-;
- Alk is an optionally substituted alkylene;
- Ph is an optionally substituted phenylene;
- e, j, m, n, o and r are independently an integer from 2 to 20;
- each s is independently an integer from 0 to 20;
- f, h and u are independently an integer from 2 to 4;
- t is an integer equal to 0 or 1;
- g, l, p and q are independently an integer from 1 to 20;
- each v is independently an integer from 0 to 10, in particular from 1 to 6;
- each i is independently an integer from 0 to 20 with the proviso that at least one i is not 0;
- k is an integer from 3 to 12;

- a trivalent moiety according to any one of formulae (18) to (23):

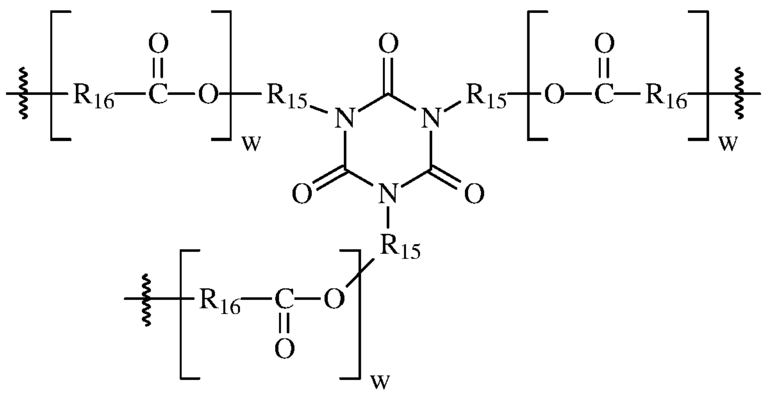

(18)

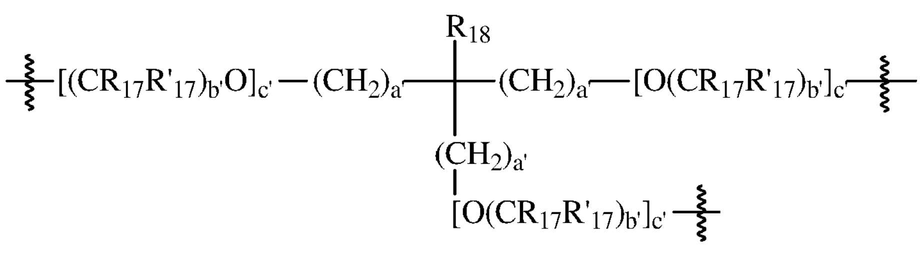

(19)

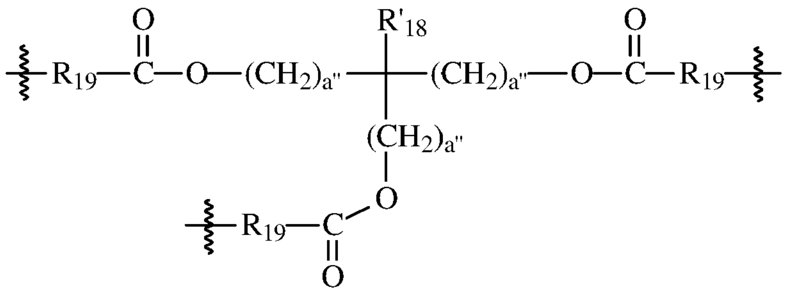

(20)

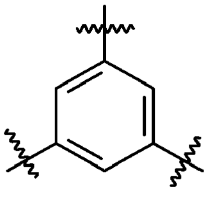

(21)

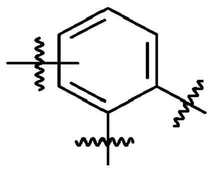

(22)

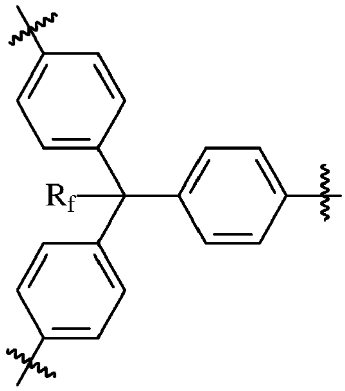

(23)

wherein:

- $R_{15}$ and $R_{16}$ are independently a linear or branched alkylene;
- $R_{17}$ and $R'_{17}$ are independently H or methyl;
- $R_{18}$ and $R'_{18}$ are independently H, alkyl or alkoxy, preferably $R_{18}$ and $R'_{18}$ are alkyl;
- each $R_{19}$ is independently a linear or branched alkylene;
- $R_f$ is H or methyl;
- w is an integer equal to 0 or 1;
- each a' is independently an integer from 0 to 2 with the proviso that not more than one a' is equal to 0, preferably each a' is equal to 1 or one a' is equal to 0 and the two other a' are equal to 1;
- each a" is independently an integer from 0 to 2 with the proviso that not more than one a" is equal to 0, preferably each a" is equal to 1 or one a" is equal to 0 and the two other a" are equal to 1;
- each b' is independently an integer from 2 to 4, in particular 2;
- each c' is independently an integer from 0 to 10, in particular from 1 to 6;

- a tetravalent moiety according to any one of formulae (24) to (27):

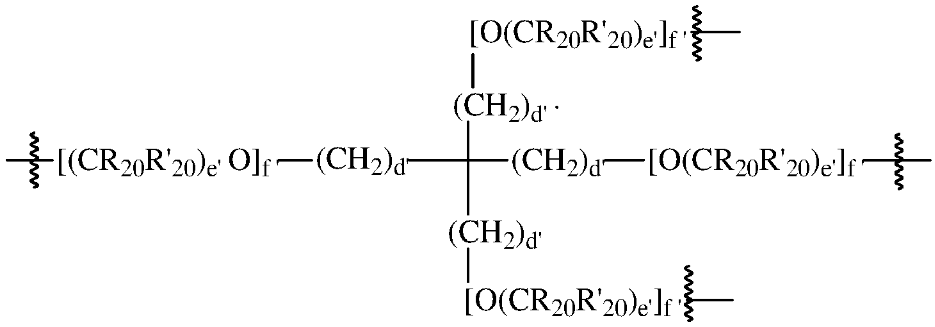

(24)

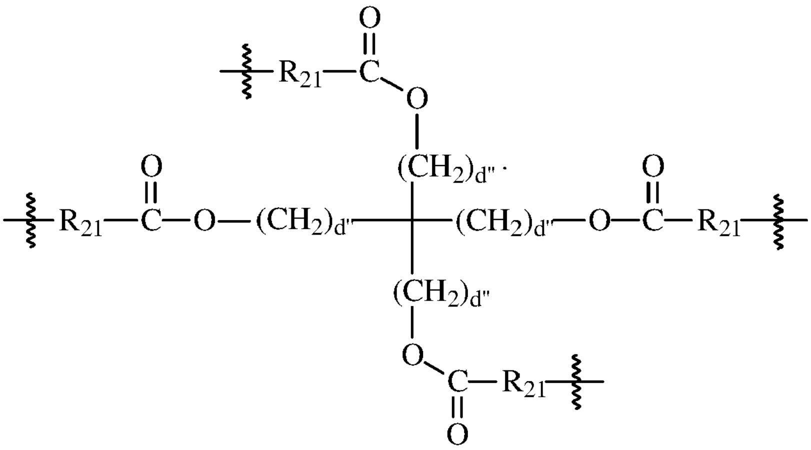

(25)

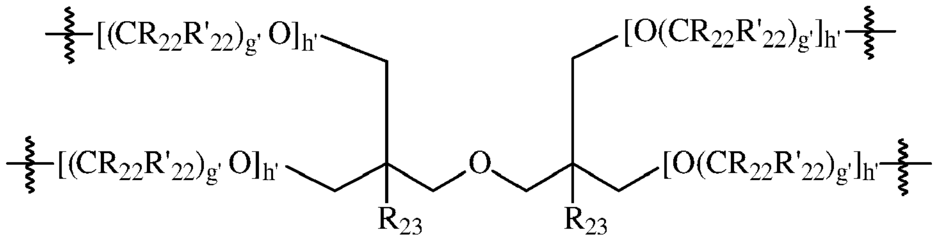

(26)

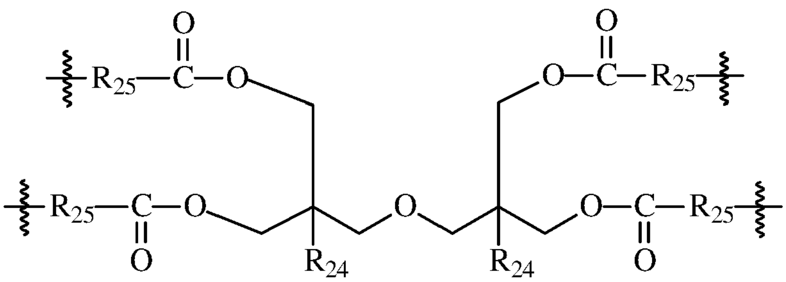

(27)

wherein:

- $R_{20}$, $R'_{20}$, $R_{22}$ and $R'_{22}$ are independently H or methyl;
- $R_{21}$ and $R_{25}$ is independently a linear or branched alkylene;
- $R_{23}$ and $R_{24}$ are independently H, alkyl or alkoxy, preferably alkyl;
- each d' is independently an integer from 0 to 2 with the proviso that not more than one d' is equal to 0, preferably each d' is equal to 1;
- each d" is independently an integer from 0 to 2 with the proviso that not more than one d" is equal to 0, preferably each d" is equal to 1;

- e’ and g’ are independently an integer from 2 to 4, in particular 2;
- f’ and h’ are independently an integer from 0 to 10, in particular from 1 to 6;

- a tetra-, penta- or hexavalent moiety according to formula (28):

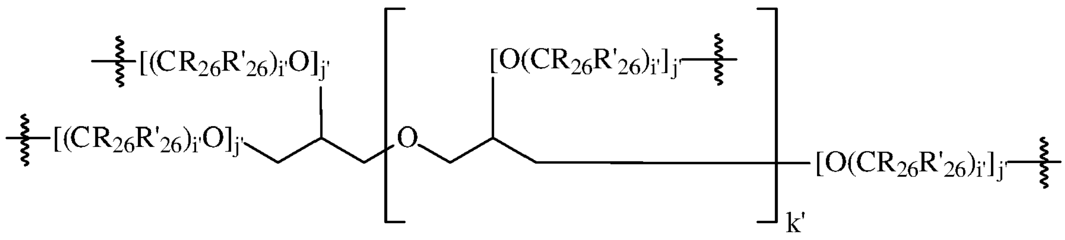

(28)

wherein:

- $R_{26}$ and $R'_{26}$ are independently H or methyl;
- each i’ is independently an integer from 2 to 4, in particular 2;
- each j’ is independently an integer from 0 to 10, in particular from 1 to 6;
- k’ is an integer from 1 to 3;

- a tri-, tetra-, penta- or hexavalent moiety according to formula (29):

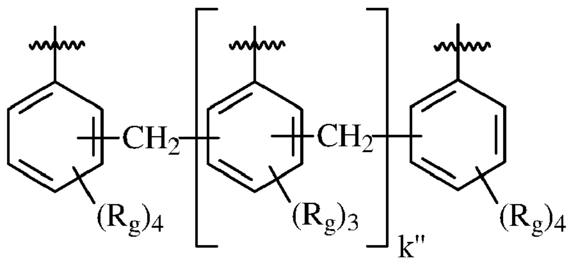

(29)

wherein

- each $R_g$ is independently selected from H, alkyl, cycloalkyl, aryl, alkaryl, aralkyl, alkoxy, -C(=O)O-Alkyl and a halogen atom;
- k" is an integer from 1 to 4.

- a hexavalent moiety according to any one of formulae (30) to (32):

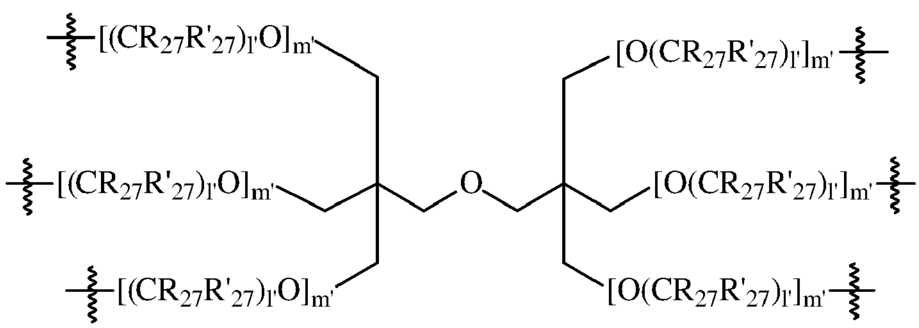

(30)

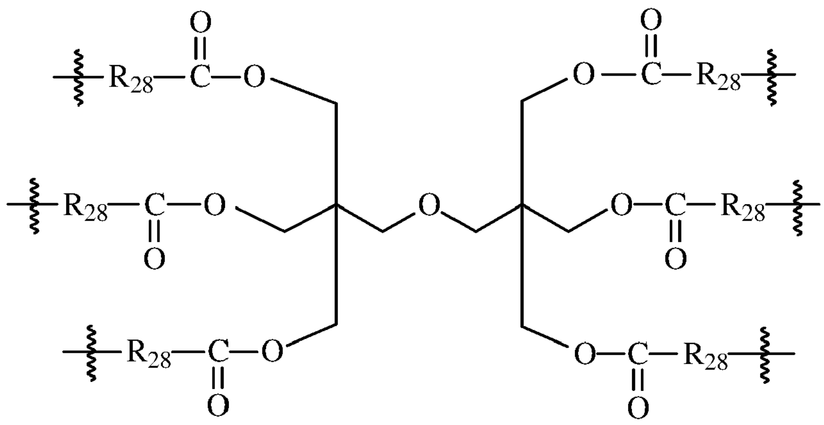

(31)

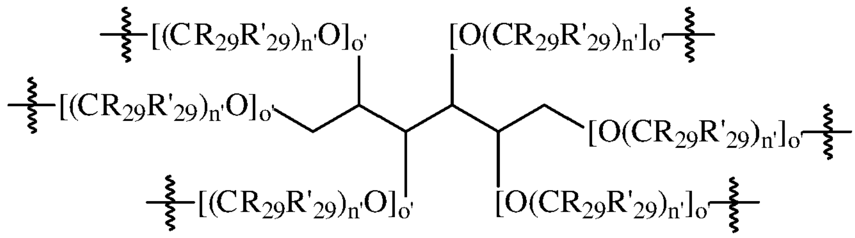

(32)

wherein

- $R_{27}$, $R'_{27}$, $R_{29}$ and $R'_{29}$ are independently H or methyl;
- each $R_{28}$ is independently a linear or branched alkylene;
- l' and n' are independently an integer from 2 to 4, in particular 2;
- m' and o' are independently an integer from 0 to 10, in particular from 1 to 6.

Aspect 22. The photoinitiator according to any one of Aspects 1 to 11 and 20, wherein Y and Z are both -O- and L and L' correspond to the following formula (33):

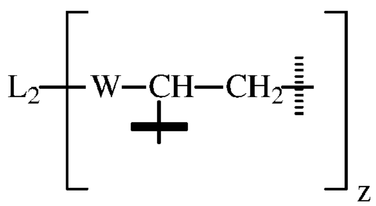

(33)

wherein

- $L_2$ is a z-valent linker;
- W is a bond, #-O-$CH_2$- or #-C(=O)-O-$CH_2$-;
- z is an integer of at least 2;
- the symbol # represents a point of attachment to $L_2$;
- the bold line represents a point of attachment to a (meth)acrylate group;
- the hashed line represents a point of attachment to a phosphine oxide-containing group or to a (meth)acrylate group, provided that at least one of the hashed lines represents a point of attachment to a phosphine oxide-containing group.

Aspect 23. The photoinitiator according to Aspect 22, wherein $L_2$ is selected from:

- a divalent moiety according to any one of formulae (8) to (17) as defined in Aspect 21;
- a trivalent moiety according to any one of formulae (18) to (23) as defined in Aspect 21;

- a tetravalent moiety according to any one of formulae (24) to (27) as defined in Aspect 21;
- a tetra-, penta- or hexavalent moiety according to formula (28) as defined in Aspect 21;
- a tri-, tetra-, penta- or hexavalent moiety according to formula (29) as defined in Aspect 21;
- a hexavalent moiety according to any one of formulae (30) to (32) as defined in Aspect 21.

Aspect 24. A process for the preparation of a photoinitiator of formula (1) or (2) according to any one of Aspects 1 to 8 and 10 to 23, wherein the process comprises reacting at least one precursor of formula (34) or (35) with at least one product of formula (36):

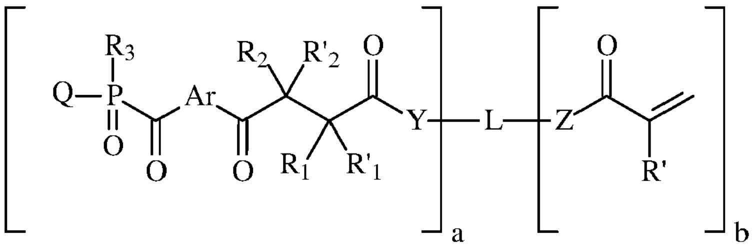
(1)

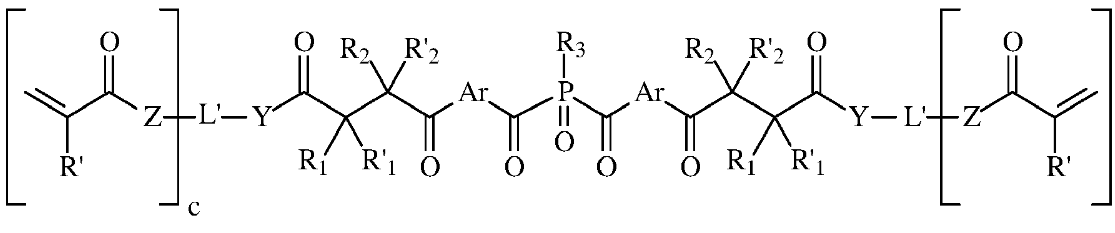
(2)

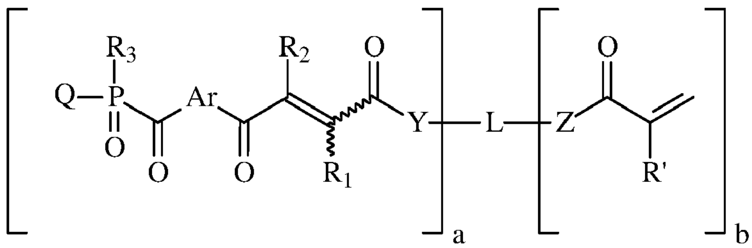
(34)

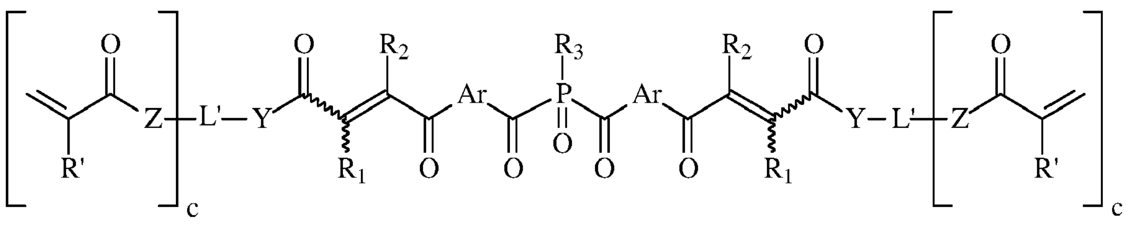
(35)

$R'_1$-$R'_2$ (36)

wherein Ar, $R_1$, $R_2$, $R_3$, $R'_1$, $R'_2$, Q, L, L' Y, Z, R', a, b and c are as defined in any one of Aspects 1 to 8 and 10 to 23; preferably the product of formula (36) is selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, N-methylpiperazine, oxazolidine, thiazolidine, thiomorpholine, azepane), more particularly a secondary cyclic amine (for example morpholine, piperidine, pyrrolidine, *N*-methylpiperazine, oxazolidine, thiazolidine, thiomorpholine, azepane);
- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);

- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile);
- a partially (meth)acrylated polyol;
- a partially (meth)acrylated polyamine.

Aspect 25. A precursor of formula (34) or (35):

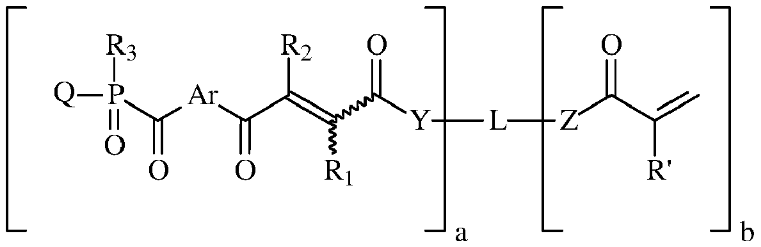

(34)

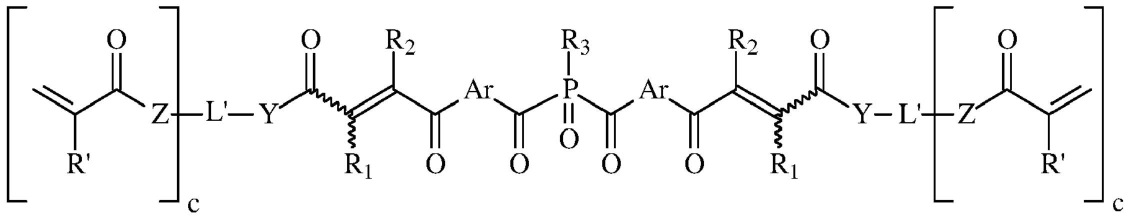

(35)

wherein Ar, $R_1$, $R_2$, $R_3$, Q, L, L', Y, Z, R', a, b and c are as defined in any one of Aspects 1 to 8 and 10 to 23.

Aspect 26. A process for the preparation of a precursor of formula (34) according to Aspect 25, wherein the process comprises:

- reacting at least one precursor of formula (37) with a compound of formula (38); or
- reacting at least one precursor of formula (37) with a compound of formula (39) and a compound of formula (40); or
- reacting at least one precursor of formula (37) with a compound of formula (41) and a compound of formula (40):

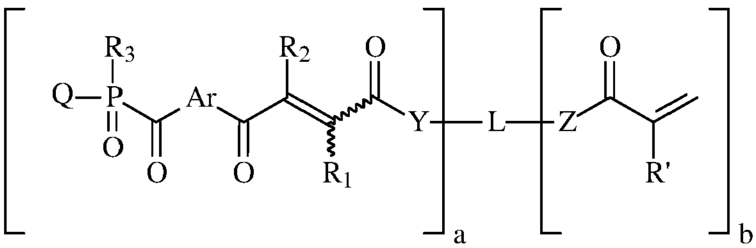

(34)

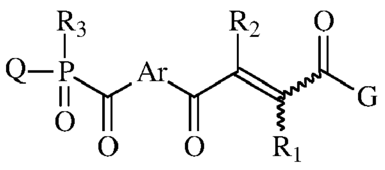 (37)

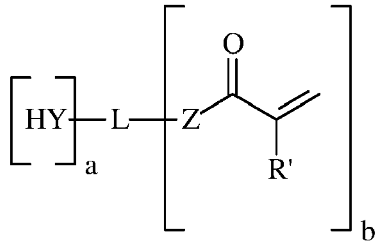 (38)

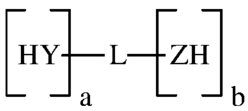 (39)

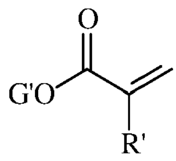 (40)

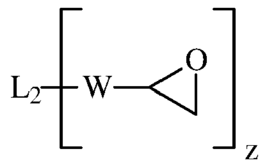 (41)

wherein:

- Ar, $R_1$, $R_2$, $R_3$, Q, L, $L_2$, W, Y, Z, R', a, b and z are as defined in any one of Aspects 1 to 8 and 10 to 23;
- G and G' are independently OH, a halogen atom or -O-C(=O)-J;
- J is alkyl or aryl, in particular tert-butyl.

Aspect 27. The process of Aspect 26, wherein the process comprises reacting at least one precursor of formula (37) with at least one compound of formula (38a)

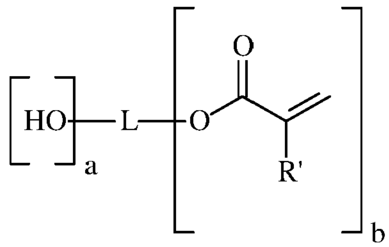 (38a)

wherein L, R', a and b are as defined in any one of Aspects 1, 20 and 21.

Aspect 28. The process of Aspect 26, wherein the process comprises reacting at least one precursor of formula (37) with at least one compound of formula (38b):

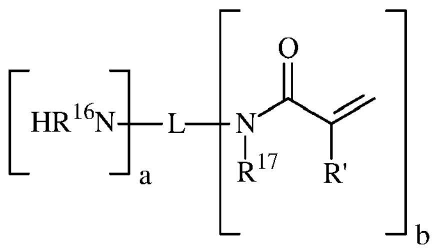 (38b)

wherein L, R', $R^{16}$, $R^{17}$, a and b are as defined in any one of Aspects 1, 20 and 21.

Aspect 29. The process of Aspect 26, wherein the process comprises reacting at least one precursor of formula (37) with at least one compound of formula (41) and at least one compound of formula (40):

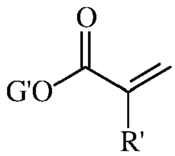
(40)

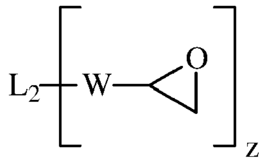
(41)

wherein G', $L_2$, R', W and z are as defined in any one of Aspects 1, 22, 23 and 26.

Aspect 30. A process for the preparation of a precursor of formula (35) according to Aspect 25, wherein the process comprises:

- reacting at least one precursor of formula (42) with a compound of formula (43); or
- reacting at least one precursor of formula (42) with a compound of formula (44) and a compound of formula (40); or
- reacting at least one precursor of formula (42) with a compound of formula (41) and a compound of formula (40):

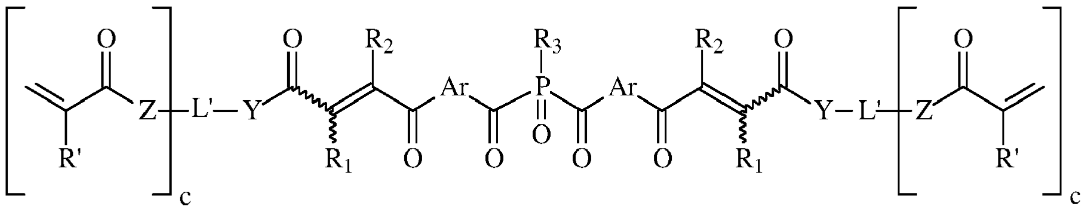
(35)

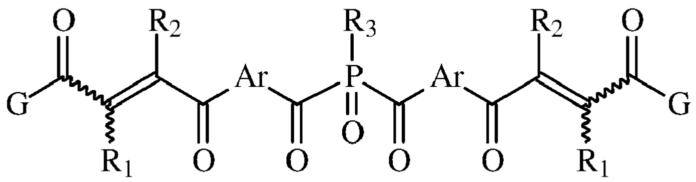
(42)

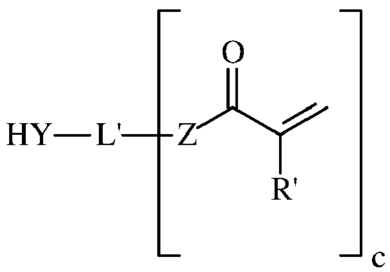
(43)

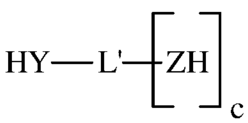
(44)

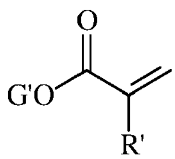
(40)

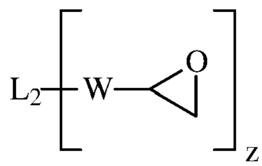
(41)

wherein
- Ar, $R_1$, $R_2$, $R_3$, L', $L_2$, W, Y, Z, R', c and z are as defined in any one of Aspects 1 to 8 and 10 to 23;
- G and G' are independently OH, a halogen atom or -O-C(=O)-J;
- J is alkyl or aryl, in particular tert-butyl.

Aspect 31. The process of Aspect 30, wherein the process comprises reacting at least one precursor of formula (42) with at least one compound of formula (43a)

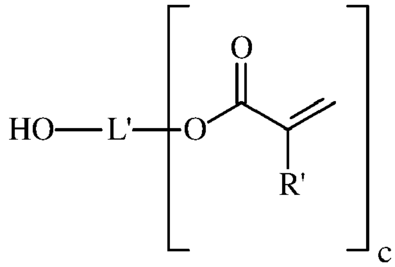

(43a)

wherein L', R' and c are as defined in any one of Aspects 1, 20 and 21.

Aspect 32. The process of Aspect 30, wherein the process comprises reacting at least one precursor of formula (42) with at least one compound of formula (43b):

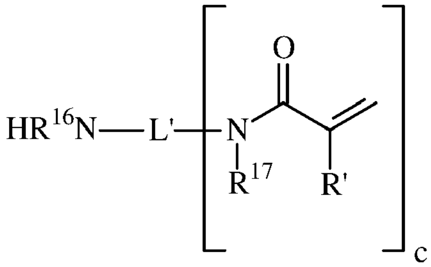

(43b)

wherein L, R', $R^{16}$, $R^{17}$, a and b are as defined in any one of Aspects 1, 20 and 21.

Aspect 33. The process of Aspect 30, wherein the process comprises reacting at least one precursor of formula (42) with at least one compound of formula (41) and at least one compound of formula (40):

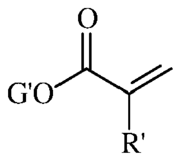

(40)

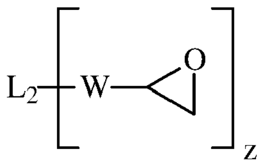

(41)

wherein G', $L_2$, R', W and z are as defined in any one of Aspects 1, 22, 23 and 26.

Aspect 34. A process for the preparation of a photoinitiator of formula (1) according to any one of Aspects 1 to 8 and 10 to 23, wherein the process comprises:

- reacting at least one precursor of formula (45) with at least one compound of formula (38); or
- reacting at least one precursor of formula (45) with at least one compound of formula (39) and at least one compound of formula (40); or
- reacting at least one precursor of formula (45) with at least one compound of formula (41) and at least one compound of formula (40);

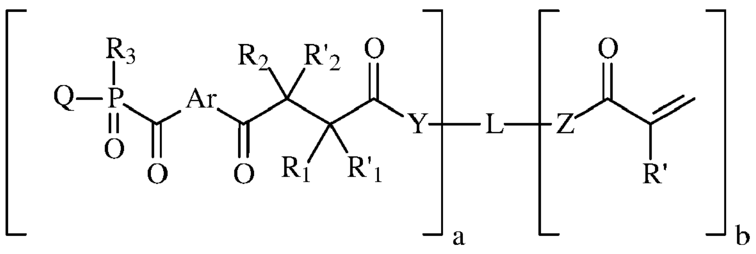

(1)

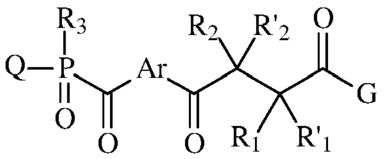 (45) 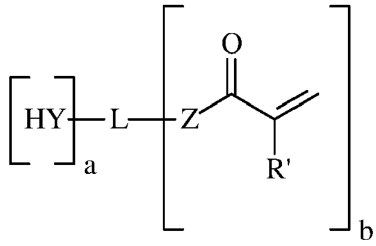 (38)

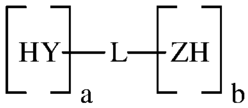 (39) 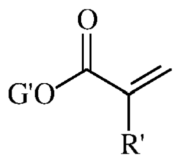 (40) 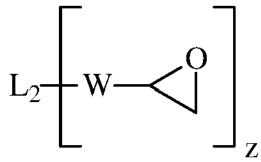 (41)

wherein:

- Ar, $R_1$, $R_2$, $R'_1$, $R'_2$, $R_3$, Q, L, $L_2$, W, Y, Z, R', a, b and z are as defined in any one of Aspects 1 to 8 and 10 to 23;
- G and G' are independently OH, a halogen atom or -O-C(=O)-J;
- J is alkyl or aryl, in particular tert-butyl.

Aspect 35. The process of Aspect 34, wherein the process comprises reacting at least one precursor of formula (45) with at least one compound of formula (35a)

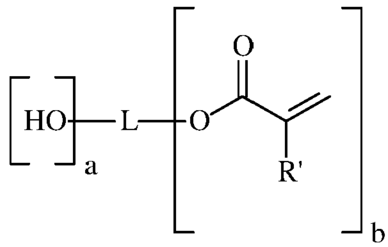 (35a)

wherein L, R', a and b are as defined in any one of Aspects 1, 20 and 21.

Aspect 36. The process of Aspect 34, wherein the process comprises reacting at least one precursor of formula (52) or (53) with at least one compound of formula (38b):

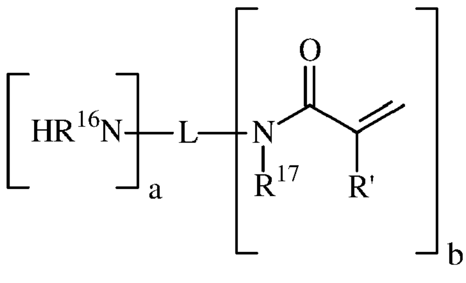 (38b)

wherein L, R', $R^{16}$, $R^{17}$, a and b are as defined in any one of Aspects 1, 20 and 21.

Aspect 37. The process of Aspect 34, wherein the process comprises reacting at least one precursor of formula (45) with at least one compound of formula (41) and at least one compound of formula (40):

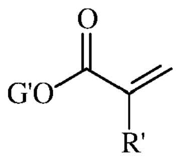 (40) 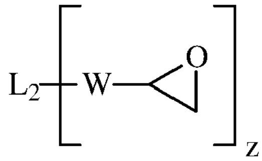 (41)

wherein G', $L_2$, R', W and z are as defined in any one of Aspects 1, 22, 23 and 26.

Aspect 38. A process for the preparation of a photoinitiator of formula (2) according to according to any one of Aspects 1 to 8 and 10 to 23, wherein the process comprises:

- reacting at least one precursor of formula (46) with a compound of formula (43); or
- reacting at least one precursor of formula (46) with a compound of formula (44) and a compound of formula (40); or
- reacting at least one precursor of formula (46) with a compound of formula (41) and a compound of formula (40):

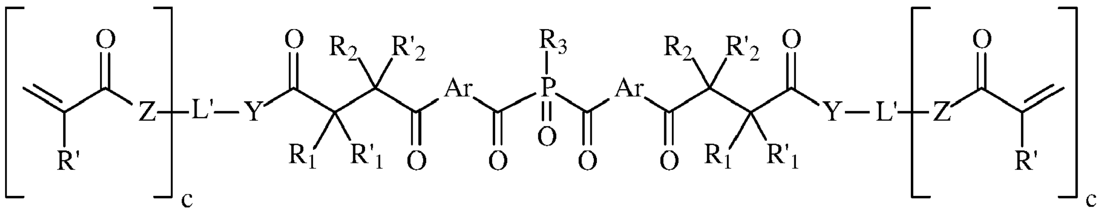 (2)

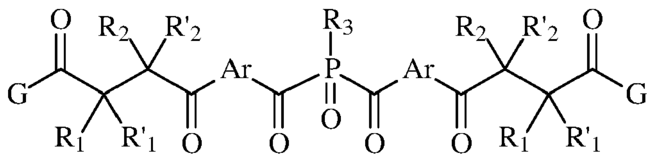 (46)

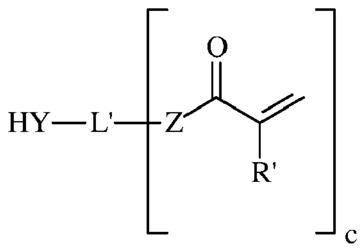 (43)

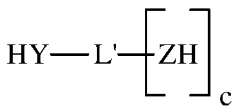 (44) 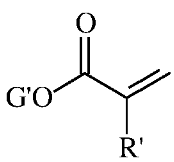 (40) 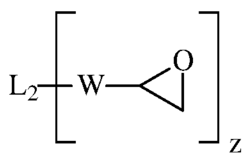 (41)

wherein

- Ar, $R_1$, $R_2$, $R_3$, $R'_1$, $R'_2$, L', $L_2$, W, Y, Z, R', c and z are as defined in any one of Aspects 1 to 8 and 10 to 23;
- G and G' are independently OH, a halogen atom or -O-C(=O)-J;
- J is alkyl or aryl, in particular tert-butyl.

Aspect 39. The process of Aspect 38, wherein the process comprises reacting at least one precursor of formula (46) with at least one compound of formula (43a)

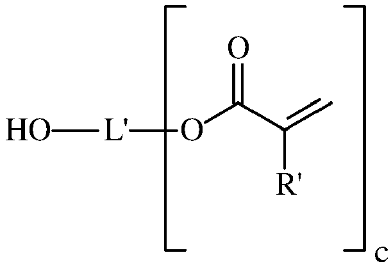

(43a)

wherein L', R' and c are as defined in any one of Aspects 1, 20 and 21.

Aspect 40. The process of Aspect 38, wherein the process comprises reacting at least one precursor of formula (46) with at least one compound of formula (43b):

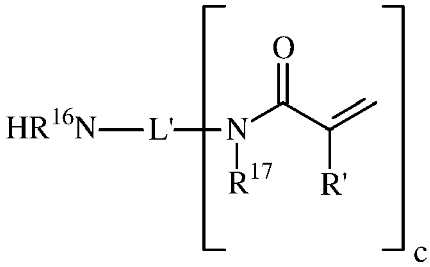

(43b)

wherein L, R', $R^{16}$, $R^{17}$, a and b are as defined in any one of Aspects 1, 20 and 21.

Aspect 41. The process of Aspect 38, wherein the process comprises reacting at least one precursor of formula (46) with at least one compound of formula (41) and at least one compound of formula (40):

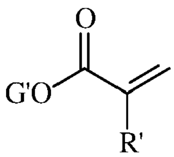

(40)

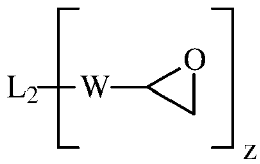

(41)

wherein G', $L_2$, R', W and z are as defined in any one of Aspects 1, 22, 23 and 26.

Aspect 42. A process for the preparation of a photoinitiator of formula (6) according to Aspect 9, wherein the process comprises reacting at least one precursor of formula (37) with at least one product of formula (47) and at least one product of formula (40):

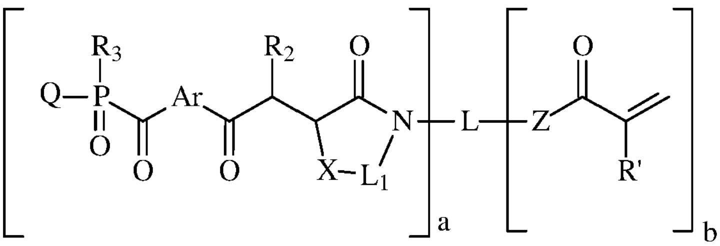

(6)

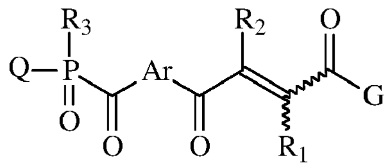

(37)

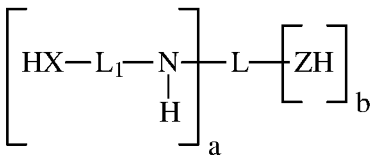

(47)

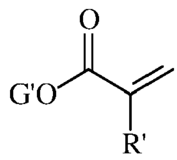

(40)

wherein:

- Ar, $R_1$, $R_2$, $R_3$, Q, L, Z, R', a and b are as defined in any one of Aspects 1 to 8 and 10 to 23;
- X and $L_1$ are as defined in Aspect 9,
- G and G' are independently OH, a halogen atom or -O-C(=O)-J;
- J is alkyl or aryl, in particular tert-butyl.

Aspect 43. A process for the preparation of a photoinitiator of formula (7) according to Aspect 9, wherein the process comprises reacting at least one precursor of formula (38) with at least one product of formula (48) and at least one product of formula (40):

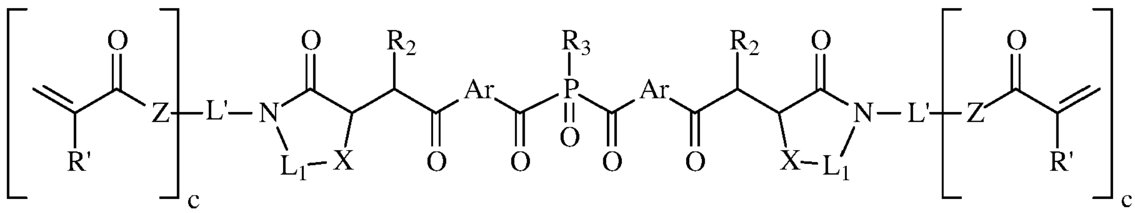

(7)

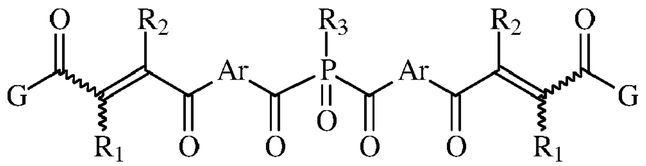

(38)

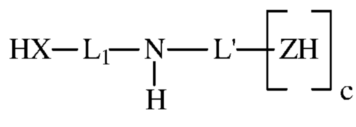

(48)

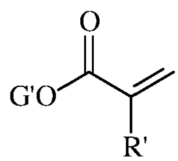

(40)

wherein:

- Ar, $R_1$, $R_2$, $R_3$, L', Z, R' and c are as defined in any one of Aspects 1 to 8 and 10 to 23;
- X and $L_1$ are as defined in Aspect 9,
- G and G' are independently OH, a halogen atom or -O-C(=O)-J;
- J is alkyl or aryl, in particular tert-butyl.

Aspect 44. A photoinitiator composition comprising:

- a mixture of at least two photoinitiators of formula (1) according to any one of Aspects 1 to 23;

- a mixture of at least two photoinitiators of formula (2) according to any one of Aspects 1 to 23;
- a mixture of at least one photoinitiator of formula (1) according to any one of Aspects 1 to 23 and at least one precursor of formula (34) according to Aspect 25; or
- a mixture of at least one photoinitiator of formula (2) according to any one of Aspects 1 to 23 and at least one precursor of formula (35) according to Aspect 25.

Aspect 45. A photoinitiator composition comprising a photoinitiator of formula (1) or (2) according to any one of Aspects 1 to 23 and a photoinitiator other than a photoinitiator of formula (1) or (2), in particular a photoinitiator selected from SpeedCure MBF (methyl benzoylformate), SpeedCure 73 (2-hydroxy-2-methyl-1-phenylpropanone), or a polymeric benzophenone.

Aspect 46. A process for photopolymerizing one or more ethylenically unsaturated compounds comprising contacting one or more ethylenically unsaturated compounds with a photoinitiator of formula (1) or (2) according to any one of Aspects 1 to 23 or a photoinitiator composition according to Aspect 44 or 45, and irradiating the mixture, in particular with UV, near-UV, visible, infrared and/or near-infrared radiation.

Aspect 47. A curable composition comprising:

c) a photoinitiator of formula (1) or (2) according to any one of Aspects 1 to 23 or a photoinitiator composition according to Aspect 44 or 45; and
d) an ethylenically unsaturated compound.

Aspect 48. The curable composition of Aspect 47, wherein the composition further comprises a cationically-polymerizable compound, in particular a cationically polymerizable compound selected from epoxides, oxetanes, oxolanes, cyclic acetals, cyclic lactones, thiiranes, thiethanes, spiro orthoesters, derivatives thereof and mixtures thereof.

Aspect 49. The curable composition of Aspect 47 or 48, wherein the composition further comprises a polyol and/or polythiol.

Aspect 50. The curable composition of any one of Aspects 47 to 49, wherein the composition further comprises an additive, in particular an additive selected from sensitizers, stabilizers, antioxidants, light blockers, polymerization inhibitors, foam inhibitors, flow or leveling agents, colorants, pigments, dispersants (wetting agents, surfactants), slip additives, fillers, thixotropic agents, matting agents, impact modifiers, waxes and mixtures thereof.

Aspect 51. The curable composition of any one of Aspects 47 to 50, wherein the composition is an ink composition, a coating composition, an adhesive composition, a sealant composition, a molding composition, a dental composition, a nail polish composition or a 3D-printing composition.

Aspect 52. A process for the preparation of a cured product, comprising curing the curable composition according to any one of Aspects 47 to 51, preferably by exposing the curable composition to radiation such as UV, near-UV, visible, infrared and/or near-infrared radiation.

Aspect 53. A process of 3D printing comprising printing a 3D article with the composition according to any one of Aspects 47 to 51, in particular layer by layer or continuously.

Aspect 54. A process of inkjet printing comprising jetting the curable composition according to any one of Aspects 47 to 51 onto a substrate.

Aspect 55. A process of coating a nail, wherein the process comprises applying the curable composition according to any one of Aspects 47 to 51 on a nail, and curing the composition on the nail.

Aspect 56. A use of a photoinitiator of formula (1) or (2) according to any one of Aspects 1 to 23 or a photoinitiator composition according to Aspect 44 or 45, as a photoinitiator or a photoinitiating system in a radiation curable composition, preferably in a UV or LED-curable composition.

Aspect 57. A use of a photoinitiator of formula (1) or (2) according to any one of Aspects 1 to 23 or a photoinitiator composition according to Aspect 44 or 45, to cure one or more ethylenically unsaturated compounds.

Aspect 58. A use of a photoinitiator of formula (1) or (2) according to any one of Aspects 1 to 23 or a photoinitiator composition according to Aspect 44 or 45, to obtain a cured product having a reduced amount of extractables.

Within this specification, embodiments have been described in a way which enables a clear and concise specification to be written, but it is intended and will be appreciated that embodiments may be variously combined or separated without departing from the invention. For example, it will be appreciated that all preferred features described herein are applicable to all aspects of the invention described herein.

Although the invention is illustrated and described herein with reference to specific embodiments, the invention is not intended to be limited to the details shown. Rather, various modifications may be made in the details within the scope and range of equivalents of the claims and without departing from the invention.

## EXAMPLES

The following examples illustrate the invention without limiting it.

### Example 1: Synthesis of Precursor 1

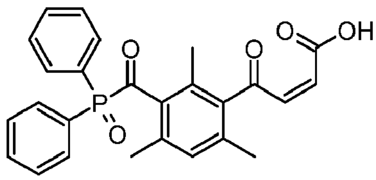

To an ice-cooled solution of 2,4,6-trimethylbenzoyldiphenylphosphine oxide (SpeedCure® TPO from Arkema - 85.0 g, 244 mmol) and maleic anhydride (28.7 g, 293 mmol) in dichloromethane (850 mL) was added aluminium chloride (129 g, 968 mmol) portion-wise over 1 h while maintaining the reaction temperature at 5-10°C. The resulting deep red solution was heated at 30-32°C for 48 h. The mixture was allowed to cool to 20°C, then was poured into ice water (approx. 1 L) with stirring. Dichloromethane was removed from the biphasic mixture by concentration under reduced pressure, then the resulting aqueous slurry was filtered to obtain the crude solid product. The product was washed repeatedly with water, then was suspended in toluene (500 mL) and filtered. The obtained solid was thoroughly dried in a vacuum oven at 60°C, giving **Precursor 1** as a pale yellow powder (97 g, 89%).

### Example 2: Synthesis of Precursor 2

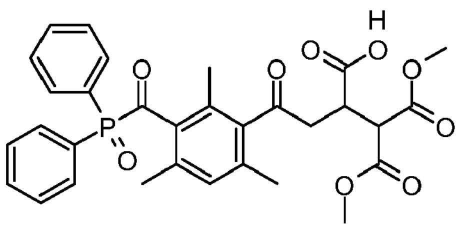

To a solution of **Precursor 1** (20.00 g, 44.83 mmol) and dimethyl malonate (5.92 g, 44.83 mmol) in Toluene (200 mL) was added potassium carbonate (6.20 g, 44.83 mmol) and the resulting suspension was heated to 70°C for 4 h. The mixture was allowed to cool to 40°C and the reaction slowly quenched with 1M hydrochloric acid (150 mL). The layers were separated, and the organic layer was washed with water (2 × 100 mL) and brine (50 mL) then was dried ($MgSO_4$), filtered and concentrated under reduced pressure to give **Precursor 2** as a yellow powder (25.04 g, 97%).

### Example 3: Synthesis of Photoinitiator 1

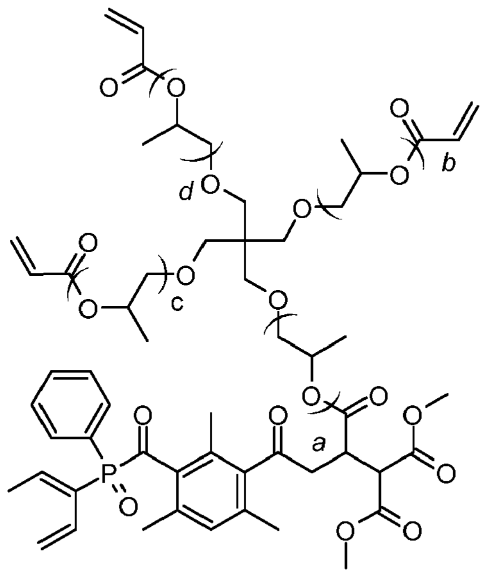

To a solution of **Precursor** 2 (30.0 g, 51.85 mmol), propoxylated pentaerythritol triacrylate (Sartomer resin SR043, 24.7 g, approx. 51.85 mmol), 4-Methoxy phenol (0.15 g, 1.21 mmol), Butylated hydroxytoluene (0.03 g, 0.14 mmol) in toluene (350 mL) was added methanesulphonic acid (1.48 g, 15.40 mmol) and the resulting mixture was heated at reflux temperature for 7 h, while water was continuously removed using a Dean-Stark apparatus. The mixture was allowed to cool to room temperature, then the reaction solution was washed successively with 1M hydrochloric acid (2 × 75 mL), water (75 mL), saturated sodium bicarbonate solution (2 × 75 mL) and brine (50 mL). The organic phase was dried ($MgSO_4$), filtered and concentrated under reduced pressure to give **Photoinitiator 1** as a yellow liquid (31.6 g, 57%).

**Example 4: Alternative Synthesis of Photoinitiator 1**

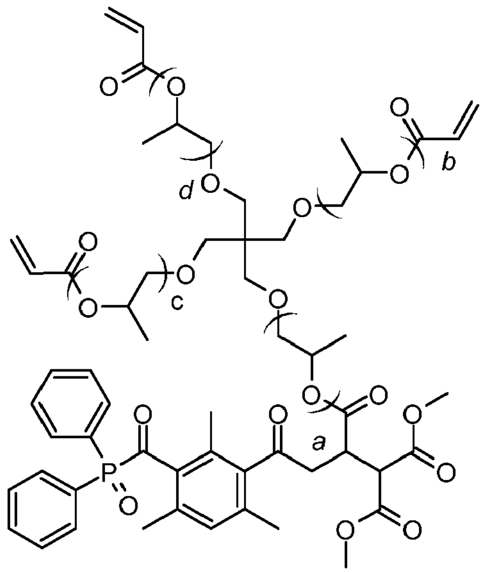

To a solution of **Precursor 2** (30 g, 51.85 mmol), Propoxylated pentaerythritol (Perstorp Polyol 4525, 22.3g, 51.85 mmol), Acrylic acid (11.2g, 155.5 mmol), 4-Methoxy phenol (0.15 g, 1.21 mmol) and Butylated hydroxytoluene (0.03 g, 0.14 mmol) in toluene (350 mL) was added methanesulphonic acid (1.48 g, 15.40 mmol) and the resulting mixture was heated at reflux temperature for 7 h, while water was continuously removed using a Dean-Stark apparatus. The mixture was allowed to cool to room temperature, then the reaction solution was washed successively with 1M hydrochloric acid (2 × 75 mL), water (75 mL), saturated sodium bicarbonate solution (2 × 75 mL) and brine (50 mL). The organic phase was dried ($MgSO_4$), filtered and concentrated under reduced pressure to give **Photoinitiator 1** as a yellow liquid (48.65 g,

77%).

**Example 5: Synthesis of Precursor 3**

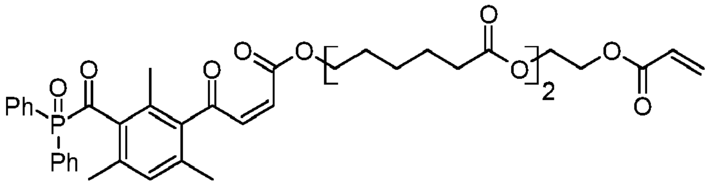

To a stirred suspension of **Precursor 1** (30.0 g, 67.3 mmol) in toluene (300 mL) was added triethylamine (40.0 mL, 287 mmol) at 25°C and the resulting mixture was cooled to 0-5°C in an ice bath. Trimethylacetyl chloride (8.23 mL, 67.3 mmol) was added and the resulting suspension was stirred at 0-5°C for 30 min. Polycaprolactone monoacrylate (Sartomer SR495B, 23.2 g, approx. 67.3 mmol) was added in one portion and the mixture was removed from the ice bath and allowed to warm to 25°C over 2 h. Water (200 mL) was added and the layers were separated. The organic layer was washed successively with 1M hydrochloric acid (100 mL), saturated sodium bicarbonate solution (100 mL) and brine (100 mL), then was dried ($MgSO_4$), filtered and concentrated under reduced pressure to give **Precursor 3** as an orange liquid (44.0 g, 85%).

**Example 6: Synthesis of Precursor 4 and Photoinitiator 3**

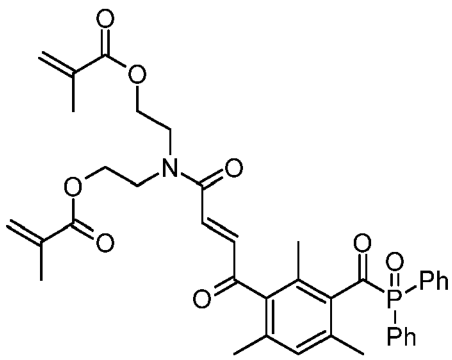

**Precursor 4**

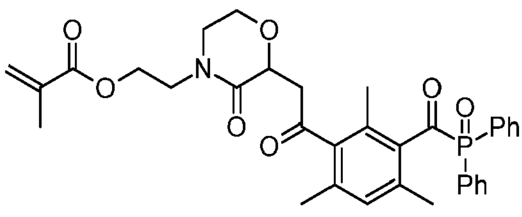

**Photoinitiator 3**

To a stirred suspension of **Precursor 1** (50.0 g, 112 mmol) in toluene (500 ml) was added triethylamine (65.0 mL, 467 mmol) at 25°C and the resulting mixture was cooled to 0-5°C in an ice bath. Trimethylacetyl chloride (13.7 mL, 112 mmol) was added and the resulting suspension was stirred at 0-5°C for 30 min. Diethanolamine (11.8 g, 112 mmol) was added in one portion and the mixture was allowed to warm to 25°C over 1 h. Water (500 mL) and ethyl acetate (500 mL) were added and the layers were separated. The organic phase was concentrated under reduced pressure, and the residue was re-suspended in toluene (500 ml). A colourless solid precipitated, which was collected and washed on the filter with toluene (100 mL). The solid was dried thoroughly under vacuum, giving 28.6 g of a diol intermediate, 25.0 g (46.9 mmol) of which was suspended in toluene (125 mL). Triethylamine (16.4 mL, 117 mmol) was added, followed by methacrylic anhydride (14.5 mL, 93.8 mmol) and the resulting mixture was heated at 85°C for 18 h. The mixture was allowed to cool to 25°C, then water (100 ml) was added and the layers were separated. The organic layer was washed successively with 1M hydrochloric acid (100 mL), 10% sodium carbonate solution (100 mL) and brine (50 mL) then was dried ($MgSO_4$), filtered

and concentrated under reduced pressure to give the crude product mixture containing **Precursor 4** and **Photoinitiator 3.** **Precursor 4** was isolated by column chromatography (eluting with 1:1 petrol-tert-butyl methyl ether), giving a colourless liquid (2.40 g, 7.6%). **Photoinitiator 3** was isolated by column chromatography (eluting with tert-butyl methyl ether), giving a glassy solid (16.4 g, 58%).

**Example 7: Synthesis of Precursor 5**

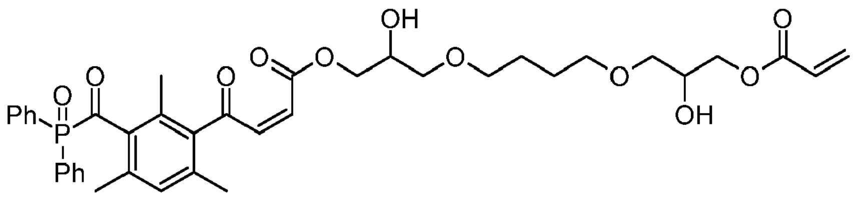

To a stirred solution of **Precursor 1** (1.78 g, 3.99 mmol) and 1,4-butanediol diglycidyl ether (2.33 g, 2.88 mmol) was added acrylic acid (0.87 g, 12.1 mmol) and the resulting suspension was heated at 120°C for 1 h, after which time more acrylic acid (0.9 mL) was added and heating at 120°C was continued for a further 3 h. The mixture was allowed to cool to 25°C, then ethyl acetate (50 mL) and water (50 mL) were added, and the layers were mixed well and separated. The organic layer was washed with saturated sodium bicarbonate solution (50 mL) and brine (50 mL), then was dried ($MgSO_4$), filtered and concentrated under reduced pressure to give 4.8 g crude product as a pale orange liquid, 3.8 g of which was purified by column chromatography (eluting with 1:2 petrol - ethyl acetate) to give **Precursor 5** as a pale-yellow liquid (1.0 g, 44%).

**Example 8: Synthesis of Precursor 6**

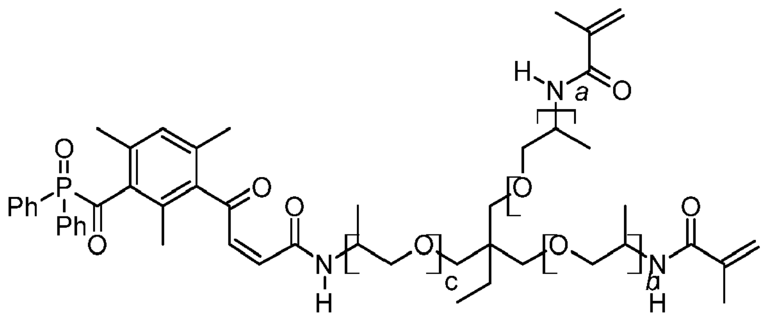

To a solution of Jeffamine T403 (24.7 g, 56.0 mmol) in toluene (170 mL) was added methacrylic anhydride (16.7 mL, 112 mmol) and the resulting mixture was stirred at 25°C for 30 min. In a separate reaction vessel, triethylamine (33.0 mL, 235 mmol), was added to a stirred suspension of **Precursor 1** (25.0 g, 56.0 mmol) in toluene (200 mL) and the resulting mixture was cooled to 0-5°C in an ice bath. Trimethylacetyl chloride (6.90 mL, 56.0 mmol) was added and the resulting suspension was stirred at 0-5°C for 30 min. The Jeffamine/methacrylic anhydride solution was added over a few minutes, then the resulting mixture was allowed to warm to 25°C over 2 h. Water (200 mL) was added and the layers were separated. The organic layer was washed successively with 1M hydrochloric acid (200 mL), saturated sodium bicarbonate solution (100 mL) and brine (50 mL), then was dried, filtered and concentrated under reduced pressure to give **Precursor 6.**

**Example 9: Synthesis of Photoinitiator 4**

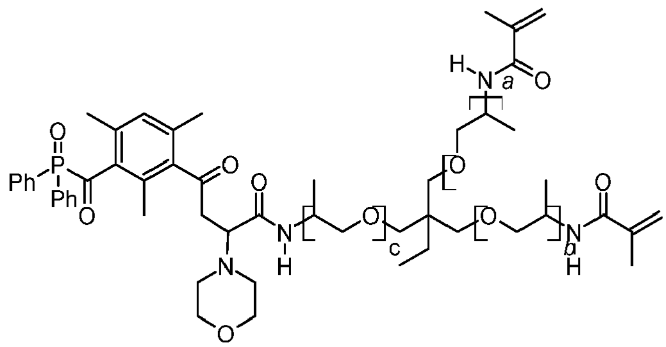

To a stirred solution of **Precursor 6** (45 g, 2.6 mmol) in methanol (500 mL) was added morpholine (25 mL, 28 mmol) and the resulting mixture was stirred at 25°C for 4 hr. After this time, the reaction mixture was concentrated to remove the methanol, before re-dissolving in ethyl acetate (150 mL) and washed successively with water (3 × 100 mL) and brine (50 mL). The organic layer was dried over magnesium sulfate and concentrated to give **Photoinitiator 4.**

**Example 10: Synthesis of Precursor 7**

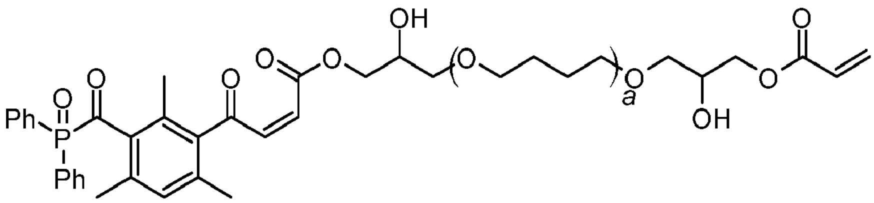

A mixture of poly(tetramethyleneoxid)diglycidylether (111.6 g, 0,13 mole), **Precursor 1** (25,5 g, 0,06 mole), acrylic acid (12,3 g, 0,17 mole), 4-methoxyphenol (0,3 g), butylhydroxytoluene (0,15 g), phenothiazine (0,01 g) and tetraethylammonium bromide (0,15 g) was heated at 125°C. Acrylic acid is added to the mixture when acid value was < 8 mg KOH/g. When epoxy value was < 9 mg KOH/g the product was filtered to give **Precursor 7.**

**Example 11: Synthesis of Precursor 8**

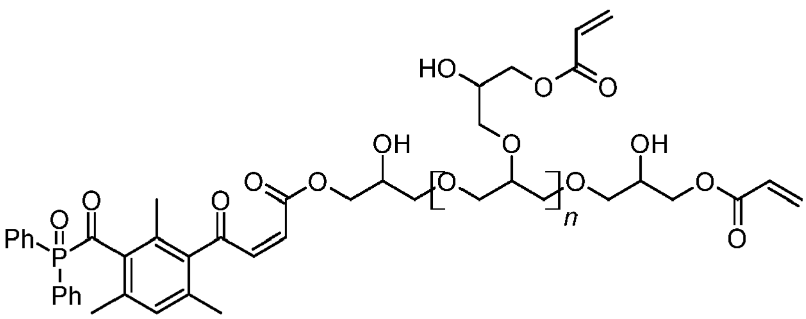

A mixture of polyglycerol-3-polyglycidyether (57,4 g, 0,12 mole), **Precursor 1** (25,6 g, 0,06 mole), acrylic acid (16,6 g, 0,23 mole), 4-methoxyphenol (0,2 g), butylhydroxytoluene (0,1 g), phenothiazine (0,01 g) and tetraethylammonium bromide (0,1 g) was heated at 125°C. Acrylic acid was added to the mixture when acid value was < 14 mg KOH/g. When epoxy value was < 7 mg KOH/g the product was filtered to give **Precursor 8.**

**Example 12: Synthesis of Precursor 9**

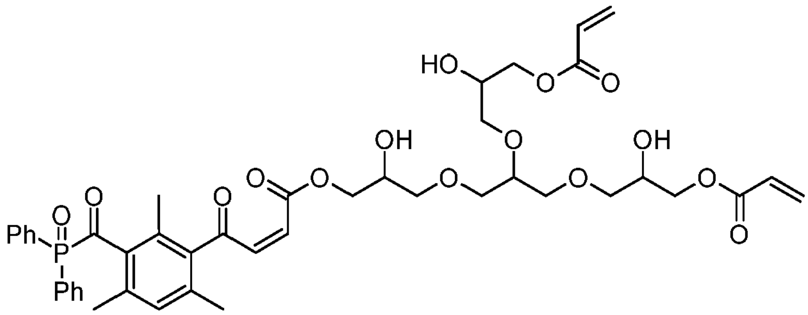

A mixture of glycerol triglycidyether (54,1 g, 0,12 mole), **Precursor 1** (25,6 g, 0,06 mole), acrylic acid (17,9 g, 0,25 mole), 4-methoxyphenol (0,2 g), butylhydroxytoluene (0,1 g), phenothiazine (0,01 g) and tetraethylammonium bromide (0,1 g) was heated at 125°C. Acrylic acid was added to the mixture when acid value was < 14 mgKOH/g. When epoxy value was < 9 mg KOH/g the product was filtered to give Precursor 9.

**Example 13: Synthesis of Photoinitiator 5**

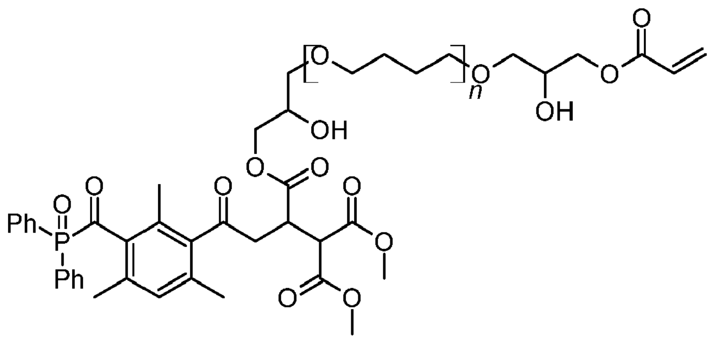

A mixture of poly(tetramethyleneoxid)diglycidylether (75,6,1 g, 0,09 mole), **Precursor 2** (19,4 g, 0,04 mole), acrylic acid (8,5 g, 0,12 mole), 4-methoxyphenol (0,2 g), butylhydroxytoluene (0,1 g), phenotiazine (0,01 g) and tetraethylammonium bromide (0,1 g) was heated at 125°C. Acrylic acid was added to the mixture when acid value was < 5 mgKOH/g. When epoxy value was < 10 mgKOH/g the product is filtered to give **Photoinitiator 5.**

**Example 14: Curing Experiments**

The following examples illustrate the high curing speed of the photoinitiators disclosed in this invention in comparison with previously disclosed photoinitiators. Testing Protocol: Formulations were prepared by combining all materials listed in Tabel 1 in the given proportions (in % by weight based on the total weight of the formulation) and then stirring at 30-40°C until the samples were fully homogeneous; the formulations were then allowed to cool to 20°C. The amount of phosphine oxide photoinitiator was chosen to ensure that the same approximate concentration of active phosphine oxide was present in each formulation. All components remained fully dissolved in the resin formulations throughout these experiments.

| | **F1** | **F2** | **F3** | **F4** | **F5** | **F6** |
|---|---|---|---|---|---|---|
| Speedcure TPO | 5 | 5 | | | | |
| **Photoinitiator 1 (PRO44001)** | | | 15.4 | 15.4 | | |
| **Photoinitiator 5 (PRO23049)** | | | | | 26.3 | 26.3 |
| Acrylated amine synergist LM7401 | | 8 | | 8 | | 8 |
| Ethoxylated bisphenol A diacrylate | 66.5 | 60.9 | 59.2 | 53.6 | 51.6 | 46.0 |
| Tripropylene glycol diacrylate | 28.5 | 26.1 | 25.4 | 23.0 | 22.1 | 19.7 |

For each sample formulation, a 50 μm film was prepared on the mounted ATR sample stage of a Thermo Scientific Nicolet iS50 FTIR Spectrometer with the aid of a suitable K-bar, then curing of the films was achieved using an Omnicure LX500 spot curing system fitted with a 385 nm LED lamp while FT-IR data was collected in real-time using the same FT-IR instrument. Acrylate double bond conversion - and therefore the extent of acrylate curing, both of the polymerizable photoinitiators themselves, and the ethylenically unsaturated compounds in which they were dissolved - was determined by measuring the decreasing intensity of the absorption band at ~810 $cm^{-1}$ with respect to the carbonyl band at -1724 $cm^{-1}$ (which was not expected to change as the polymerisation reaction progressed), over a period of 30 seconds from the moment the lamp was turned on. The experiment was performed twice for each formulation.

Conversion was calculated using the following formula:

$$\text{Conversion} = [1-(A_t\text{-}B_t)/(A_{t0}/B_{to})]*100$$

where

$A_t$ = Intensity of the band at ~810 $cm^{-1}$ at the given time point
$B_t$ = Intensity of the band at ~1724 $cm^{-1}$ at the given time point
$A_{t0}$ = the intensity of the band at 810 $cm^{-1}$ at t = 0 (before the lamp was turned on)
$B_{t0}$ = the intensity of the band at 1724 $cm^{-1}$ at t = 0.

The conversion obtained with Formulations F1, F2, F3 and F4 are given in Figure 1. The conversion obtained with Formulations F1, F2, F5 and F6 are given in Figure 2. In each case, the polymerizable photoinitiator disclosed of the invention is compared to SpeedCure TPO, both in the presence and absence of acrylated amine synergist LM7401.

As can be seen from these results, the phosphine oxides disclosed in this invention are effective photoinitiators for the depth curing of ethylenically unsaturated compounds under LED lamp conditions.

**Example 15: Extractables**

The curing paper was first dried by passing under mercury lamp 5 times at 5.0 m/min with the lamp at 50% intensity. The weight of the paper was recorded. 50 μm films were cured under mercury (lamp 50% intensity, belt speed 5.0 m/min) and the weight of the paper rerecorded. The films were placed in heavy wall pressure vessels with 15 mL of solvent (acetonitrile or ethanol) and placed in the oven at 60°C for 10 days. After cooling to room temperature, the vials were opened, and the extraction liquid filtered through a 0.45 μm filter before being analysed. Extractable species were quantified using an MS-suitable HPLC method which was developed for analysis using calibration curves for all extractable species.

The extractable of concern was focused on mesitaldehyde, previously identified as a photolytic decomposition product of TPO, TPO-L and BPO by Scarsella et al. (Molecules 2019, 24, 3592). It was found to migrate at high concentrations and at this time has not been evaluated for in vivo safety upon consumption or contact.

Formulation:

| Migration Formulation | % by weight in Formula | | |
|---|---|---|---|
| | Resin LM5302 | Speedcure 73 | Phosphine Oxide |
| Speedcure 73 | 95% | 5% | 0% |
| Speedcure TPO | 94% | 1% | 5% |
| Speedcure BPO | 94% | 1% | 5% |
| Speedcure TPO-L | 94% | 1% | 5% |
| Photoinitiator 1 | 74% | 1% | 25% |
| Dried Blank Paper | 0% | 0% | 0% |

LM5302 is an ethoxylated trimethylolpropane triacrylate available from Arkema.

Results:

| Migration Formulation | Extraction Solvent | Concentrations of extractables (ppm) |
|---|---|---|
| | | Mesitaldehyde |
| Speedcure 73 | Acetonitrile | n/d |
| Speedcure 73 | Ethanol | n/d |
| Speedcure TPO | Acetonitrile | 293 |
| Speedcure TPO | Ethanol | 316 |
| Speedcure BPO | Acetonitrile | 713 |
| Speedcure BPO | Ethanol | 656 |
| Speedcure TPO-L | Acetonitrile | 396 |
| Speedcure TPO-L | Ethanol | 413 |
| Omnipol TP | Acetonitrile | 364 |
| Omnipol TP | Ethanol | 327 |
| Photoinitiator 1 | Acetonitrile | n/d |
| Photoinitiator 1 | Ethanol | n/d |
| Blank Paper | Acetonitrile | n/d |
| Blank Paper | Ethanol | n/d |

## Claims

**1.** A photoinitiator according to formula (1) or (2):

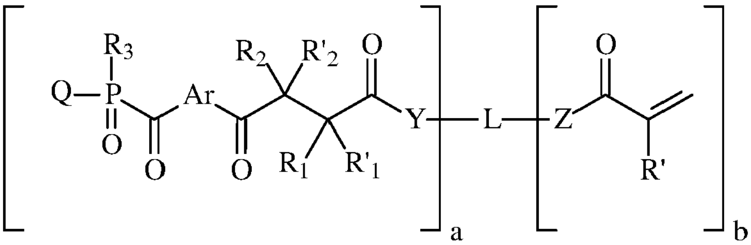

(1)

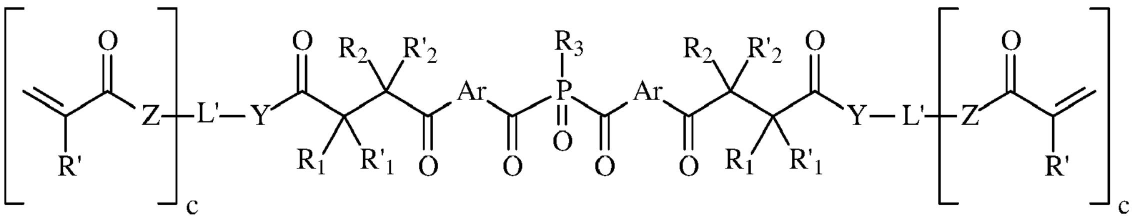

(2)

wherein:

- each Ar is independently an optionally substituted arylene;
- $R_1$ and $R_2$ are independently H or an optionally substituted group selected from alkyl and aryl; or $R_1$ and $R_2$, together with the carbon atoms to which they are attached, form a ring;
- one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-$

$W^2$-$R^{10}$), -C($R^{11}$)(CO-$W^3$-$R^{12}$)(CN), -C($R^{13}$)$(CN)_2$, a moiety comprising a polymerizable group and a moiety comprising a phosphine oxide group; or $R'_2$ is H and $R'_1$ and Y, together with the atoms to which they are attached, form a 5-8 membered ring;
- each $R_3$ is independently an optionally substituted group selected from alkyl, aryl and alkoxy;
- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom;
- Q is an optionally substituted aryl or a group of formula (3):

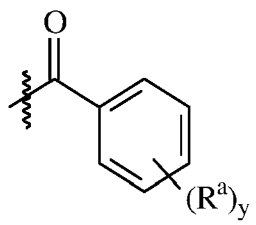

(3)

wherein:

- each $R^a$ is independently an optionally substituted group selected from alkyl, aryl, alkoxy, aryloxy, thioalkyl and thioaryl; and
- y is a number chosen from 0 to 5;

- each Y is independently -O-, -S-, -$NR^{16}$-, or a group represented by the following formula (4):

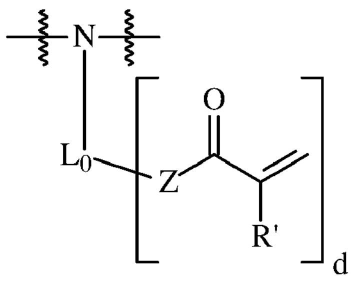

(4)

- each Z is independently -O- or -$NR^{17}$-;
- each $R^{16}$ is independently H or an optionally substituted group selected from alkyl, and aryl; or $R^{16}$, together with the nitrogen atom to which it is attached, forms a 5-8 membered ring with $R'_1$;
- each $R^{17}$ is independently H or an optionally substituted group selected from alkyl and aryl;
- L is a (a+b)valent linker;
- L' is a (c+1)valent linker;
- $L_0$ is a (d+1)valent linker;
- each R' is independently H or methyl;
- a, b, c and d are independently an integer from 1 to 6.

**2.** The photoinitiator according to claim 1, wherein each Ar is independently an optionally substituted phenylene, preferably a meta-phenylene substituted by one or more optionally substituted groups selected from alkyl, aryl, alkoxy, aryloxy, thioalkyl and thioaryl; and more preferably Ar is a group of formula (5):

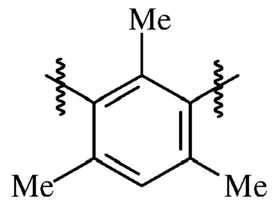
(5).

3. The photoinitiator according to claim 1 or 2, wherein one of $R'_1$ and $R'_2$ is H and the other of $R'_1$ and $R'_2$ is $-C(R^8)(CO-W^1-R^9)(CO-W^2-R^{10})$, and wherein preferably

- $R^8$ is H;
- $W^1$ and $W^2$ are independently a bond or an oxygen atom; and
- $R^9$ and $R^{10}$ are independently an optionally substituted alkyl.

4. The photoinitiator according to any one of claims 1 to 3, wherein Q is phenyl or a group of formula (3a):

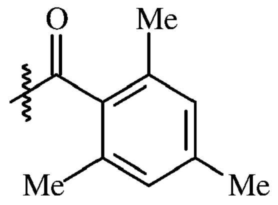
(3a).

5. The photoinitiator according to any one of claims 1 to 4, wherein Y is -O-.

6. The photoinitiator according to any one of claims 1 to 5, wherein Z is -O-.

7. The photoinitiator according to any one of claims 1 to 4, wherein Y is $-NR^{16}-$ and $R^{16}$ is preferably H.

8. The photoinitiator according to any one of claims 1 to 4 and 7, wherein Z is $-NR^{17}-$ and $R^{17}$ is preferably H.

9. The photoinitiator according to any one of claims 1 to 8, wherein L, L' and L" are independently selected from an aromatic linker, an aliphatic linker, a cycloaliphatic linker, a polyether linker, a polythioether linker, a polyalkylene imine linker, a polyester linker, a polycarbonate linker, a polyurethane linker, a polyorganosiloxane linker, a polybutadiene linker, and combinations thereof; preferably L and L' are independently selected from an aromatic linker, an aliphatic linker, a cycloaliphatic linker, a polyether linker, a polythioether linker, a polyalkylene imine linker, a polyester linker, a polyorganosiloxane linker, and combinations thereof.

10. The photoinitiator according to any one of claims 1 to 9, wherein L, L' and L" are independently selected from:

- a divalent moiety according to any one of formulae (8) to (17):

$-(CR_4R'_4)e-$ (8)

$-CH_2-O-CH_2-$ (9)

$-[(CR_5R'_5)_f-W]_g-(CR_5R'_5)_f-$ (10)

$-[(CR_6R'_6)_h-W]_i-(CR_7R'_7)_j-[W-(CR_6R'_6)_h]_i-$ (11)

$-[(CR_8R'_8)_k-C(=O)O]_l-(CR_9R'_9)_m-$ (12)

$-(CR_9R'_9)_m-[(CR_8R'_8)_k-C(=O)O]_l-$ (13)

$-[(CR_{10}R'_{10})_n-O-C(=O)-(CR_{11}R'_{11})_o-C(=O)-O]_p-(CR_{10}R'_{10})_n-$ (14)

$$-(CR_{12}R'_{12})_q-C(=O)-O-(CR_{13}R'_{13})_r-O-C(=O)-(CR_{12}R'_{12})_q- \quad (15)$$

$$-(CR_{14}R'_{14})_s-Cy-[L-Cy]_t-(CR_{14}R'_{14})_s- \quad (16)$$

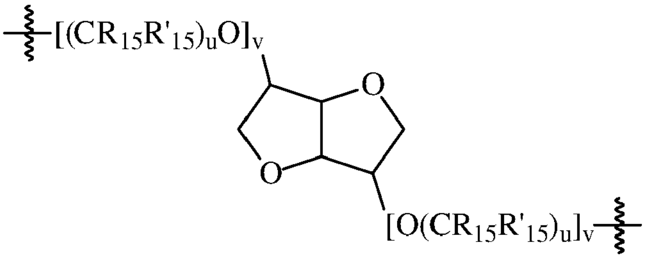

(17)

wherein:

- $R_4$, $R'_4$, $R_7$, $R'_7$, $R_9$, $R'_9$, $R_{10}$, $R'_{10}$, $R_{11}$, $R'_{11}$, $R_{12}$, $R'_{12}$, $R_{13}$, $R'_{13}$, $R_{14}$ and $R'_{14}$ are independently H or alkyl;
- $R_5$, $R'_5$, $R_6$, $R'_6$, $R_8$, $R'_8$, $R_{15}$ and $R'_{15}$ are independently H or methyl;
- each W is independently -O- or -S-;
- Cy is an optionally substituted ring, in particular an optionally substituted cyclohexylene or phenylene;
- L is a bond or a linker such as Alk, -C(=O)-, -C(=O)-O-Alk-O-C(=O)-, -SO-, $-SO_2-$, $-C(=CCl_2)-$ and -Alk-Ph-Alk-;
- Alk is an optionally substituted alkylene;
- Ph is an optionally substituted phenylene;
- e, j, m, n, o and r are independently an integer from 2 to 20;
- each s is independently an integer from 0 to 20;
- f, h and u are independently an integer from 2 to 4;
- t is an integer equal to 0 or 1;
- g, l, p and q are independently an integer from 1 to 20;
- each v is independently an integer from 0 to 10, in particular from 1 to 6;
- each i is independently an integer from 0 to 20 with the proviso that at least one i is not 0;
- k is an integer from 3 to 12;

- a trivalent moiety according to any one of formulae (18) to (23):

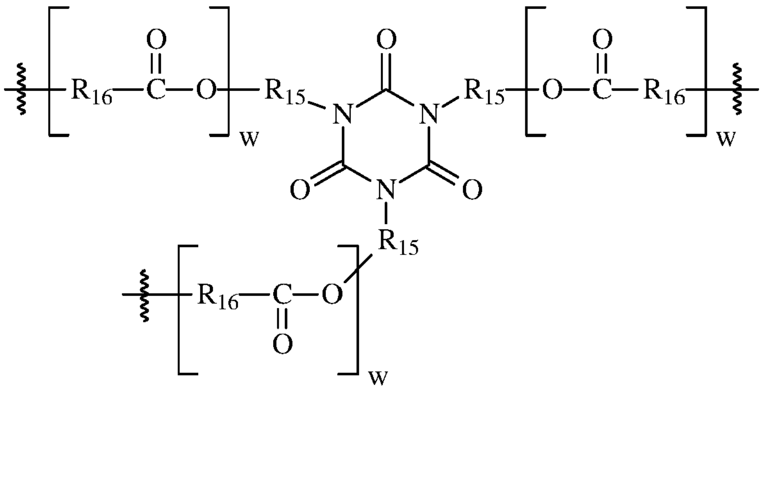

(18)

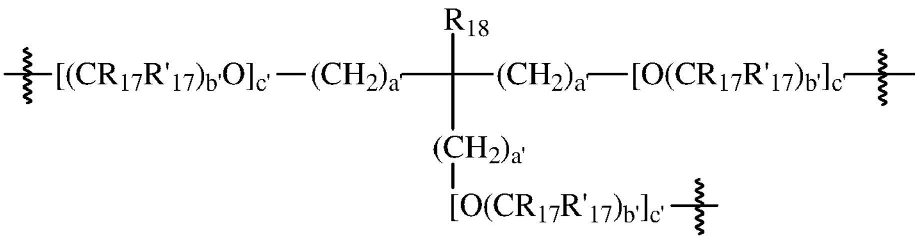

(19)

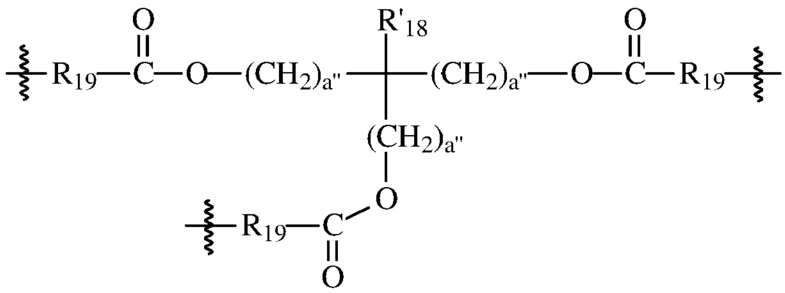

(20)

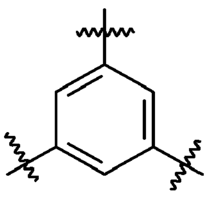

(21)

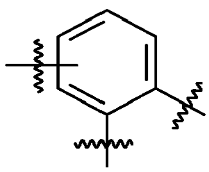

(22)

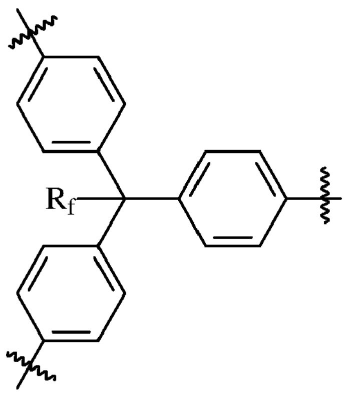

(23)

wherein:

- $R_{15}$ and $R_{16}$ are independently a linear or branched alkylene;
- $R_{17}$ and $R'_{17}$ are independently H or methyl;
- $R_{18}$ and $R'_{18}$ are independently H, alkyl or alkoxy, preferably $R_{18}$ and $R'_{18}$ are alkyl;
- each $R_{19}$ is independently a linear or branched alkylene;
- $R_f$ is H or methyl;
- w is an integer equal to 0 or 1;
- each a' is independently an integer from 0 to 2 with the proviso that not more than one a' is equal to 0, preferably each a' is equal to 1 or one a' is equal to 0 and the two other a' are equal to 1;
- each a" is independently an integer from 0 to 2 with the proviso that not more than one a" is equal to 0, preferably each a" is equal to 1 or one a" is equal to 0 and the two other a" are equal to 1;
- each b' is independently an integer from 2 to 4, in particular 2;
- each c' is independently an integer from 0 to 10, in particular from 1 to 6;

- a tetravalent moiety according to any one of formulae (24) to (27):

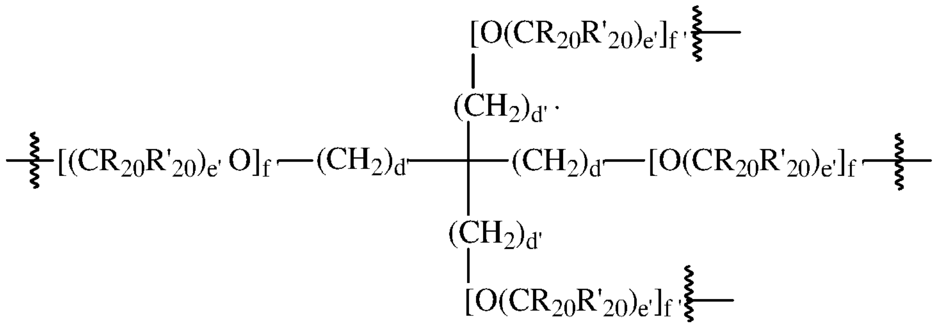

(24)

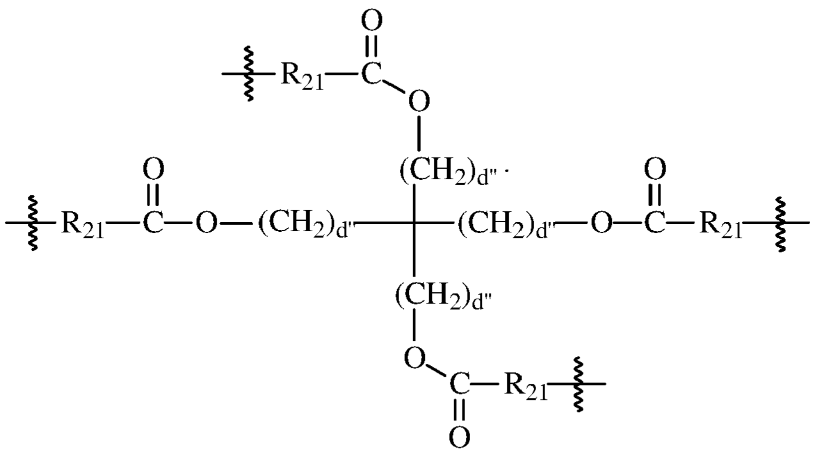

(25)

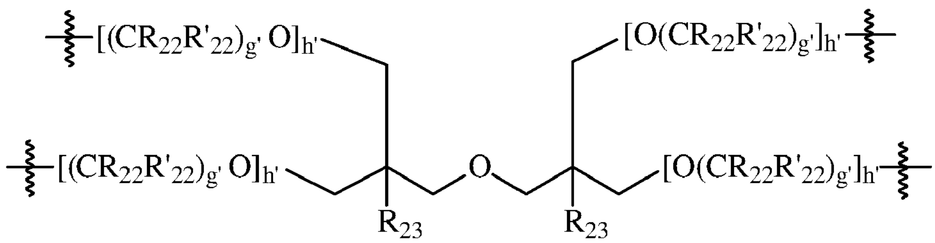

(26)

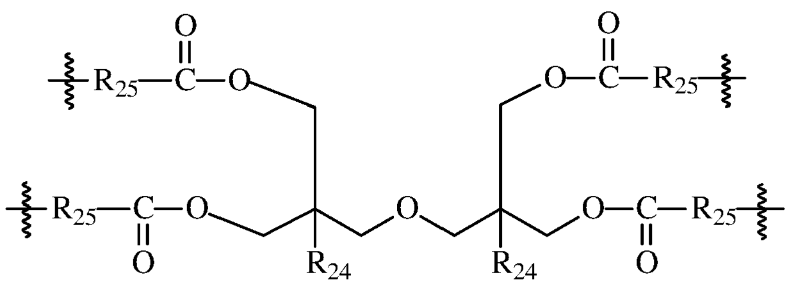

(27)

wherein:

- $R_{20}$, $R'_{20}$, $R_{22}$ and $R'_{22}$ are independently H or methyl;
- $R_{21}$ and $R_{25}$ is independently a linear or branched alkylene;
- $R_{23}$ and $R_{24}$ are independently H, alkyl or alkoxy, preferably alkyl;
- each d' is independently an integer from 0 to 2 with the proviso that not more than one d' is equal to 0, preferably each d' is equal to 1;

- each d" is independently an integer from 0 to 2 with the proviso that not more than one d" is equal to 0, preferably each d" is equal to 1;
- e' and g' are independently an integer from 2 to 4, in particular 2;
- f' and h' are independently an integer from 0 to 10, in particular from 1 to 6;

- a tetra-, penta- or hexavalent moiety according to formula (28):

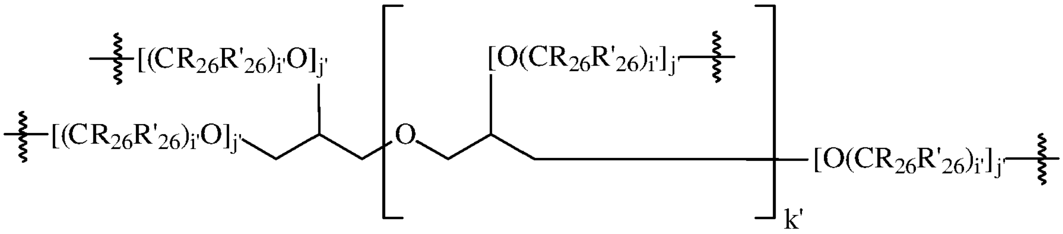

(28)

wherein:

- $R_{26}$ and $R'_{26}$ are independently H or methyl;
- each i' is independently an integer from 2 to 4, in particular 2;
- each j' is independently an integer from 0 to 10, in particular from 1 to 6;
- k' is an integer from 1 to 3;

- a tri-, tetra-, penta- or hexavalent moiety according to formula (29):

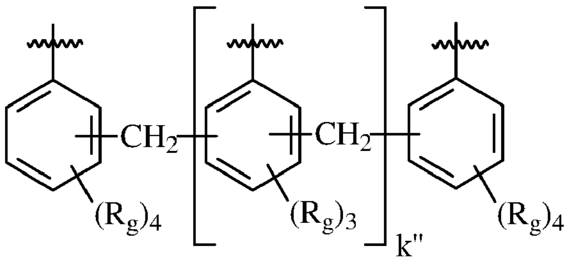

(29)

wherein

- each $R_g$ is independently selected from H, alkyl, cycloalkyl, aryl, alkaryl, aralkyl, alkoxy, -C(=O)O-Alkyl and a halogen atom;
- k" is an integer from 1 to 4.

- a hexavalent moiety according to any one of formulae (30) to (32):

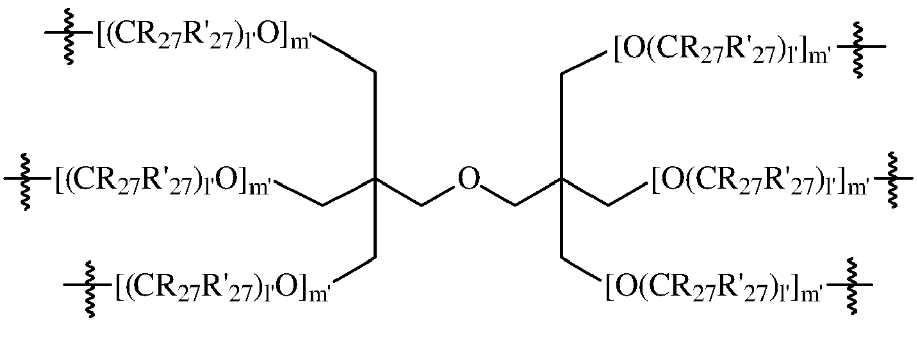

(30)

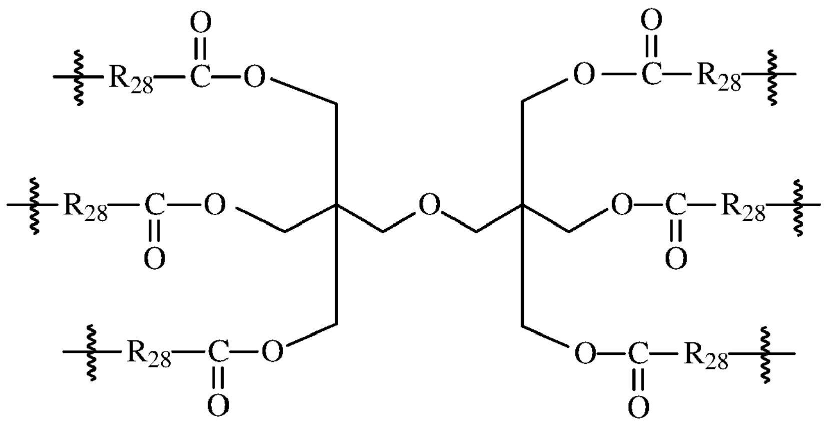

(31)

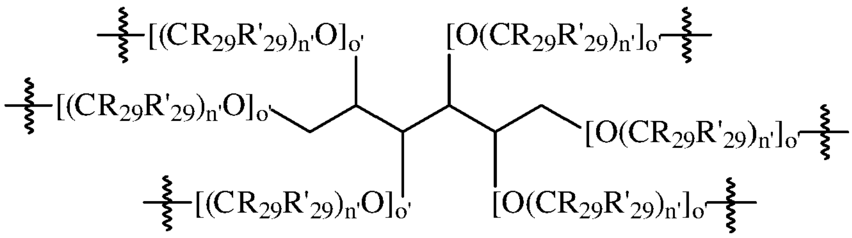

(32)

wherein

- R27, R'27, R2s and R'29 are independently H or methyl;
- each $R_{28}$ is independently a linear or branched alkylene;
- l' and n' are independently an integer from 2 to 4, in particular 2;
- m' and o' are independently an integer from 0 to 10, in particular from 1 to 6.

**11.** The photoinitiator according to any one of claims 1 to 6, 9 and 10, wherein Y and Z are both -O- and L and L' correspond to the following formula (33):

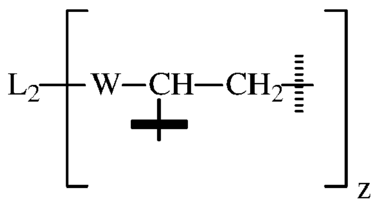

(33)

wherein

- $L_2$ is a z-valent linker;
- W is a bond, #-O-$CH_2$- or #-C(=O)-O-$CH_2$-;
- z is an integer of at least 2;
- the symbol # represents a point of attachment to $L_2$;
- the bold line represents a point of attachment to a (meth)acrylate group;
- the hashed line represents a point of attachment to a phosphine oxide-containing group or to a (meth)acrylate group, provided that at least one of the hashed lines represents a point of attachment to a phosphine oxide-containing group.

**12.** A process for the preparation of a photoinitiator of formula (1) or (2) according to any one of claims 1 to 11, wherein the process comprises reacting at least one precursor of formula (34) or (35) with at least one product of formula (36):

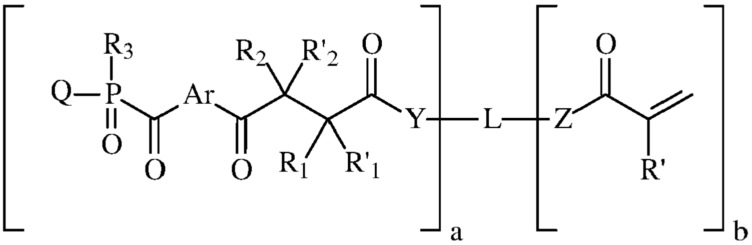

(1)

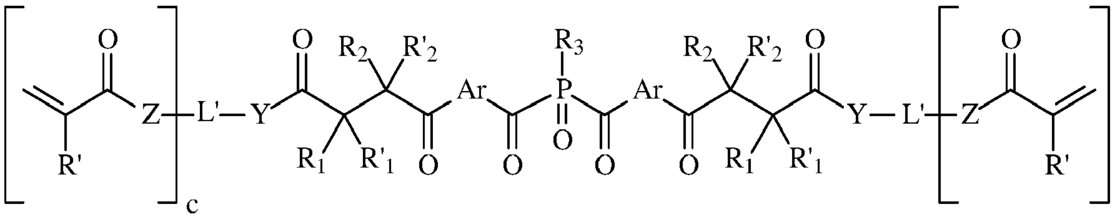

(2)

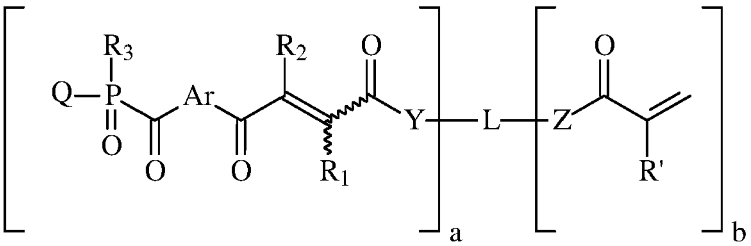

(34)

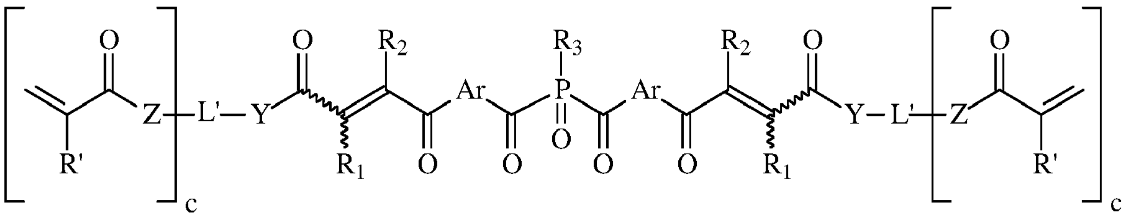

(35)

$R'_1$- $R'_2$ (36)

wherein Ar, $R_1$, $R_2$, $R_3$, $R'_1$, $R'_2$, Q, L, L' Y, Z, R', a, b and c are as defined in any one of claims 1 to 11; preferably the product of formula (36) is selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, N-methylpiperazine, oxazolidine, thiazolidine, thiomorpholine, azepane), more particularly a secondary cyclic amine (for example morpholine, piperidine, pyrrolidine, N-methylpiperazine, oxazolidine, thiazolidine, thiomorpholine, azepane);
- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);
- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile);
- a partially (meth)acrylated polyol;

- a partially (meth)acrylated polyamine.

**13.** A precursor of formula (34) or (35):

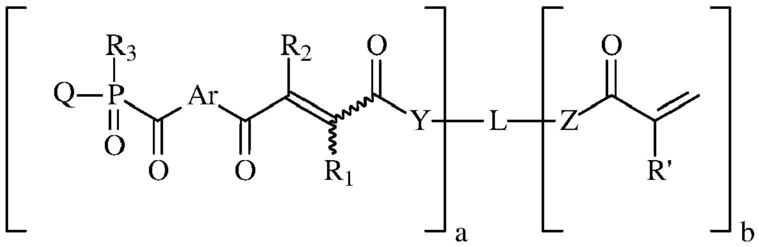

(34)

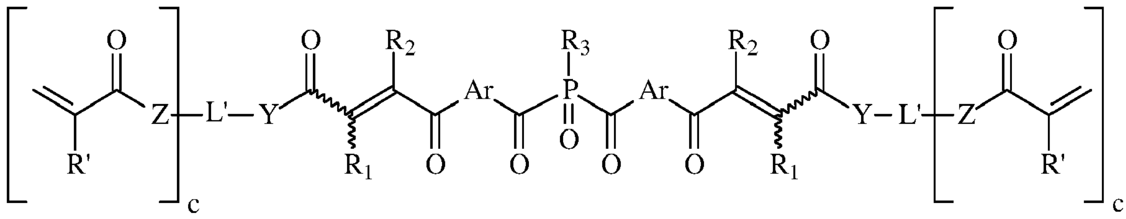

(35)

wherein Ar, $R_1$, $R_2$, $R_3$, Q, L, L', Y, Z, R', a, b and c are as defined in any one of claims 1 to 11.

**14.** A process for the preparation of a photoinitiator of formula (1) according to any one of claims 1 to 11, wherein the process comprises:

- reacting at least one precursor of formula (45) with at least one compound of formula (38); or
- reacting at least one precursor of formula (45) with at least one compound of formula (39) and at least one compound of formula (40); or
- reacting at least one precursor of formula (45) with at least one compound of formula (41) and at least one compound of formula (40);

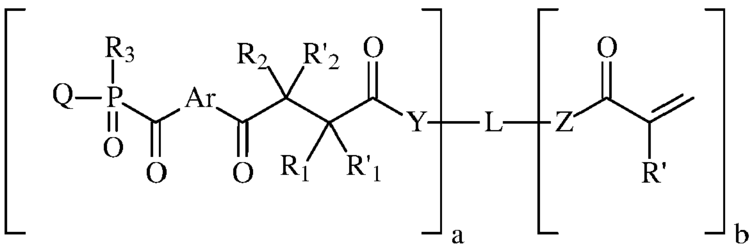

(1)

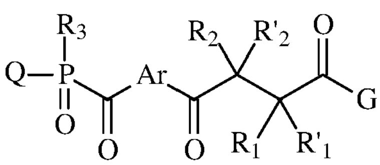

(45)

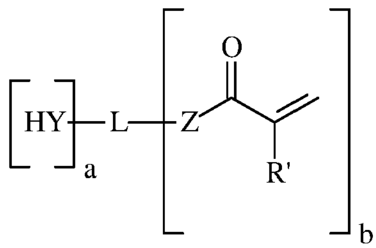

(38)

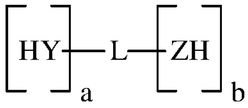 (39) 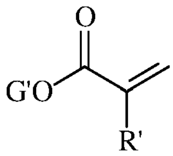 (40) 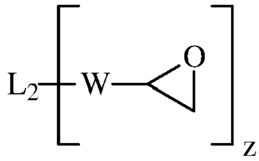 (41)

wherein:

- Ar, $R_1$, $R_2$, $R'_1$, $R'_2$, $R_3$, Q, L, $L_2$, W, Y, Z, R', a, b and z are as defined in any one of claims 1 to 11;
- G and G' are independently OH, a halogen atom or -O-C(=O)-J;
- J is alkyl or aryl, in particular tert-butyl.

**15.** A photoinitiator composition comprising:

- a mixture of at least two photoinitiators of formula (1) according to any one of claims 1 to 11;
- a mixture of at least two photoinitiators of formula (2) according to any one of claims 1 to 11;
- a mixture of at least one photoinitiator of formula (1) according to any one of claims 1 to 11 and at least one precursor of formula (34) according to claim 13; or
- a mixture of at least one photoinitiator of formula (2) according to any one of claims 1 to 11 and at least one precursor of formula (35) according to claim 13.

**16.** A process for photopolymerizing one or more ethylenically unsaturated compounds comprising contacting one or more ethylenically unsaturated compounds with a photoinitiator of formula (1) or (2) according to any one of claims 1 to 11 or a photoinitiator composition according to claim 15, and irradiating the mixture, in particular with UV, near-UV, visible, infrared and/or near-infrared radiation.

**17.** A curable composition comprising:

a) a photoinitiator of formula (1) or (2) according to any one of claims 1 to 11 or a photoinitiator composition according to claim 15; and
b) an ethylenically unsaturated compound.

**18.** A process for the preparation of a cured product, comprising curing the curable composition according to claim 17, preferably by exposing the curable composition to radiation such as UV, near-UV, visible, infrared and/or near-infrared radiation.

**19.** A use of a photoinitiator of formula (1) or (2) according to any one of claims 1 to 11 or a photoinitiator composition according to claim 15, to obtain a cured product having a reduced amount of extractables.

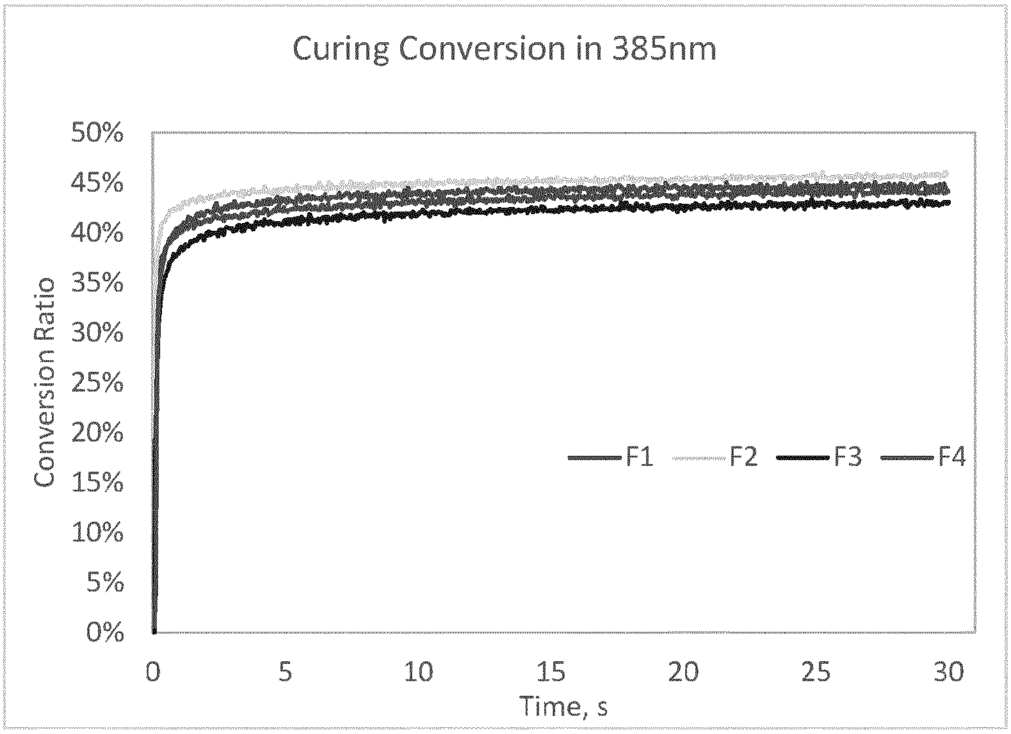


**Figure 1**

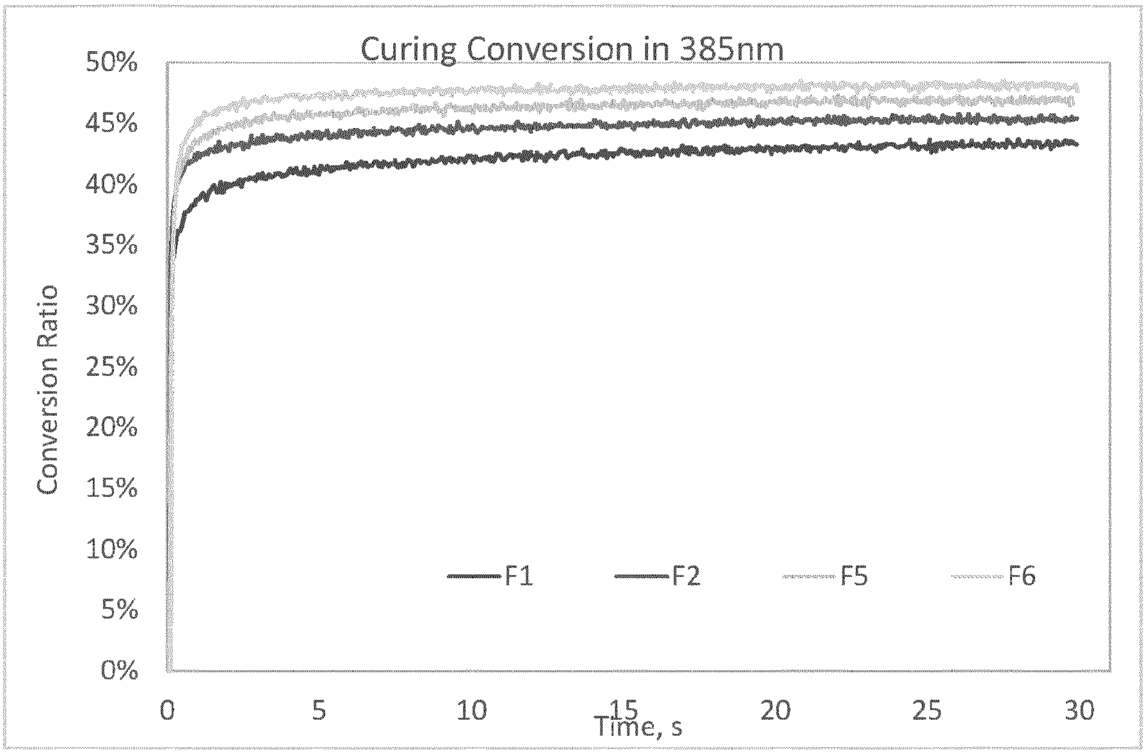


**Figure 2**

Europäisches Patentamt
European Patent Office
Office européen des brevets

# EUROPEAN SEARCH REPORT

Application Number
EP 23 30 7168

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 902 456 A1 (FUJIFILM CORP [JP]) 5 August 2015 (2015-08-05) * paragraph [0068] * * abstract * * compounds A-12, A-14 to A-16, A-19, A-20 * ----- | 1-19 | INV. C07F9/53 C07F9/6558 C07F9/6533 B41M7/00 C08F2/50 C08K5/00 C09D11/101 G03F7/038 |
| | | | TECHNICAL FIELDS SEARCHED (IPC) |
| | | | C08K B41M G03F C09D C08F C07F |

The present search report has been drawn up for all claims

1

| Place of search | Date of completion of the search | Examiner |
|---|---|---|
| The Hague | 8 April 2024 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 30 7168

This annex lists the patent family members relating to the patent documents cited in the above-mentioned European search report. The members are as contained in the European Patent Office EDP file on
The European Patent Office is in no way liable for these particulars which are merely given for the purpose of information.

08-04-2024

| Patent document cited in search report | Publication date | Patent family member(s) | Publication date |
|---|---|---|---|
| EP 2902456 A1 | 05-08-2015 | CN 104662107 A | 27-05-2015 |
| | | EP 2902456 A1 | 05-08-2015 |
| | | US 2015197651 A1 | 16-07-2015 |
| | | WO 2014051026 A1 | 03-04-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3378875 A
- US 10590264 B
- EP 3149013 A
- EP 2023077292 W
- WO 2014126830 A
- WO 2014126834 A
- WO 2014126837 A


### Non-patent literature cited in the description


- **HERBST, WILLY et al.** Industrial Organic Pigments, Production, Properties, Applications. Wiley - VCH, 2004
- **TUMBLESTON et al.** Continuous Liquid Interface Production of 3D Objects. *Science*, 20 March 2015, vol. 347 (6228), 1349-1352